# EUROPEAN PATENT APPLICATION

(11) **EP 4 825 818 A1**
(43) Date of publication of application: **21.10.2026**
(21) Application number: 25872853.4
(22) Date of filing: 23.09.2025
(51) Int. Cl.: C03C 10/04, C03C 21/00, H05K 5/02, H04M 1/02

(54) **CHEMICALLY STRENGTHENED MICROCRYSTALLINE GLASS, COVER GLASS PLATE, ELECTRONIC DEVICE, AND GLASS COMPONENT**

(30) Priority: 30.09.2024 CN 202411386703
(71) Applicant: Chongqing Aureavia Hi-Tech Glass Co., Ltd., Chongqing 400713 (CN)
(72) Inventor: LIU, Zhiqiang, Chongqing 400713 (CN); ZHOU, Jingpeng, Chongqing 400713 (CN); LUO, Feng, Chongqing 400713 (CN); HUANG, Hao, Chongqing 400713 (CN)
(74) Representative: Ostertag & Partner Patentanwälte mbB
(86) International application number: PCT/CN2025/123347
(87) International publication number: WO 2026/067404

(57) **Abstract**

The present disclosure belongs to the technical field of glass-ceramics. Provided are a chemically strengthened glass-ceramic, a cover glass, an electronic device and a glass device. A high-lithium-content glass-ceramic having a specific composition and using lithium disilicate as a main crystalline phase undergoes chemical strengthening treatment so as to satisfy specific stress characteristics, especially the mole percentage content of ZrO₂ in the glass-ceramic and the stress characteristic relationship A satisfy specific requirements, i.e. satisfying the range requirement of relationship B. Therefore, the present disclosure solves the problem of "surface cracking" of the manufactured chemically strengthened glass-ceramic and can also ensure that the chemically strengthened glass-ceramic has high mechanical strength, thereby ensuring that the chemically strengthened glass-ceramic has excellent damage resistance performance.

## Description

### CROSS-REFERENCE TO RELATED APPLICATIONS

The present disclosure claims priority to Chinese Patent Application No. 202411386703.2, titled "CHEMICALLY STRENGTHENED MICROCRYSTALLINE GLASS, COVER GLASS PLATE, ELECTRONIC DEVICE, AND GLASS COMPONENT", filed before the China National Intellectual Property Administration on September 30, 2024; which is incorporated into the present disclosure by reference in its entirety.

### TECHNICAL FIELD

The present disclosure relates to the technical field of glass-ceramics, and in particular to a chemically strengthened glass-ceramic, a cover glass, an electronic device, and a glass device.

### BACKGROUND

As a solid material containing a crystalline phase and a glass phase, a glass-ceramic has an overall strength performance significantly superior to that of ordinary glass due to the large number of tiny crystals contained therein which can hinder microcrack propagation. Currently, glass-ceramics have begun to be used in electronic devices, for example, as cover glasses for portable electronic devices. Further examples of applications of glass-ceramics include, but are not limited to, display screen cover plates, back covers, camera protection cover plates, and the like.

In glass-ceramics, common crystalline phases comprise lithium metasilicate, lithium disilicate, petalite, quartz, quartz solid solution, spinel, spodumene, nepheline, zirconia, and the like. Among them, lithium disilicate (Li₂Si₂O₅) is an orthorhombic crystal based on a [Si₂O₅] tetrahedral array, with a flat or plate-like shape. Inside the glass-ceramic, lithium disilicate crystals often have a randomly oriented microstructure, which can force the path of a crack to be twisted when passing through the crystals, thereby helping to prevent crack propagation and improving the strength and fracture toughness of the glass-ceramic. At the same time, the lithium disilicate crystal is also an ideal crystalline phase for preparing highly transparent glass-ceramics. Therefore, glass-ceramics having lithium disilicate as the main crystalline phase exhibit great application potential in the market of cover glass for electronic devices.

As cover glasses for electronic devices, especially for portable electronic devices (such as mobile phones, tablet computers, smart watches, smart bracelets), in addition to strength, it is also desirable that the glass-ceramic used as the cover glass in the portable electronic device be as thin as possible. In order to achieve high strength performance for such thin glass-ceramics to better cope with problems such as compression, impact, scratching, and wear, it is usually necessary to subject glass-ceramics to a chemical strengthening treatment.

Lithium is an essential component of the lithium disilicate crystalline phase, and lithium ions are key ions for ion exchange during the chemical strengthening process of the lithium disilicate glass-ceramic. Thus, a large amount of lithium is typically added to the glass composition to obtain a strengthenable lithium disilicate glass-ceramic with a high crystalline phase content while ensuring a high stress level in the strengthened glass-ceramic.

### SUMMARY

Without being bound by any theory, for a glass-ceramic with a high lithium content and having lithium disilicate as the main crystalline phase, when it is subjected to the chemical strengthening treatment in a molten salt bath, especially in a high-temperature molten salt bath, a large number of irregular cracks/fractures tend to appear on the surface of the resulting chemically strengthened glass-ceramic. These cracks/fractures exist on the surface of the chemically strengthened glass-ceramic, with depths ranging from 10 µm to 100 µm, hereinafter referred to as "surface cracking". The problem of "surface cracking" in the chemically strengthened glass-ceramic can lead to a significant decrease in the drop damage resistance performance and mechanical strength of the chemically strengthened glass-ceramic. More severely, it may even render the surface of the chemically strengthened glass-ceramic directly unusable due to excessive cracks/fractures.

Further, the inventors have discovered that during the chemical strengthening treatment of the glass-ceramic with a high lithium content and having lithium disilicate as the main crystalline phase to prepare a chemically strengthened glass-ceramic with desired properties, the compatibility between the glass composition and the stress distribution structure is very important. If the glass composition and the stress distribution structure are incompatible, the problem of "surface cracking" is likely to arise in the resulting chemically strengthened glass-ceramic, leading to a significant reduction in the mechanical strength performance of the chemically strengthened glass-ceramic. When a glass-ceramic of a specific composition is matched with an appropriate and preferred stress distribution structure, it not only overcomes the problem of "surface cracking" in the resulting chemically strengthened glass-ceramic but also ensures that the chemically strengthened glass-ceramic has high mechanical strength performance.

The present disclosure provides a chemically strengthened glass-ceramic, a cover glass comprising the chemically strengthened glass-ceramic, an electronic device comprising the chemically strengthened glass-ceramic, and a glass device comprising the chemically strengthened glass-ceramic. The chemically strengthened glass-ceramic, with a high lithium content and having lithium disilicate as the main crystalline phase, has a specific composition and a specific stress distribution structure, such that the chemically strengthened glass-ceramic is not only free from the "surface cracking" problem but also has high mechanical strength performance.

Specifically, the technical solutions provided by the present disclosure include:
In a first aspect, a chemically strengthened glass-ceramic is provided, wherein a main crystalline phase of the chemically strengthened glass-ceramic is a lithium disilicate crystalline phase; a crystallinity of the chemically strengthened glass-ceramic is not less than 65%; a Li₂O content at a center of the chemically strengthened glass-ceramic is not less than 11%, based on mass percentage of oxides;
the chemically strengthened glass-ceramic has a compressive stress layer on a surface thereof and has a tensile stress layer inside; the chemically strengthened glass-ceramic satisfies the following relationships: $A = \frac{{\int }_{0}^{DOL _ 0} CS \left(t\right) dt}{DOL _ 0} ;$ and
B=A-83989×[n(ZrO₂)]²+2526.5×n(ZrO₂), with 130 ≤ B ≤ 180, preferably 135 ≤ B ≤ 180, more preferably 135 ≤ B ≤ 175;
wherein t is a depth from a main surface of the chemically strengthened glass-ceramic, CS(t) is a compressive stress value at depth t, ${\int }_{0}^{DOL _ 0} CS \left(t\right) dt$ is a stress integral of the compressive stress layer from the main surface to DOL_0 of the chemically strengthened glass-ceramic, in MPa·µm; and
DOL_0 is a depth of the compressive stress layer, in µm;
in relationship A, corresponding data are substituted for calculation according to the above unit requirements, and a calculation result of relationship A is obtained, wherein only numerical values are used in the calculation, with units being disregarded;
n(ZrO₂) is a mole percentage content of ZrO₂ at the center of the chemically strengthened glass-ceramic;
in relationship B, a value of relationship A and a numerical value of the mole percentage content of ZrO₂ are substituted for calculation, and a calculation result of relationship B is obtained, wherein only numerical values are used in the calculation, with units being disregarded.

By subjecting the glass-ceramic with a specific composition, having lithium disilicate as the main crystalline phase, and having a high lithium content to the chemical strengthening treatment such that it satisfies a specific stress characteristic, in particular, by having the mole percentage content of ZrO₂ in the glass-ceramic and the stress characteristic relationship A satisfy a specific requirement (i.e., satisfy the range requirement of relationship B above), the present disclosure can not only effectively overcome the problem of "surface cracking" in the resulting chemically strengthened glass-ceramic, but also ensure that the chemically strengthened glass-ceramic has high mechanical strength performance, thereby ensuring that the chemically strengthened glass-ceramic has excellent damage resistance performance.

Optionally, the value of relationship A satisfies: 120 ≤ A ≤ 250, preferably 130 ≤ A ≤ 240, more preferably 130 ≤ A ≤ 235. By making the chemically strengthened glass-ceramic satisfy relationship A, it is advantageous for enabling the chemically strengthened glass-ceramic to achieve a desired high stress level, thereby helping to ensure that the chemically strengthened glass-ceramic has high mechanical strength performance.

Optionally, the value of relationship A is: 150.39, 155.13, 157.8, 163.95, 165.23, 167.78, 171.98, 130.02, 148.08, 153.52, 157.87, 150.70, 161.51, 200.59, 217.59, 234.24, 208.06, 207.14, 220.07, 224.21, or 226.66; and/or,
the value of relationship B is: 144.41, 149.14, 151.82, 157.96, 159.24, 161.80, 166.00, 148.99, 165.83, 168.65, 170.67, 163.85, 155.53, 136.18, 155.43, 172.09, 147.01, 147.17, 165.17, 164.24, or 166.69.

Optionally, the chemically strengthened glass-ceramic satisfies the following relationship: C = A - |CT_AV|, with 30 ≤ C ≤ 90, preferably 30 ≤ C ≤ 85, more preferably 30 ≤ C ≤ 80, wherein |CT_AV| is an absolute value of an average tensile stress, in MPa. By making the chemically strengthened glass-ceramic satisfy relationship C, it helps to overcome the problem of "surface cracking" in the resulting chemically strengthened glass-ceramic and helps to ensure that the chemically strengthened glass-ceramic has high mechanical strength performance.

Optionally, the value of relationship C is: 33.97, 40.28, 37.3, 41.41, 47.67, 42.93, 45.51, 45.77, 52.74, 53.28, 51.42, 52.28, 37.27, 64.74, 70.95, 77.45, 57.85, 52.49, 67.32, 66.26, or 64.31.

Optionally, the chemically strengthened glass-ceramic satisfies the following relationship: 2.0 ≤ |K_{0.5×DOL_0}| ≤ 6.0, wherein |K_{0.5×DOL_0}| is an absolute value of a slope of a stress curve at a depth t = 0.5 × DOL_0 from the main surface of the chemically strengthened glass-ceramic.

Optionally, the chemically strengthened glass-ceramic satisfies: 0 ≤ M(K₂O) ≤ 1.5%, and 5% ≤ M(Na₂O) ≤ 25%; M(K₂O) is a mass percentage of K₂O of a surface of the chemically strengthened glass-ceramic, and M(Na₂O) is a mass percentage of Na₂O of the surface of the chemically strengthened glass-ceramic.

Optionally, after thinning a thickness of 3 µm from each of two main surfaces of the chemically strengthened glass-ceramic, a resulting thinned chemically strengthened glass-ceramic satisfies: a mass percentage M'(K₂O) of K₂O of a surface of the thinned chemically strengthened glass-ceramic and a mass percentage M'(Na₂O) of Na₂O of the surface of the thinned chemically strengthened glass-ceramic are: 0 ≤ M'(K₂O) ≤ 0.5%, and 4.0% ≤ M'(Na₂O) ≤ 20%.

Optionally, a composition at a center or of the tensile stress layer of the chemically strengthened glass-ceramic comprises:
SiO₂: 58% to 66%, Al₂O₃: 0% to 3.5%, P₂O₅: 1% to 3%, ZrO₂: 1% to 6%, and Li₂O: 24% to 32%, based on mole percentage of oxides. In the present disclosure, by adjusting and controlling the content ranges of the various oxide components, it is advantageous for ensuring that the chemically strengthened glass-ceramic satisfying a desired crystalline phase structure and stress structure is obtained.

Optionally, the composition at the center or of the tensile stress layer of the chemically strengthened glass-ceramic further comprises: SrO: 0% to 3%, and/or, Na₂O: 0% to 4%, and/or, K₂O: 0% to 2%, and/or, CaO: 0% to 5%, and/or, B₂O₃: 0% to 1%, and/or, Ta₂O₅: 0% to 1%, and/or, BaO: 0% to 3%, and/or, MgO: 0% to 3%, and/or, ZnO: 0% to 3%, and/or, Y₂O₃: 0% to 1%, and/or, La₂O₃: 0% to 1%, and/or, Yb₂O₃: 0% to 1%, based on mole percentage of oxides.

Optionally, the composition at the center or of the tensile stress layer of the chemically strengthened glass-ceramic comprises:
SiO₂ with a mole percentage of 60% to 65%, preferably 60.5% to 64.50%; and/or,
Al₂O₃ with a mole percentage of 0.5% to 3.5%, preferably 1% to 1.5%; and/or,
P₂O₅ with a mole percentage of 1% to 2.8%, preferably 1.20% to 2%; and/or,
ZrO₂ with a mole percentage of 1% to 5%, preferably 1.4% to 5%; and/or,
Li₂O with a mole percentage of 24% to 31.6%, preferably 27.5% to 31%; and/or,
Na₂O with a mole percentage of 0% to 3%, preferably 0% to 1%; and/or,
K₂O with a mole percentage of 0% to 1%, preferably 0% to 0.7%; and/or,
CaO with a mole percentage of 0% to 4%, preferably 0% to 3%; and/or,
BaO with a mole percentage of 0% to 2%, preferably 1% to 2%; and/or,
SrO with a mole percentage of 0% to 2%, preferably 1% to 2%; and/or,
MgO with a mole percentage of 0% to 2%; and/or,
ZnO with a mole percentage of 0% to 2%; and/or,
B₂O₃ with a mole percentage of 0% to 0.7%, preferably 0% to 0.5%; and/or,
Y₂O₃ with a mole percentage of 0% to 0.5%, preferably 0% to 0.2%; and/or,
La₂O₃ with a mole percentage of 0% to 0.5%, preferably 0% to 0.2%; and/or,
Ta₂O₅ with a mole percentage of 0% to 0.7%, preferably 0% to 0.5%; and/or,
Yb₂O₃ with a mole percentage of 0% to 0.7%, preferably 0% to 0.5%,
based on mole percentage of oxides.

In the present disclosure, the appropriate addition of alkaline earth metal oxides such as BaO, SrO, MgO, CaO facilitates improving the glass melting process, making it less prone to crystallization during the glass melting process, helping to reduce high-temperature viscosity to a certain extent, increasing the density of the base glass, increasing the Young's modulus, and also enabling the glass to achieve higher stress after strengthening to a certain extent. The appropriate addition of rare earth metal oxides such as Y₂O₃, La₂O₃, Yb₂O₃ can increase the density of the base glass and enhance the Young's modulus of the glass-ceramic. The appropriate addition of transition metal oxides such as Ta₂O₅ can increase the density of the base glass and enhance the Young's modulus of the glass-ceramic. The appropriate addition of alkali metal oxides such as Na₂O, K₂O can improve the glass melting process but may reduce the stress of the chemically strengthened glass-ceramic.

Optionally, the composition at the center or of the tensile stress layer of the chemically strengthened glass-ceramic comprises:
SiO₂ with a mole percentage of 60.92%, 60.94%, 61.15%, 61.16%, 61.43%, 61.72%, 61.82%, 62.58%, 62.77%, 63.16%, 63.39%, or 63.86%; and/or,
Al₂O₃ with a mole percentage of 1.14%, 1.22%, 1.23%, 1.37%, 1.38%, 1.4%, 1.42%, 1.43%, or 1.44%; and/or,
P₂O₅ with a mole percentage of 1.51%, 1.74%, 1.83%, 1.84%, 1.85%, 1.86%, 1.87%, 1.89%, or 1.92%; and/or,
ZrO₂ with a mole percentage of 1.44%, 1.89%, 2.18%, 2.34%, 2.36%, 3.23%, 4.47%, 4.57%, 4.59%, 4.61%, or 4.66%; and/or,
Li₂O with a mole percentage of 27.54%, 29.25%, 29.38%, 29.52%, 29.8%, 30.22%, 30.4%, 30.44%, 30.81%, or 31.51 %; and/or,
Na₂O with a mole percentage of 0% or 0.3%; and/or,
K₂O with a mole percentage of 0% or 0.46%; and/or,
CaO with a mole percentage of 0%, 0.92%, or 2.67%; and/or,
BaO **with** a mole percentage of 0%, 0.91%, 1.38%, or 1.83%; and/or,
SrO with a mole percentage of 0%, 0.91%, 0.92%, 1.38%, 1.42%, or 1.83%; and/or,
MgO with a mole percentage of 0%, 0.2%, or 1.83%; and/or,
ZnO with a mole percentage of 0%, 0.54%, or 1.67%; and/or,
B₂O₃ with a mole percentage of 0% or 0.46%; and/or,
Y₂O₃ with a mole percentage of 0% or 0.2%, and/or,
La₂O₃ with a mole percentage of 0% or 0.2%; and/or,
Ta₂O₅ with a mole percentage of 0%, 0.46%, or 0.5%; and/or,
Yb₂O₃ with a mole percentage of 0% or 0.46%,
based on mole percentage of oxides.

Optionally, the chemically strengthened glass-ceramic satisfies:
2.00 ≤ n(SiO₂)/n(Li₂O) ≤ 2.40, preferably 2.00 ≤ n(SiO₂)/n(Li₂O) ≤ 2.30, more preferably 2.02 ≤ n(SiO₂)/n(Li₂O) ≤ 2.20, wherein n(SiO₂) and n(Li₂O) are mole percentage contents of SiO₂ and Li₂O at the center or in the tensile stress layer of the chemically strengthened glass-ceramic, respectively; and/or,
90% ≤ n(SiO₂) + n(Li₂O) ≤ 96%, preferably 90% ≤ n(SiO₂) + n(Li₂O) ≤ 95%, wherein n(SiO₂) and n(Li₂O) are mole percentage contents of SiO₂ and Li₂O at the center or in the tensile stress layer of the chemically strengthened glass-ceramic, respectively; and/or,
20% ≤ 2.25 × n(Li₂O) - 8 × n(ZrO₂) - 0.2 × n(CaO) ≤ 60%, preferably 25% ≤ 2.25 × n(Li₂O) - 8 × n(ZrO₂) - 0.2 × n(CaO) ≤ 60%, wherein n(Li₂O), n(ZrO₂), and n(CaO) are mole percentage contents of Li₂O, ZrO₂, and CaO at the center or in the tensile stress layer of the chemically strengthened glass-ceramic, respectively; and/or,
0% ≤ n(Y₂O₃) + n(La₂O₃) + n(Ta₂O₅) + n(Yb₂O₃) ≤ 1%, preferably 0% ≤ n(Y₂O₃) + n(La₂O₃) + n(Ta₂O₅) + n(Yb₂O₃) ≤ 0.7%, wherein n(Y₂O₃), n(La₂O₃), n(Ta₂O₅), and n(Yb₂O₃) are mole percentage contents of Y₂O₃, La₂O₃, Ta₂O₅, and Yb₂O₃ at the center or in the tensile stress layer of the chemically strengthened glass-ceramic, respectively; and/or,
0% ≤ n(SrO) + n(BaO) + n(CaO) + n(MgO) ≤ 3%, preferably 0% ≤ n(SrO) + n(BaO) + n(CaO) + n(MgO) ≤ 2.7%, wherein n(SrO), n(BaO), n(CaO), and n(MgO) are mole percentage contents of SrO, BaO, CaO, and MgO at the center or in the tensile stress layer of the chemically strengthened glass-ceramic, respectively; and/or,
0 ≤ n(SrO)/[n(SrO) + n(BaO) + n(CaO) + n(MgO)] ≤ **1,** wherein n(SrO), n(BaO), n(CaO), and n(MgO) are mole percentage contents of SrO, BaO, CaO, and MgO at the center or in the tensile stress layer of the chemically strengthened glass-ceramic, respectively. **In** the present disclosure, by adjusting and controlling the content relationship of the various oxides, it is advantageous for ensuring that the glass-ceramic satisfying desired properties and having lithium disilicate as the main crystalline phase structure is obtained, while also facilitating the achievement of a desired stress distribution structure.

Optionally, the chemically strengthened glass-ceramic satisfies:
a value of n(SiO₂)/n(Li₂O) is 2.01, 2.03, 2.07, 2.08, 2.09, 2.10, or 2.28, wherein n(SiO₂) and n(Li₂O) are mole percentage contents of SiO₂ and Li₂O at the center or in the tensile stress layer of the chemically strengthened glass-ceramic, respectively; and/or,
a value of n(SiO₂) + n(Li₂O) is 90.17%, 90.19%, 90.31%, 90.4%, 90.41%, 90.81%, 91.24%, 91.62%, 92.16%, 93.38%, 93.39%, 94.26%, or 94.9%, wherein n(SiO₂) and n(Li₂O) are mole percentage contents of SiO₂ and Li₂O at the center or in the tensile stress layer of the chemically strengthened glass-ceramic, respectively; and/or,
a value of 2.25 × n(Li₂O) - 8 × n(ZrO₂) - 0.2 × n(CaO) is 29.39%, 29.77%, 30.05%, 42.65%, 43.99%, 50.6%, 52.02%, 52.88%, or 56.88%, wherein n(Li₂O), n(ZrO₂), and n(CaO) are mole percentage contents of Li₂O, ZrO₂, and CaO at the center or in the tensile stress layer of the chemically strengthened glass-ceramic, respectively; and/or,
a value of n(Y₂O₃) + n(La₂O₃) + n(Ta₂O₅) + n(Yb₂O₃) is 0%, 0.2%, 0.46%, or 0.7%, wherein n(Y₂O₃), n(La₂O₃), n(Ta₂O₅), and n(Yb₂O₃) are mole percentage contents of Y₂O₃, La₂O₃, Ta₂O₅, and Yb₂O₃ at the center or in the tensile stress layer of the chemically strengthened glass-ceramic, respectively; and/or,
a value of n(SrO) + n(BaO) + n(CaO) + n(MgO) is 0%, 0.2%, 0.92%, 1.38%, 1.42%, 1.83%, or 2.67%, wherein n(SrO), n(BaO), n(CaO), and n(MgO) are mole percentage contents of SrO, BaO, CaO, and MgO at the center or in the tensile stress layer of the chemically strengthened glass-ceramic, respectively; and/or,
a value of n(SrO)/[n(SrO) + n(BaO) + n(CaO) + n(MgO)] is 0, 0.5, or 1, wherein n(SrO), n(BaO), n(CaO), and n(MgO) are mole percentage contents of SrO, BaO, CaO, and MgO at the center or in the tensile stress layer of the chemically strengthened glass-ceramic, respectively.

Optionally, the composition at the center or of the tensile stress layer of the chemically strengthened glass-ceramic comprises:
SiO₂: 55% to 75%, Al₂O₃: 0% to 6%, P₂O₅: 2% to 8%, ZrO₂: 3% to 12%, and Li₂O: 11% to 20%, based on mass percentage of oxides.

Optionally, the composition at the center or of the tensile stress layer of the chemically strengthened glass-ceramic further comprises: SrO: 0% to 6%, and/or, Na₂O: 0% to 4%, and/or, K₂O: 0% to 2%, and/or, CaO: 0% to 5%, and/or, B₂O₃: 0% to 1%, and/or, Ta₂O₅: 0% to 2%, and/or, BaO: 0% to 6%, and/or, MgO: 0% to 3%, and/or, ZnO: 0% to 3%, and/or, Y₂O₃: 0% to 2%, and/or, La₂O₃: 0% to 2%, and/or, Yb₂O₃: 0% to 4%, based on mass percentage of oxides.

Optionally, the composition at the center or of the tensile stress layer of the chemically strengthened glass-ceramic comprises:
SiO₂ with a mass percentage of 60% to 71%, preferably 62% to 68%; and/or,
Al₂O₃ with a mass percentage of 1% to 6%, preferably 1% to 3%, more preferably 2% to 3%; and/or,
P₂O₅ with a mass percentage of 3% to 6%, preferably 3.5% to 5.5%; and/or,
ZrO₂ with a mass percentage of 4% to 11%, preferably 4% to 10%; and/or,
Li₂O with a mass percentage of 11% to 18%, preferably 12% to 17.5%, more preferably 14% to 17%; and/or,
Na₂O with a mass percentage of 0% to 2.8%, preferably 0% to 1%; and/or,
K₂O with a mass percentage of 0% to 1.5%, preferably 0% to 1%; and/or,
CaO with a mass percentage of 0% to 3%, preferably 0% to 1%; and/or,
BaO with a mass percentage of 0% to 5.5%, more preferably 0% to 5%; and/or,
SrO with a mass percentage of 0% to 5%, preferably 0% to 3.5%; and/or,
MgO with a mass percentage of 0% to 2%; and/or,
ZnO with a mass percentage of 0% to 2.5%; and/or,
B₂O₃ with a mass percentage of 0% to 0.8%, preferably 0% to 0.5%; and/or,
Y₂O₃ with a mass percentage of 0% to 1%, preferably 0% to 0.8%; and/or,
La₂O₃ with a mass percentage of 0% to 1.5%, preferably 0% to 1%; and/or,
Ta₂O₅ with a mass percentage of 0% to 1.5%, preferably 0% to 0.5%; and/or,
Yb₂O₃ with a mass percentage of 0% to 3.5%, preferably 0% to 3%,
based on mass percentage of oxides.

Optionally, the crystallinity of the chemically strengthened glass-ceramic is 70% to 90%, more preferably, the crystallinity of the chemically strengthened glass-ceramic is 70% to 87%; and/or,
in the chemically strengthened glass-ceramic, an average grain size is not greater than 100 nm, preferably, the average grain size is not greater than 50 nm, more preferably, the average grain size is 15 nm to 30 nm; and/or,
in the chemically strengthened glass-ceramic, a mass of the lithium disilicate crystalline phase accounts for 80 wt% to 100 wt% of all crystalline phases; and/or,
a mass percentage of a petalite crystalline phase in the chemically strengthened glass-ceramic is less than or equal to 10%, preferably less than or equal to 5%, more preferably, free of the petalite crystalline phase. In the present disclosure, by having the glass-ceramic satisfy a desired crystallinity and/or a desired crystalline phase composition and/or an appropriate average grain size, it is advantageous for the glass-ceramic to maintain excellent optical performance while achieving excellent mechanical strength performance and high intrinsic strength.

Optionally, when the thickness is not greater than 0.70 mm, a b value of the chemically strengthened glass-ceramic is < 1.0, preferably, the b value is < 0.8, more preferably, the b value is ≤ 0.6; and/or,
the chemically strengthened glass-ceramic is transparent within a visible light wavelength range, preferably, for light with a wavelength of 550 nm, a transmittance of the chemically strengthened glass-ceramic is ≥ 85%, preferably, the transmittance is ≥ 90%, more preferably, the transmittance is ≥ 90.27%. The chemically strengthened glass-ceramic satisfying such value and/or transmittance can ensure good display effect and transparency effect, making it suitable for use in display screens of electronic devices where display effect is required.

Optionally, the Young's modulus of the chemically strengthened glass-ceramic is greater than 100 GPa, preferably, the Young's modulus is greater than 105 GPa, more preferably, the Young's modulus is 110 GPa to 130 GPa; and/or,
the density of the chemically strengthened glass-ceramic is 2.51 g/cm³ to 2.65 g/cm³; and/or,
the refractive index of the chemically strengthened glass-ceramic is ≤ 1.60, preferably, the refractive index is 1.54 to 1.60; and/or,
the thickness T of the chemically strengthened glass-ceramic is 0.35 mm to 1.0 mm, preferably, the thickness T is 0.4 mm to 0.7 mm, more preferably, the thickness T is 0.45 mm to 0.55 mm; and/or,
the chemically strengthened glass-ceramic is 2D, 2.5D, 3D, or irregularly shaped; and/or, the chemically strengthened glass-ceramic has a uniform thickness or a non-uniform thickness. Young's modulus, density, and refractive index within the above ranges indicate that the chemically strengthened glass-ceramic has high intrinsic strength/inherent strength, thereby facilitating the achievement of excellent mechanical strength performance and excellent damage resistance performance.

Optionally, the chemically strengthened glass-ceramic satisfies:
0.20 ≤ DOL_0/T ≤ 0.25, preferably 0.21 ≤ DOL_0/T ≤ 0.23, wherein DOL_0 is the depth of the compressive stress layer, and T is the thickness of the chemically strengthened glass-ceramic; and/or,
90.00 µm ≤ DOL_0 ≤ 160.00 µm, preferably 100.00 µm ≤ DOL_0 ≤ 160.00 µm, wherein DOL_0 is the depth of the compressive stress layer; and/or,
100.00 MPa ≤ CS_50 ≤ 300.00 MPa, preferably 110.00 MPa ≤ CS_50 ≤ 250.00 MPa, more preferably 110.00 MPa ≤ CS_50 ≤ 240.00 MPa, wherein CS_50 is the compressive stress value at a depth of 50 µm from the main surface of the chemically strengthened glass-ceramic; and/or,
80.00 MPa ≤ |CT_AV| ≤ 200.00 MPa, preferably 80.00 MPa ≤ |CT_AV| ≤ 170.00 MPa, more preferably 80.00 MPa ≤ |CT_AV| ≤ 160.00 MPa, wherein |CT_AV| is the absolute value of the average tensile stress; and/or,
40000.00 MPa/mm ≤ CT_LD ≤ 100000.00 MPa/mm, preferably 47000.00 MPa/mm ≤ CT_LD ≤ 95000.00 MPa/mm, wherein CT_LD is a tensile stress linear density. In the present disclosure, by making the chemically strengthened glass-ceramic satisfy appropriate stress characteristics, it is advantageous for obtaining a chemically strengthened glass-ceramic product with a high stress level, thereby facilitating the utilization of the stress characteristics to improve mechanical strength performance, ensuring that the chemically strengthened glass-ceramic has excellent damage resistance performance without the problem of "surface cracking".

Optionally, when subjecting the chemically strengthened glass-ceramic to a sandpaper drop resistance test using an 80-mesh sandpaper, when the thickness is not greater than 0.70 mm, an average sandpaper drop resistance height of the chemically strengthened glass-ceramic is ≥ 1.0 m, preferably, the average sandpaper drop resistance height of the chemically strengthened glass-ceramic is ≥ 1.2 m, more preferably, the average sandpaper drop resistance height of the chemically strengthened glass-ceramic is ≥ 1.6 m. The larger the measured average sandpaper drop resistance height, the better the drop damage resistance performance of the chemically strengthened glass-ceramic.

In a second aspect, a glass device is provided, the glass device comprising the chemically strengthened glass-ceramic according to any embodiment of the first aspect.

In a third aspect, a cover glass is provided, the cover glass comprising the chemically strengthened glass-ceramic according to any embodiment of the first aspect. The cover glass may be a display screen cover plate, a back cover, or a camera protection cover plate of an electronic device.

In a fourth aspect, an electronic device is provided, the electronic device comprising the chemically strengthened glass-ceramic according to any embodiment of the first aspect.

Optionally, the electronic device comprises a housing assembled on the outside of the electronic device, the housing comprising the chemically strengthened glass-ceramic according to any embodiment of the first aspect.

Optionally, the housing comprises a display screen cover plate assembled on the front side of the electronic device, the display screen cover plate comprising the chemically strengthened glass-ceramic according to any embodiment of the first aspect.

Optionally, the housing comprises a back cover assembled on the rear side of the electronic device, the back cover comprising the chemically strengthened glass-ceramic according to any embodiment of the first aspect.

Optionally, the electronic device further comprises a camera assembly located inside the housing, the housing comprises a camera protection cover plate, the camera protection cover plate is disposed over the camera assembly, and the camera protection cover plate comprises the chemically strengthened glass-ceramic according to any embodiment of the first aspect.

Optionally, the electronic device further comprises a middle frame located between a display module and the housing, the middle frame comprising the chemically strengthened glass-ceramic according to any embodiment of the first aspect.

In some embodiments, the housing may partially use the chemically strengthened glass-ceramic, or may entirely use the chemically strengthened glass-ceramic. The electronic device of the present disclosure may comprise one or more selected from the group consisting of the display screen cover plate, the back cover, the camera protection cover plate, and the middle frames, which use the chemically strengthened glass-ceramic according to any embodiment of the first aspect.

Compared with the prior art, one or more of the above technical solutions provided by the present disclosure include the following advantages:
By subjecting the glass-ceramic with a specific composition, having lithium disilicate as the main crystalline phase, and having a high lithium content to the chemical strengthening treatment such that it satisfies a specific stress characteristic, in particular, by having the mole percentage content of ZrO₂ in the glass-ceramic and the stress characteristic relationship A satisfy a specific requirement (i.e., satisfy the range requirement of relationship B above), the present disclosure can not only effectively overcome the problem of "surface cracking" in the resulting chemically strengthened glass-ceramic, but also ensure that the chemically strengthened glass-ceramic has high mechanical strength performance, thereby ensuring that the chemically strengthened glass-ceramic has excellent damage resistance performance.

### BRIEF DESCRIPTION OF THE DRAWINGS

The accompanying drawings, which are incorporated in and constitute a part of this specification, illustrate embodiments consistent with the present disclosure and, together with the specification, serve to explain the principles of the present disclosure. It should be understood that the following drawings only illustrate certain embodiments of the present disclosure and are therefore not to be considered limiting of its scope.

In order to more clearly illustrate the technical solutions in the embodiments of the present disclosure or the prior art, the drawings required for use in the description of the embodiments or the prior art will be briefly introduced below. Obviously, for those skilled in the art, other drawings can be obtained based on these drawings without any creative effort.
FIG. 1 is a physical photograph of the chemically strengthened glass-ceramic of Example 1 of the present disclosure under strong light;
FIG. 2 is a physical photograph of the chemically strengthened glass-ceramic of Comparative Example 5 of the present disclosure under strong light;
FIG. 3 is a 2D microscopic image of the main surface of the chemically strengthened glass-ceramic of Example 1 of the present disclosure, magnified 200 times;
FIG. 4 is a 2D microscopic image of the main surface of the chemically strengthened glass-ceramic of Comparative Example 5 of the present disclosure, magnified 100 times;
FIG. 5 is a 2D microscopic image of a cross-section along the thickness direction of the chemically strengthened glass-ceramic of Example 1 of the present disclosure after breakage, magnified 200 times;
FIG. 6 is a 2D microscopic image of a cross-section along the thickness direction of the chemically strengthened glass-ceramic of Comparative Example 5 of the present disclosure after breakage, magnified 200 times;
FIG. 7 is a schematic diagram of the stress test position using SLP-2000 for the Example samples of the present disclosure, with the test point located at the exact center of the sample. In the figure, 7-a is the edge of the main surface of the sample, 7-b is the region of the main surface of the sample, and 7-c is the region of the stress test point position;
FIG. 8 is a schematic diagram of the stress test position using SLP-2000 for the Comparative Example samples of the present disclosure, with the test point located at the exact center of the sample, and the test point being free of the problem of "surface cracking", wherein 8-a is the edge of the main surface of the sample, 8-b is the "surface cracking" region of the sample, 8-c is the region of the stress test point position, and 8-d is the region of the sample without "surface cracking";
FIG. 9 is the optical transmittance curve of the chemically strengthened glass-ceramic of Example 1 of the present disclosure within the visible light wavelength range;
FIG. 10 is an XRD pattern of the glass-ceramic of Example 1 of the present disclosure;
FIG. 11 is an XRD comparison diagram of the glass-ceramic of Example 1 of the present disclosure before and after chemical strengthening, wherein A0 is the XRD pattern of the glass-ceramic before chemical strengthening, and A1 is the XRD pattern of the chemically strengthened glass-ceramic obtained after chemical strengthening;
FIG. 12 is an XRD comparison diagram of the glass-ceramic of Comparative Example 5 of the present disclosure before and after chemical strengthening, wherein B0 is the XRD pattern of the glass-ceramic before chemical strengthening, and B1 is the XRD pattern of the chemically strengthened glass-ceramic obtained after chemical strengthening;
FIG. 13 is a stress distribution diagram of the chemically strengthened glass-ceramic of Example 15 of the present disclosure tested by SLP-2000;
FIG. 14 is a stress distribution diagram of the chemically strengthened glass-ceramic of Comparative Example 8 of the present disclosure tested by SLP-2000;
FIG. 15 is a schematic front structural diagram of an electronic device mentioned in the embodiments of the present disclosure;
FIG. 16 is a schematic rear structural diagram of an electronic device mentioned in the embodiments of the present disclosure;
FIG. 17 is a first schematic structural diagram of an electronic device mentioned in the embodiments of the present disclosure;
FIG. 18 is a second schematic structural diagram of an electronic device mentioned in the embodiments of the present disclosure;
FIG. 19 is a schematic structural diagram of the chemically strengthened glass-ceramic of the present disclosure, wherein d is the depth of the compressive stress layer, 21 is the compressive stress layer, and 22 is the tensile stress layer.

Reference numerals: 1 - housing; 11 - display screen cover plate; 12 - back cover; 13 - camera protection cover plate; 2 - camera assembly; 3 - middle frame; 4 - display module.

### DETAILED DESCRIPTION

The embodiments of the present disclosure will be described in detail below with reference to the Examples. However, those skilled in the art will understand that the following Examples are only for illustrating the present disclosure and should not be considered as limiting the scope of the present disclosure. In the Examples, where specific conditions are not indicated, the conditions are conventional conditions or conditions recommended by the manufacturer. The reagents or instruments used, for which the manufacturer is not indicated, are conventional products commercially available.

The endpoints and any values of the ranges disclosed herein are not limited to the precise ranges or values. These ranges or values should be understood to include values close to these ranges or values. For numerical ranges, the endpoint values of each range, the endpoint values and individual point values of each range, and the individual point values can be combined with each other to obtain one or more new numerical ranges, and these numerical ranges should be considered as specifically disclosed herein. The terms "optionally", "optional", or similar expressions mean that it may be included or may not be included (or may be present or may be absent). The expression of "and/or" as used herein is inclusive, for example, "A and/or B" means only A, only B, or both A and B.

### Term Explanation and Test Methods:

In the present disclosure, the "surface cracking" phenomenon: refers to the phenomenon where the surface of a chemically strengthened glass (e.g., a chemically strengthened glass-ceramic) exhibits obvious cracks/fractures when illuminated with strong light. The micro-cracks/fractures have depths ranging from a few micrometers to tens of micrometers and do not penetrate the entire thickness of the glass.

In the present disclosure, a glass-ceramic is a solid composite material containing both a glass phase and a crystalline phase (or also referred to as a microcrystalline phase or a crystal phase). A glass-ceramic is also known as a microcrystalline glass, a crystallized glass or a crystalline glass.

In the present disclosure, a chemically strengthened glass-ceramic refers to a solid composite material obtained after subjecting a glass-ceramic to a chemical strengthening treatment. It should be understood that during the chemical strengthening treatment, alkali metal ions with larger ionic radii (e.g., potassium ions or sodium ions) in the molten salt bath (or also referred as fused-salt bath) replace alkali metal ions with smaller ionic radii in the glass-ceramic (e.g., sodium ions or lithium ions), thereby generating an exchanged ion volume difference and generating compressive stress (or also referred to as compression stress) on the surface of the glass-ceramic.

In the present disclosure, a base glass (or also referred to as a parent glass) refers to a glass that has not been subjected to a nucleation treatment, crystallization treatment, and strengthening treatment.

In the present disclosure, the nucleation treatment refers to the growth of crystal nucleus in the base glass through heat treatment; and the crystallization treatment refers to the precipitation of target crystals or crystalline phases in the base glass through heat treatment.

In the present disclosure, the composition at the center of the chemically strengthened glass-ceramic refers to the composition at or near the center of the depth or thickness of the chemically strengthened glass-ceramic, i.e., the composition of the region of the chemically strengthened glass-ceramic that has not undergone ion exchange. It should be understood that the composition at the center of the chemically strengthened glass-ceramic is the same as or substantially the same as the composition of the glass-ceramic that has not yet been chemically strengthened.

In the present disclosure, the visible light wavelength range refers to 360 nm to 740 nm.

In the present disclosure, the main crystalline phase (or also referred to as primary crystalline phase) refers to a crystalline phase that has a higher mass content (or also referred to as weight percentage or mass percentage) than other crystalline phases present in the glass-ceramic or chemically strengthened glass-ceramic.

In the present disclosure, the main surface refers to the surface with the largest surface area, for example, the upper or lower surface of a horizontally placed glass-ceramic sheet.

In the present disclosure, the crystallinity refers to the percentage of the total mass of crystalline phases in the glass-ceramic or chemically strengthened glass-ceramic relative to the mass of the glass-ceramic or chemically strengthened glass-ceramic, also referred to as the total crystalline phase content in the glass-ceramic or chemically strengthened glass-ceramic.

In the present disclosure, when light of a given wavelength is irradiated onto the main surface of the glass-ceramic or chemically strengthened glass-ceramic, the light undergoes reflection, absorption, and transmission, and a ratio of an intensity of the transmitted part to an intensity of the incident light is the transmittance.

In the present disclosure, the refractive index refers to a ratio of a speed of light in a vacuum to a speed of light in the medium.

In the present disclosure, a crystallized glass raw material refers to a glass raw material that has been subjected to heat treatment for a period of time to achieve a given crystallinity but has not yet reached a target crystallinity, and which can continue to crystallize upon heating to reach the target crystallinity.

In the present disclosure, CT_LD refers to the tensile stress linear density, in MPa/mm. In the present disclosure, CT_LD is calculated by the following formula: $CT _ LD = \left|CT_AV\right| \times \frac{\left(1000\times T-2\times DOL_0\right)}{T}$ wherein T is the thickness of the chemically strengthened glass-ceramic, in mm; DOL_0 is the depth of the compressive stress layer of the chemically strengthened glass-ceramic, in µm; |CT_AV| is the absolute value of the average tensile stress of the chemically strengthened glass-ceramic, in MPa. It should be understood that in the calculation formula for the tensile stress linear density, data is substituted for calculation according to the above unit requirements, and the calculation result is obtained, wherein only numerical values are used in the calculation, with units being disregarded.

It should be understood that after the glass-ceramic is placed in the molten salt bath for ion exchange, the compressive stress layer (or also referred to as a compression stress layer) is formed on the surface of the glass-ceramic, and the tensile stress layer (or also referred to as a stretching stress layer) is formed inside the glass-ceramic. Illustratively, during the chemical strengthening treatment, alkali metal ions with larger radii in the molten salt bath exchange with alkali metal ions with smaller radii in the glass-ceramic, thereby forming the compressive stress layer on the surface of the glass-ceramic and forming the tensile stress layer inside the glass-ceramic. That is, after the chemical strengthening treatment of the glass-ceramic, the chemically strengthened glass-ceramic comprising the compressive stress layer and the tensile stress layer is prepared.

In the present disclosure, CS_50 refers to the compressive stress value at a depth of 50 µm from the main surface of the chemically strengthened glass-ceramic, in MPa, obtained by testing with an SLP-2000 stress meter (also referred to as a scattered light photoelastic stress meter).

In the present disclosure, |CT_AV| refers to the absolute value of the average tensile stress, in MPa, specifically refers to the absolute value of the average of all tensile stresses in the tensile stress layer, obtained by testing with an SLP-2000 stress meter.

In the present disclosure, DOL_0 refers to the depth of the compressive stress layer, also referred to as the depth of the compression stress layer, specifically refers to the distance from any main surface of the chemically strengthened glass-ceramic to the position near that surface where the compressive stress is zero, obtained by testing with an SLP-2000 stress meter.

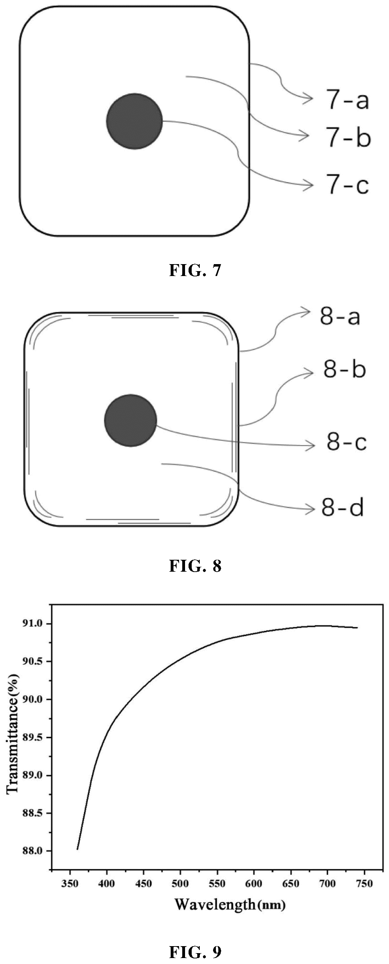

In the present disclosure, the test method for the aforementioned stress properties is as follows: test is performed using an SLP-2000 stress meter with a light source wavelength of 518 nm, SOC = 25.5 (nm/cm)/MPa, the refractive index is set according to the refractive index value of the sample to be tested, and the exposure time is 300 µsec. When testing the stress properties of the chemically strengthened glass-ceramic, it is necessary to first drop an index matching fluid onto the stress meter, then wipe the chemically strengthened glass-ceramic sample to be tested clean, place it on the test path, and test its stress values. The stress meter is SLP-2000, and the index matching fluid used has a refractive index of 1.51. Then, the tensile stress linear density (CT_LD) value of the chemically strengthened glass-ceramic is calculated by the aforementioned formula for tensile stress linear density; the value of ${\int }_{0}^{DOL _ 0} CS \left(t\right) dt$ is calculated from the stress data of the chemically strengthened glass-ceramic measured by SLP-2000. The test positions are referred to FIG. 7 and FIG. 8.

In the present disclosure, the b value is used to characterize the yellow-blue value of the material. The b value in the present disclosure is the b value of the transmitted light; a positive b value indicates that the material tends towards blue.

In the present disclosure, an upper temperature limit for crystallization refers to the highest temperature at which the base glass crystallizes; when the temperature is greater than this temperature, the base glass does not precipitate crystals.

In the present disclosure, the thickness is measured by a micrometer. It should be understood that in the thickness direction of the glass-ceramic sample, the degree of ion exchange varies in a gradient from the surface to the center. Generally, the increment in total exchange amount of Na-K and/or Li-Na (mass) is not greater than 1.5% of the total mass of the sample, so the expansion effect in the thickness direction is extremely slight, and it can be approximately considered that the thickness remains substantially unchanged. That is, before and after chemical strengthening, the thickness change of the glass-ceramic is very small and can be substantially ignored; the thickness of the glass-ceramic is substantially the same as the thickness of the resulting chemically strengthened glass-ceramic.

In the present disclosure, the dimensions of the glass-ceramic sheet are measured using a 2D video measuring machine (instrument model: Miyu MY-YXCL-4030).

In the present disclosure, Young's modulus is used to characterize the ability of a glass to resist elastic deformation due to external forces. In the present disclosure, the UMS-100 ultrasonic material characterization system is used to test the Young's modulus of the glass-ceramic through acoustic waves.

In the present disclosure, the crystalline phases, crystallinity, and average grain size of the glass-ceramic or chemically strengthened glass-ceramic are confirmed by XRD test. Specifically:
(1) XRD test: The glass-ceramic or chemically strengthened glass-ceramic of the present disclosure is pulverized and ground into a sample with a particle size of less than 75 µm. The ground sample is tested using an X-ray diffractometer to obtain an XRD diffraction peak curve and XRD diffraction data. The X-ray diffractometer used in the present disclosure is a Shimadzu XRD-6100, with a target material of copper, 20 = 10° to 50°, scanning speed of 0.2°/min, operating voltage of 40 kV, and operating current of 30 mA.
(2) Determination of crystalline phases: Jade software (JADE Standard 8.6) is used to analyze the XRD diffraction data to determine the crystalline phases in the sample.
(3) Determination of crystallinity (also referred to as total crystalline phase content): The XRD test results (in RAW format) are imported into Jade software for fitting and calculation to determine the crystallinity of the sample. Specifically, the ratio of the fitted crystalline phase peak area to the fitted total peak area is recorded as the crystallinity of the sample.
(4) Determination of average grain size (also referred to as average crystal size): Using the result data obtained from the XRD test, the average grain size of the sample is calculated according to the Scherrer formula D = Kλ/(β cosθ). Here, λ is the X-ray wavelength, λ = 0.154056 nm, β is the full width at half maximum (FWHM) of the diffraction peak, K = 0.89, and θ is the Bragg diffraction angle. Specifically, the RAW format file output by the XRD instrument is curve-fitted in Jade software, and Jade outputs a fitting report. Based on the 2θ angle and Peak FWHM value corresponding to each diffraction peak in the fitting report, the Peak FWHM value is converted to radians: β = (FWHM/180 × 3.14). The grain size for each diffraction peak is calculated by the Scherrer formula D = Kλ/(β cosθ), and the values are averaged to obtain the average grain size in the sample.

In the present disclosure, referring to the national standard "GB/T 7962.12-2010 Test methods of colourless optical glass - Part 12: Spectral internal transmittance", a haze meter is used to test the transmittance and b value of the glass-ceramic of the present disclosure. Specifically, use a haze meter to test the transmittance and b value of five glass-ceramic sheets from the same batch for different wavelengths of light. The average of the b values measured for the five glass-ceramic sheets is recorded as the b value result for the glass-ceramic. The average of the transmittances measured for the five glass-ceramic sheets under light with a wavelength of 550 nm is recorded as the transmittance result for the glass-ceramic under light with a wavelength of 550 nm. The haze meter used in the present disclosure is a Konica Minolta CM-3600A (Japan), with a receiving optical system of transmission, a dispersion method using a plane diffraction grating, a wavelength range of 360 nm to 740 nm, a wavelength interval of 10 nm, an illumination light source of pulsed xenon lamps ×4, and the instrument is placed in an environment with an ambient temperature of 24°C and an air humidity of 40%.

In the present disclosure, a Shimadzu UV-2600 UV-Vis Spectrophotometer is also used to test the transmittance curve of the glass-ceramic or chemically strengthened glass-ceramic under visible light wavelengths.

Density test: In the present disclosure, a Japanese ALFA MIRAGE electronic density balance SD-200L is used to test the density of the glass-ceramic.

Refractive index test: In the present disclosure, a Chinese Shanghai Lichen Bangxi Instrument Technology Abbe refractometer WYA-2WAJ is used to test the refractive index of the glass-ceramic.

Thermal expansion softening point test: The sample is formed into a cylinder with a diameter of 5.5 mm and a length of 20 mm, and is tested using a thermal expansion instrument LINSEIS L75VD1000, which outputs a thermal expansion test curve. The temperature corresponding to the peak position of the curve is recorded as the thermal expansion softening point temperature of the sample.

Upper temperature limit for crystallization test: The base glass is broken into small pieces and then placed and spread in an oblong quartz groove. A gradient furnace model JKZC-XJY01 is set to a temperature range, such as 1050°C to 1225°C, with at least 6 temperature measuring points selected from high to low for each temperature range. After the gradient furnace reaches the preset temperature range, the oblong quartz groove containing the sample is placed into the gradient furnace, so that the 6 temperature measuring points correspond to the glass samples at 6 positions in the oblong quartz groove. The oblong quartz groove is placed in the gradient furnace and kept at a constant temperature for 60 min to 70 min, and then the oblong quartz groove is taken out. A microscope or magnifying glass is used to observe the condition of the glass samples at different positions in the oblong quartz groove. If the glass sample appears devitrified or hazy, it is determined that the glass sample at that location has crystallized. If the glass sample is completely transparent, it is determined that the glass sample at that location has not crystallized. The upper temperature limit for crystallization ranges between the temperature measuring point corresponding to the completely transparent sample and the temperature measuring point corresponding to the adjacent devitrified or hazy sample. The average of the two temperature measuring points is taken as the upper temperature limit for crystallization. If all the glass samples in the oblong quartz groove crystallize or none of them crystallize within the temperature range set by the gradient furnace, the temperature range of the gradient furnace is reset and the upper temperature limit for crystallization of the glass sample is re-measured.

In the present disclosure, M(K₂O) is the mass percentage of K₂O of the surface of the chemically strengthened glass-ceramic. M(Na₂O) is the mass percentage of Na₂O of the surface of the chemically strengthened glass-ceramic.

Test method for M(K₂O): The K element content of the surface of the chemically strengthened glass-ceramic is measured by an X-ray fluorescence spectrometer (XRF), and then the mass percentage of K₂O of the surface is calculated. The calculation method is: K₂O mass percentage of the surface = (K element content of the surface × molecular weight of K₂O) / (atomic weight of K element × 2). It should be understood that the K element content of the surface = K element mass / total element mass, and total element mass = total oxide mass. The model of the X-ray fluorescence spectrometer (XRF) used is Thermo Scientific ARL PERFORM'X, with a target material of Rh (rhodium), a tube voltage of 40 kV, a current of 60 mA, a collimator of 0.15, a crystal of LiF200, a detector of FPC, a test range of a circle with a diameter of 29 mm, and a test method using the X_UQ method in OXSAS analysis software.

Test method for M(Na₂O): The Na element content of the surface of the chemically strengthened glass-ceramic is measured by an X-ray fluorescence spectrometer (XRF), and then the mass percentage of Na₂O of the surface is calculated. The calculation method is: Na₂O mass percentage of the surface = (Na element content of the surface × molecular weight of Na₂O) / (atomic weight of Na element × 2). It should be understood that the Na element content of the surface = Na element mass / total element mass, and total element mass = total oxide mass. The model of the X-ray fluorescence spectrometer (XRF) used is Thermo Scientific ARL PERFORM'X, with a target material of Rh (rhodium), a tube voltage of 30 kV, a current of 80 mA, a collimator of 0.40, a crystal of AxO₃, a detector of FPC, a test range of a circle with a diameter of 29 mm, and a test method using the X_UQ method in OXSAS analysis software.

In the present disclosure, the XRF instrument uses a standardless test and does not test the concentration of elements with atomic number equal to 6 or less than 6 or their oxides in the chemically strengthened glass-ceramic. The mass percentage of K₂O of the surface of the chemically strengthened glass-ceramic = K₂O mass / total oxide mass, and the mass percentage of Na₂O of the surface of the chemically strengthened glass-ceramic = Na₂O mass / total oxide mass, where the oxides include oxides such as SiO₂, Al₂O₃, ZrO₂, Na₂O, K₂O, P₂O₅, which can be accurately measured by XRF, and do not include the content of oxides such as B₂O₃, Li₂O, which cannot be accurately measured by XRF.

In the present disclosure, M'(K₂O) is the mass percentage of K₂O of the surface of the thinned chemically strengthened glass-ceramic obtained after thinning each of two main surfaces of the chemically strengthened glass-ceramic by 3 µm. M'(Na₂O) is the mass percentage of Na₂O of the surface of the thinned chemically strengthened glass-ceramic obtained after thinning each of two main surfaces of the chemically strengthened glass-ceramic by 3 µm. The test methods for M'(K₂O) and M'(Na₂O) are the same as the test methods for M(K₂O) and M(Na₂O).

Average sandpaper drop resistance height test: In the present disclosure, the sum of the sandpaper drop resistance heights measured for each sample among multiple chemically strengthened glass-ceramic samples from the same Example or the same Comparative Example, is divided by the number of samples tested to obtain the value, which is recorded as the average sandpaper drop resistance height of the tested chemically strengthened glass-ceramic used to characterize the drop damage resistance performance of the chemically strengthened glass-ceramic. The drop damage resistance performance here is obtained by testing with uniform sandpaper, which can simulate the application scenario where the chemically strengthened glass-ceramic falls onto a ground with relatively uniform roughness.

Specifically, at least 10 samples are taken per batch for testing. The average sandpaper drop resistance height is $\left〈h\right〉 n = \frac{1}{n} {\sum }_{i = 1}^{n} hi ,$ where n is the number of glass samples tested per batch, and *hi* is the sandpaper drop resistance height measured for a single sample.

Wherein, the test method for the sandpaper drop resistance height of a single sample is as follows:
step 1: an 80-mesh sandpaper is attached to the lower surface of a 181 g test device, and the test device is placed on a LT-SKDL-CD drop machine from LvTu company;
step 2: the chemically strengthened glass-ceramic sample to be tested is placed directly below the test device, making the chemically strengthened glass-ceramic, in particular the main surface of the chemically strengthened glass-ceramic, face the sandpaper. The test device is dropped with a certain drop height to impact the chemically strengthened glass-ceramic sample located directly below the test device. If the chemically strengthened glass-ceramic sample does not break, the drop height of the test device is increased according to a certain rule, and the test device continues to be dropped to impact the chemically strengthened glass-ceramic sample located directly below the test device, until the chemically strengthened glass-ceramic sample breaks. For example, the drop height of the test device starts from 0.4 m, and a drop impact is performed on the sample; if the sample does not break, the drop height of the test device is increased by 0.1 m, and the drop is performed again, and the above process is repeated until the chemically strengthened glass-ceramic sample breaks;
step 3: the drop height of the previous drop before the breakage of the chemically strengthened glass-ceramic sample is recorded as its sandpaper drop resistance height. For example, if the drop height when the sample breaks is 0.5 m using a method of increasing the drop height by 0.1 m each time, the sandpaper drop resistance height of the sample is 0.4 m.

t_{strengthening}: In the Examples of the present disclosure, the glass-ceramic sample to be strengthened is placed in a corresponding salt bath environment for chemical strengthening. During the strengthening process, the glass-ceramic sample is taken out at intervals, and its |CT_AV|, DOL_0, and T are tested using SLP-2000. Then, the CT_LD value at that time point is calculated using the formula $CT _ LD = \left|CT_AV\right| \times \frac{\left(1000\times T-2\times DOL_0\right)}{T} .$

The time required for the CT_LD value to reach its maximum is t_{strengthening}. The stress data of the chemically strengthened glass prepared by placing the glass-ceramic in the corresponding salt bath environment and strengthening for t_{strengthening} time is tested.

Relationship A: In the present disclosure, the relationship is $A = \frac{{\int }_{0}^{DOL _ 0} CS \left(t\right) dt}{DOL _ 0}$, A is a stress characteristic value obtained after strengthening the glass-ceramic sample in the corresponding salt bath environment for a period of time, which is the ratio of the stress integral of the compressive stress layer from the main surface to the depth DOL_0 in the thickness direction of the resulting chemically strengthened glass-ceramic sample to DOL_0. In the Examples, the glass-ceramic base sample to be strengthened is placed in the corresponding salt bath environment and chemically strengthened for a time of t_{strengthening}. The resulting chemically strengthened glass-ceramic sample is taken out, and the corresponding stress curve and stress data such as DOL_0 are obtained by testing with SLP-2000. The A value of the chemically strengthened glass-ceramic sample in the corresponding salt bath environment is obtained by integrating the stress curve and performing calculations.

|K_{0.5×DOL_0}|: On the stress curve measured by SLP-2000, a tangent line is drawn at a depth t = 0.5 × DOL_0 from the main surface of the chemically strengthened glass-ceramic, the absolute value of the slope of this tangent line is calculated.

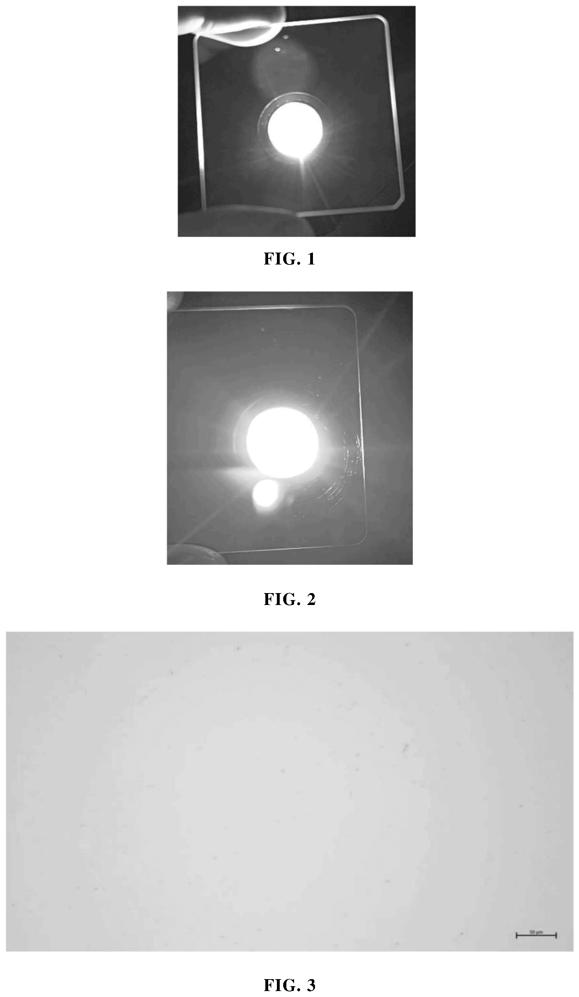

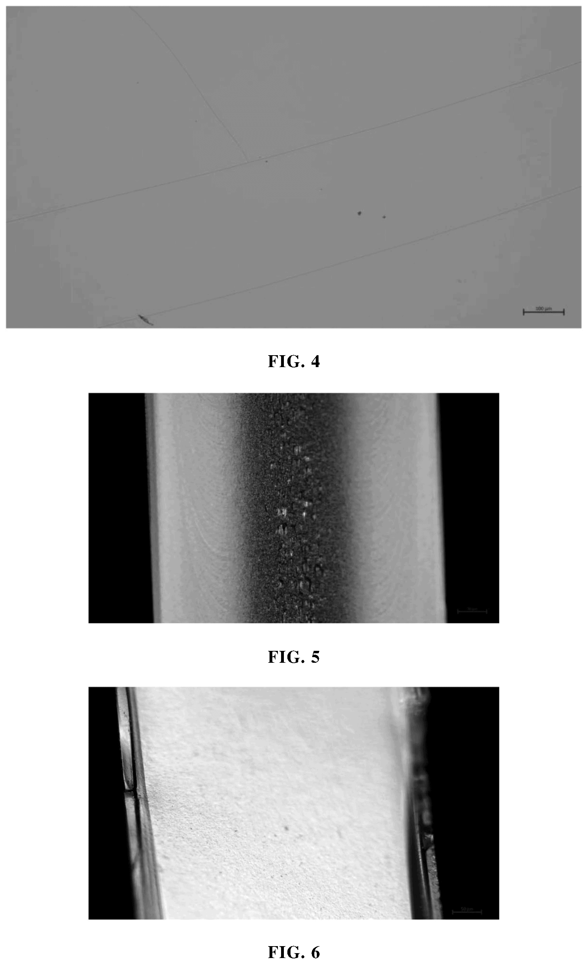

Without being bound by any theory, for the glass-ceramic with a high lithium content and having lithium disilicate as the main crystalline phase, when subjected to the chemical strengthening treatment in the molten salt bath, especially in the high-temperature molten salt bath, a large number of irregular cracks/fractures tend to appear on the surface of the resulting chemically strengthened glass-ceramic. These cracks/fractures exist on the surface of the chemically strengthened glass-ceramic, as shown in FIG. 2 and FIG. 4, with depths ranging from 10 µm to 100 µm, hereinafter referred to as "surface cracking". The problem of "surface cracking" in the chemically strengthened glass-ceramic can lead to a significant decrease in the drop damage resistance performance and mechanical strength of the chemically strengthened glass-ceramic. More severely, it may even render the surface of the chemically strengthened glass-ceramic directly unusable due to excessive cracks/fractures.

Without being bound by any theory, the inventors have discovered that if the surface compressive stress generated during the chemical strengthening process of the glass-ceramic is too concentrated while the internal tensile stress distribution is relatively dispersed, it easily leads to an excessive internal and external stress difference in the matrix. The surface with overly concentrated stress may experience a "bursting" phenomenon, causing the problem of "surface cracking", ultimately resulting in the problem of "surface cracking" in the resulting chemically strengthened glass-ceramic.

Without being bound by any theory, the inventors have discovered that during the chemical strengthening treatment of the glass-ceramic with a high lithium content and having lithium disilicate as the main crystalline phase to prepare a chemically strengthened glass-ceramic with desired properties, the compatibility between the glass composition and the stress distribution structure is very important. If the glass composition and the stress distribution structure are incompatible, the problem of "surface cracking" in the resulting chemically strengthened glass-ceramic is likely to arise, leading to a significant reduction in the mechanical strength performance of the chemically strengthened glass-ceramic. When a glass-ceramic of a specific composition matches an appropriate and preferred stress distribution structure, it not only overcomes the problem of "surface cracking" in the resulting chemically strengthened glass-ceramic but also ensures that the chemically strengthened glass-ceramic has high mechanical strength performance.

During the chemical strengthening treatment of the glass-ceramic with a high lithium content and having lithium disilicate as the main crystalline phase, the compatibility between the glass composition and its chemical strengthening process is very important. If the compatibility between the two is poor, an appropriate matching stress distribution structure cannot be obtained, and a chemically strengthened glass-ceramic with desired properties cannot be obtained.

In the present disclosure, to mitigate the problem that the glass-ceramic with a high lithium content and having lithium disilicate as the main crystalline phase is prone to "surface cracking" after the chemical strengthening treatment, a chemically strengthened glass-ceramic is provided, which, with a high lithium content and having lithium disilicate as the main crystalline phase, has a specific composition and a specific stress distribution structure. The chemically strengthened glass-ceramic not only is free from the problem of "surface cracking" but also has high mechanical strength performance.

As described above, in some embodiments of the present disclosure, a chemically strengthened glass-ceramic is provided, wherein a main crystalline phase of the chemically strengthened glass-ceramic is a lithium disilicate crystalline phase; a crystallinity of the chemically strengthened glass-ceramic is not less than 65%; a Li₂O content at a center of the chemically strengthened glass-ceramic is not less than 11%, based on mass percentage of oxides;
the chemically strengthened glass-ceramic has a compressive stress layer on a surface thereof and has a tensile stress layer inside; the chemically strengthened glass-ceramic satisfies the following relationships: $A = \frac{{\int }_{0}^{DOL _ 0} CS \left(t\right) dt}{DOL _ 0} ;$ and
B=A-83989×[n(ZrO₂)]²+2526.5×n(ZrO₂), with 130 ≤ B ≤ 180, preferably 135 ≤ B ≤ 180, more preferably 135 ≤ B ≤ 175;
wherein t is a depth from a main surface of the chemically strengthened glass-ceramic, CS(t) is a compressive stress value at depth t, ${\int }_{0}^{DOL _ 0} CS \left(t\right) dt$ is a stress integral of the compressive stress layer from the main surface to DOL_0 of the chemically strengthened glass-ceramic, in MPa·µm; and
DOL_0 is a depth of the compressive stress layer, in µm;
in relationship A, corresponding data are substituted for calculation according to the above unit requirements, and the calculation result of relationship A is obtained, wherein only numerical values are used in the calculation, with units being disregarded;
n(ZrO₂) is a mole percentage content of ZrO₂ at the center of the chemically strengthened glass-ceramic;
in relationship B, the value of relationship A and the numerical value of the mole percentage content of ZrO₂ are substituted for calculation, and the calculation result of relationship B is obtained, wherein only numerical values are used in the calculation, with units being disregarded.

In the present disclosure, by subjecting a glass-ceramic with a high lithium content, having a specific composition, and having lithium disilicate as the main crystalline phase, to chemical strengthening treatment such that it satisfies specific stress characteristics, in particular, by having the mole percentage content of ZrO₂ in the glass-ceramic and the stress characteristic relationship A satisfy a specific requirement (i.e., satisfy the range requirement of relationship B above), it is able to not only effectively overcome the problem of "surface cracking" in the resulting chemically strengthened glass-ceramic, but also ensure that the chemically strengthened glass-ceramic has high mechanical strength performance, thereby ensuring that the chemically strengthened glass-ceramic has excellent damage resistance performance.

When the value of relationship B is greater than the upper limit, the resulting chemically strengthened glass-ceramic exhibits the "surface cracking" phenomenon; when the value of relationship B is less than the lower limit, the resulting chemically strengthened glass-ceramic cannot achieve the desired stress effect, its stress level is too low, and its mechanical properties and strength performance are poor.

In some embodiments, the value of relationship B can be: 130.00, 135.00, 140.00, 145.00, 150.00, 155.00, 160.00, 165.00, 170.00, 175.00, 180.00, 144.41, 149.14, 151.82, 157.96, 159.24, 161.80, 166.00, 148.99, 165.83, 168.65, 170.67, 163.85, 155.53, 136.18, 155.43, 172.09, 147.01, 147.17, 165.17, 164.24, or 166.69, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments of the present disclosure, the value of relationship A satisfies: 120 ≤ A ≤ 250, preferably 130 ≤ A ≤ 240, more preferably 130 ≤ A ≤ 235. By making the chemically strengthened glass-ceramic satisfy relationship A, it is advantageous for enabling the chemically strengthened glass-ceramic to achieve a desired high stress level, thereby helping to ensure that the chemically strengthened glass-ceramic has high mechanical strength performance.

In some embodiments, the value of relationship A can be: 120.00, 125.00, 130.00, 135.00, 140.00, 145.00, 150.00, 155.00, 160.00, 165.00, 170.00, 175.00, 180.00, 185.00, 190.00, 195.00, 200.00, 205.00, 210.00, 215.00, 220.00, 225.00, 230.00, 235.00, 240.00, 245.00, 250.00, 150.39, 155.13, 157.80, 163.95, 165.23, 167.78, 171.98, 130.02, 148.08, 153.52, 157.87, 150.70, 161.51, 200.59, 217.59, 234.24, 208.06, 207.14, 220.07, 224.21, or 226.66, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments of the present disclosure, the chemically strengthened glass-ceramic satisfies the following relationship: C = A - |CT_AV|, with 30 ≤ C ≤ 90, preferably 30 ≤ C ≤ 85, more preferably 30 ≤ C ≤ 80, wherein |CT_AV| is the absolute value of the average tensile stress, in MPa. By making the chemically strengthened glass-ceramic satisfy relationship C, it helps to overcome the problem of "surface cracking" in the resulting chemically strengthened glass-ceramic and helps to ensure that the chemically strengthened glass-ceramic has high mechanical strength performance. When the value of relationship C is greater than the upper limit, it is detrimental to solving the problem of "surface cracking" in the resulting chemically strengthened glass-ceramic; when the value of relationship C is less than the lower limit, it is detrimental to the resulting chemically strengthened glass-ceramic achieving the desired stress effect, its stress level is too low, and its mechanical properties and strength performance are poor.

In some embodiments, the value of relationship C can be: 30.00, 35.00, 40.00, 45.00, 50.00, 55.00, 60.00, 65.00, 70.00, 75.00, 80.00, 85.00, 90.00, 33.97, 40.28, 37.3, 41.41, 47.67, 42.93, 45.51, 45.77, 52.74, 53.28, 51.42, 52.28, 37.27, 64.74, 70.95, 77.45, 57.85, 52.49, 67.32, 66.26, or 64.31, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments of the present disclosure, the chemically strengthened glass-ceramic satisfies the following relationship: 2 ≤ |K_{0.5×DOL_0}| ≤ 6, preferably 2.5 ≤ |K_{0.5×DOL_0}| ≤ 5.5, more preferably 3 ≤ |K_{0.5×DOL_0}| ≤ 5, wherein |K_{0.5×DOL_0}| is the absolute value of the slope of the stress curve at a depth t = 0.5 × DOL_0 from the main surface of the chemically strengthened glass-ceramic. By making the chemically strengthened glass-ceramic satisfy the above relationship, it helps to overcome the problem of "surface cracking" in the resulting chemically strengthened glass-ceramic and helps to ensure that the chemically strengthened glass-ceramic has high mechanical strength performance. When the value of |K_{0.5×DOL_0}| is greater than the upper limit, it is detrimental to solving the problem of "surface cracking" in the resulting chemically strengthened glass-ceramic; when the value of |K_{0.5×DOL_0}| is less than the lower limit, it is detrimental to the resulting chemically strengthened glass-ceramic achieving the desired stress effect, its stress level is too low, and its mechanical properties and strength performance are poor.

In some embodiments, the value of |K_{0.5×DOL_0}| can be: 2, 2.5, 3, 3.5, 4, 4.5, 5, 5.5, 6, 3.088, 3.154, 3.105, 3.241, 3.085, 3.208, 3.309, 2.958, 3.224, 3.647, 3.057, 3.464, 3.354, 4.587, 4.244, 4.216, 4.485, 4.454, or 4.324, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments of the present disclosure, the chemically strengthened glass-ceramic satisfies: 0 ≤ M(K₂O) ≤ 1.5%, and 5% ≤ M(Na₂O) ≤ 25%; M(K₂O) is the mass percentage of K₂O of the surface of the chemically strengthened glass-ceramic, and M(Na₂O) is the mass percentage of Na₂O of the surface of the chemically strengthened glass-ceramic.

In some embodiments, M(K₂O) can be 0, 0.1%, 0.2%, 0.3%, 0.4%, 0.5%, 0.6%, 0.7%, 0.8%, 0.9%, 1.0%, 1.1%, 1.2%, 1.3%, 1.4%, or 1.5%, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments, M(Na₂O) can be 5%, 5.5%, 6%, 6.5%, 7%, 7.5%, 8%, 8.5%, 9%, 9.5%, 10%, 10.5%, 11%, 11.5%, 12%, 12.5%, 13%, 13.5%, 14%, 14.5%, 15%, 15.5%, 16%, 16.5%, 17%, 17.5%, 18%, 18.5%, 19%, 19.5%, 20%, 20.5%, 21%, 21.5%, 22%, 22.5%, 23%, 23.5%, 24%, 24.5%, or 25%, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments of the present disclosure, after thinning a thickness of 3 µm from each of two main surfaces of the chemically strengthened glass-ceramic, the resulting thinned chemically strengthened glass-ceramic satisfies: a mass percentage M'(K₂O) of K₂O of the surface of the thinned chemically strengthened glass-ceramic and a mass percentage M'(Na₂O) of Na₂O of the surface of the thinned chemically strengthened glass-ceramic are: 0 ≤ M'(K₂O) ≤ 0.5%, and 4.0% ≤ M'(Na₂O) ≤ 20%.

In some embodiments, M'(K₂O) can be 0, 0.1%, 0.2%, 0.3%, 0.4%, or 0.5%, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments, M'(Na₂O) can be 4%, 4.5%, 5%, 5.5%, 6%, 6.5%, 7%, 7.5%, 8%, 8.5%, 9%, 9.5%, 10%, 10.5%, 11%, 11.5%, 12%, 12.5%, 13%, 13.5%, 14%, 14.5%, 15%, 15.5%, 16%, 16.5%, 17%, 17.5%, 18%, 18.5%, 19%, 19.5%, or 20%, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

It should be understood that the chemically strengthened glass-ceramic of the present disclosure is prepared by subjecting the glass-ceramic to the chemical strengthening treatment. The mass percentages of Na₂O and K₂O of the surface of the chemically strengthened glass-ceramic differ from the mass percentages of Na₂O and K₂O of the surface of the thinned chemically strengthened glass-ceramic obtained after thinning each of two main surfaces of the chemically strengthened glass-ceramic by 3 µm in the thickness direction. This is because during the chemical strengthening treatment, the glass-ceramic undergoes ion exchange, smaller alkali metal ions (e.g., Li⁺ or Na⁺) are replaced by larger alkali metal ions (e.g., Na⁺ or K⁺) respectively, and the surface layer of the glass-ceramic is in direct contact with the salt bath, experiencing less resistance from the glass matrix. The exchange rate in the surface layer is higher, forcing larger alkali metal ions (e.g., Na⁺ or K⁺) to enter more easily. However, as ion exchange proceeds, ions in the interior undergo ion exchange with increasing resistance from the glass matrix, making it more difficult. Therefore, compared to the mass percentages of Na₂O and K₂O of the surface of the thinned chemically strengthened glass-ceramic obtained after thinning each of two main surfaces of the chemically strengthened glass-ceramic by 3 µm, the mass percentages of Na₂O and K₂O of the surface of the unthinned chemically strengthened glass-ceramic are higher.

In some embodiments of the present disclosure, the chemically strengthened glass-ceramic satisfies: 0.20 ≤ DOL_0/T ≤ 0.25, preferably 0.21 ≤ DOL_0/T ≤ 0.23, wherein DOL_0 is the depth of the compressive stress layer, and T is the thickness of the chemically strengthened glass-ceramic. By having the depth of the compressive stress layer and the thickness of the chemically strengthened glass-ceramic satisfy an appropriate ratio relationship, it helps to ensure that the chemically strengthened glass-ceramic is in a more favorable stress distribution state, thereby facilitating the utilization of the stress structure to improve mechanical strength performance.

In some embodiments, the value of DOL_0/T in the chemically strengthened glass-ceramic can be 0.20 to 0.23 or 0.21 to 0.22. In some embodiments, the value of DOL_0/T in the chemically strengthened glass-ceramic can be 0.20, 0.21, 0.22, 0.23, 0.24, or 0.25, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments of the present disclosure, the chemically strengthened glass-ceramic satisfies: 90 µm ≤ DOL_0 ≤ 160 µm, preferably 100.00 µm ≤ DOL_0 ≤ 160.00 µm, wherein DOL_0 is the depth of the compressive stress layer. By making the chemically strengthened glass-ceramic have an appropriate DOL_0, it is able to prevent a sudden crack generated by impact or puncture from a blunt or sharp object from directly penetrating the compressive stress region and reaching the tensile stress region, which would cause the chemically strengthened glass-ceramic to shatter. This makes it more advantageous for improving the ability of the chemically strengthened glass-ceramic to counteract the energy that drives crack propagation, thereby ensuring that the chemically strengthened glass-ceramic has excellent damage resistance performance, such as excellent drop damage resistance performance.

In some embodiments, the DOL_0 of the chemically strengthened glass-ceramic can be 100.00 µm, 105.00 µm, 110.00 µm, 115.00 µm, 120 µm, 130 µm, 140 µm, 150 µm, 160 µm, 110.54 µm, 109.75 µm, 111.42 µm, 110.75 µm, 114.2 µm, 111.9 µm, 113.24 µm, 105.74 µm, 107.56 µm, 107.96 µm, 110.78 µm, 108.98 µm, 109.87 µm, 107.04 µm, 107.62 µm, 109.78 µm, 110.42 µm, 112.85 µm, 106.99 µm, 107.67 µm, or 110.42 µm, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

The thickness T of the chemically strengthened glass-ceramic of the present disclosure is not particularly limited. For example, in some embodiments of the present disclosure, the glass-ceramic used to prepare the chemically strengthened glass-ceramic or the chemically strengthened glass-ceramic itself is in the form of a plate. Optionally, the thickness T of the glass-ceramic used to prepare the chemically strengthened glass-ceramic or the chemically strengthened glass-ceramic can be 0.35 mm to 1.0 mm, preferably the thickness T is 0.4 mm to 0.7 mm; more preferably, the thickness T is 0.45 mm to 0.55 mm. Optionally, the thickness T of the chemically strengthened glass-ceramic of the present disclosure can be 0.35 mm, 0.4 mm, 0.45 mm, 0.5 mm, 0.55 mm, 0.6 mm, 0.65 mm, 0.7 mm, 0.8 mm, 0.9 mm, or 1.0 mm, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained. Currently, electronic devices typically pursue being light and thin, on the premise that the smaller the thickness, the lighter the weight, and the better the optical effect. The present disclosure is able to make the chemically strengthened glass-ceramic product as thin as possible while ensuring strength, to meet the light and thin requirements of electronic devices.

In the present disclosure, by making the chemically strengthened glass-ceramic satisfy appropriate stress characteristics, it is advantageous for obtaining a chemically strengthened glass-ceramic product with a high stress level, thereby facilitating the utilization of the stress characteristics to improve mechanical strength performance, ensuring that the chemically strengthened glass-ceramic has excellent damage resistance performance without the problem of "surface cracking".

In some embodiments of the present disclosure, the chemically strengthened glass-ceramic satisfies: 100 MPa ≤ CS_50 ≤ 300 MPa, preferably 110 MPa ≤ CS_50 ≤ 250 MPa, more preferably 110 MPa ≤ CS_50 ≤ 240 MPa, wherein CS_50 is the compressive stress value at a depth of 50 µm from the main surface of the chemically strengthened glass-ceramic.

In some embodiments, the CS_50 of the chemically strengthened glass-ceramic can be 100.00 MPa, 110.00 MPa, 120.00 MPa, 130.00 MPa, 140.00 MPa, 150.00 MPa, 160.00 MPa, 170.00 MPa, 180.00 MPa, 190.00 MPa, 200.00 MPa, 210.00 MPa, 220.00 MPa, 230.00 MPa, 240.00 MPa, 250.00 MPa, 260.00 MPa, 270.00 MPa, 280.00 MPa, 290.00 MPa, 300.00 MPa, 158.56 MPa, 168.85 MPa, 168.41 MPa, 180.27 MPa, 195.42 MPa, 170.2 MPa, 188.74 MPa, 113.52 MPa, 153.44 MPa, 143.55 MPa, 147.58 MPa, 153.89 MPa, 184.21 MPa, 207.1 MPa, 216.95 MPa, 246.54 MPa, 223.64 MPa, 229.67 MPa, 223.5 MPa, 239.75 MPa, or 244.85 MPa, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments of the present disclosure, the chemically strengthened glass-ceramic satisfies: 80.00 MPa ≤ |CT_AV| ≤ 200.00 MPa, preferably 80.00 MPa ≤ |CT_AV| ≤ 170.00 MPa, more preferably 80.00 MPa ≤ |CT_AV| ≤ 160.00 MPa, wherein |CT_AV| is the absolute value of the average tensile stress.

In some embodiments, the |CT_AV| of the chemically strengthened glass-ceramic can be 80.00 MPa to 160.00 MPa, 100.00 MPa to 160.00 MPa, 100.00 MPa to 125.00 MPa, 105.00 MPa to 120.00 MPa, 100.00 MPa to 150.00 MPa, or 110.00 MPa to 115.00 MPa. In some embodiments, the |CT_AV| of the chemically strengthened glass-ceramic can be 80 MPa, 85 MPa, 90 MPa, 100.00 MPa, 110.00 MPa, 120.00 MPa, 125.00 MPa, 130.00 MPa, 135.00 MPa, 140.00 MPa, 150.00 MPa, 160.00 MPa, 170.00 MPa, 180.00 MPa, 190.00 MPa, 200.00 MPa, 116.42 MPa, 114.85 MPa, 120.5 MPa, 122.54 MPa, 117.56 MPa, 124.85 MPa, 126.47 MPa, 84.25 MPa, 95.34 MPa, 100.24 MPa, 106.45 MPa, 98.42 MPa, 124.24 MPa, 135.85 MPa, 146.64 MPa, 156.79 MPa, 150.21 MPa, 154.65 MPa, 152.75 MPa, 157.95 MPa, or 162.35 MPa, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

In some embodiments of the present disclosure, the chemically strengthened glass-ceramic satisfies: 40000.00 MPa/mm ≤ CT_LD ≤ 100000.00 MPa/mm, preferably 47000.00 MPa/mm ≤ CT_LD ≤ 95000.00 MPa/mm, wherein CT_LD is the tensile stress linear density. Controlling the CT_LD of the chemically strengthened glass-ceramic to be at a relatively large value, for example, not less than 40000 MPa/mm, is advantageous for ensuring that the tensile stress stored inside the chemically strengthened glass-ceramic is sufficiently dense, thereby helping to ensure that it has a high surface stress level, ensuring that it can obtain excellent damage resistance performance, such as excellent drop damage resistance performance, to meet market demands.

In some embodiments, the CT_LD of the chemically strengthened glass-ceramic can be 55000 MPa/mm to 92000 MPa/mm, 58000 MPa/mm to 90000 MPa/mm, 56000 MPa/mm to 94000 MPa/mm, or 57000 MPa/mm to 93000 MPa/mm. In some embodiments, the CT_LD of the chemically strengthened glass-ceramic can be 40000 MPa/mm, 45000 MPa/mm, 50000 MPa/mm, 55000 MPa/mm, 60000 MPa/mm, 65000 MPa/mm, 66000 MPa/mm, 67000 MPa/mm, 68000 MPa/mm, 69000 MPa/mm, 70000 MPa/mm, 72000 MPa/mm, 74000 MPa/mm, 76000 MPa/mm, 78000 MPa/mm, 80000 MPa/mm, 85000 MPa/mm, 90000 MPa/mm, 95000 MPa/mm, 100000 MPa/mm, 64943.73 MPa/mm, 64430.85 MPa/mm, 66795.56 MPa/mm, 68254.78 MPa/mm, 63858.59 MPa/mm, 68967.14 MPa/mm, 69184.15 MPa/mm, 48615.62 MPa/mm, 54320.92 MPa/mm, 56952.36 MPa/mm, 59279.88 MPa/mm, 55516.75 MPa/mm, 69639 MPa/mm, 77684.46 MPa/mm, 83514.41 MPa/mm, 87940.38 MPa/mm, 83865.25 MPa/mm, 84840.99 MPa/mm, 87379.11 MPa/mm, 89924.09 MPa/mm, or 90643.25 MPa/mm, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

It should be understood that the chemically strengthened glass-ceramic of the present disclosure is prepared by subjecting the glass-ceramic to the chemical strengthening treatment, and the composition at the center of the chemically strengthened glass-ceramic is the same as or substantially the same as the composition of the glass-ceramic. Compared to the glass-ceramic before the chemical strengthening treatment, the composition at the surface of the resulting chemically strengthened glass-ceramic may differ from the composition of the glass-ceramic before the chemical strengthening treatment. This is because ion exchange occurs during the chemical strengthening treatment. During ion exchange, one type of alkali metal ion (e.g., Li⁺ or Na⁺) at the surface of the glass-ceramic is replaced by a larger alkali metal ion (e.g., Na⁺ or K⁺) from the molten salt bath, respectively. However, in embodiments, the glass composition and phase assemblage at or near the center of the depth or thickness of the glass-ceramic product will still have the composition and phase assemblage of the freshly formed glass-ceramic. That is, in the present disclosure, the composition and the phase assemblage at the center of the chemically strengthened glass-ceramic or the composition and the phase assemblage of the tensile stress layer of the chemically strengthened glass-ceramic are the same as or substantially the same as those of the glass-ceramic that has not been chemically strengthened.

In the present disclosure, the glass-ceramic used to prepare the above chemically strengthened glass-ceramic can be obtained by subjecting the base glass to the heat treatment. The composition of the base glass is also the same as or substantially the same as the composition of the glass-ceramic, based on mole percentage or mass percentage of oxides.

In some embodiments of the present disclosure, the composition of the base glass, or the composition of the glass-ceramic, or the composition at the center or of the tensile stress layer of the chemically strengthened glass-ceramic comprises: SiO₂: 58% to 66%, Al₂O₃: 0% to 3.5%, P₂O₅: 1% to 3%, ZrO₂: 1% to 6%, and Li₂O: 24% to 32%, based on mole percentage of oxides. By adjusting and controlling the content ranges of the various oxide components to satisfy a specific glass composition, it is advantageous for obtaining a glass-ceramic that satisfies a specific crystalline phase structure, and for preparing a chemically strengthened glass-ceramic that satisfies a specific stress structure.

In some embodiments of the present disclosure, the composition of the base glass, or the composition of the glass-ceramic, or the composition at the center or of the tensile stress layer of the chemically strengthened glass-ceramic further comprises: SrO: 0% to 3%, and/or, Na₂O: 0% to 4%, and/or, K₂O: 0% to 2%, and/or, CaO: 0% to 5%, and/or, B₂O₃: 0% to 1%, and/or, Ta₂O₅: 0% to 1%, and/or, BaO: 0% to 3%, and/or, MgO: 0% to 3%, and/or, ZnO: 0% to 3%, and/or, Y₂O₃: 0% to 1%, and/or, La₂O₃: 0% to 1%, and/or, Yb₂O₃: 0% to 1%, based on mole percentage of oxides.

It is understood that the measurement method of the composition of the base glass, or the composition of the glass-ceramic, or the composition at the center or of the tensile stress layer of the chemically strengthened glass-ceramic can be converted, for example, the above measurement method based on mole percentage of oxides can be converted to a measurement method based on mass percentage of oxides.

In some embodiments of the present disclosure, the composition of the base glass, or the composition of the glass-ceramic, or the composition at the center or of the tensile stress layer of the chemically strengthened glass-ceramic comprises: SiO₂: 55% to 75%, Al₂O₃: 0% to 6%, P₂O₅: 2% to 8%, ZrO₂: 3% to 12%, and Li₂O: 11% to 20%, based on mass percentage of oxides.

In some embodiments of the present disclosure, the composition of the base glass, or the composition of the glass-ceramic, or the composition at the center or of the tensile stress layer of the chemically strengthened glass-ceramic further comprises: SrO: 0% to 6%, and/or, Na₂O: 0% to 4%, and/or, K₂O: 0% to 2%, and/or, CaO: 0% to 5%, and/or, B₂O₃: 0% to 1%, and/or, Ta₂O₅: 0% to 2%, and/or, BaO: 0% to 6%, and/or, MgO: 0% to 3%, and/or, ZnO: 0% to 3%, and/or, Y₂O₃: 0% to 2%, and/or, La₂O₃: 0% to 2%, and/or, Yb₂O₃: 0% to 4%, based on mass percentage of oxides.

In the present disclosure, SiO₂ is a glass network forming oxide, an indispensable component for forming the glass network structure. At the same time, SiO₂ is also an important component of the main crystalline phase, lithium disilicate (Li₂Si₂O₅) crystalline phase. Appropriately increasing the content of SiO₂ can increase the stability and mechanical strength of the glass, helping to ensure the precipitation of a desired content of the lithium disilicate crystalline phase. However, excessive SiO₂ increases the viscosity of the base glass, making the glass melting process more difficult, thereby reducing the formability of the base glass. Therefore, to satisfy the glass formability requirements and achieve the desired crystallization effect of the present disclosure, thereby obtaining the desired glass-ceramic or chemically strengthened glass-ceramic product of the present disclosure, in the composition of the base glass, or the composition of the glass-ceramic, or the composition at the center or of the tensile stress layer of the chemically strengthened glass-ceramic, the mole percentage content of SiO₂ is 58% to 66%, or the mass percentage content of SiO₂ is 55% to 75%.

In some embodiments, in the composition of the base glass, or the composition of the glass-ceramic, or the composition at the center or of the tensile stress layer of the chemically strengthened glass-ceramic, the mole percentage of SiO₂ can be 58% to 66%, 60.5% to 64.5%, 60% to 65%, or 60.5% to 64%, based on mole percentage of oxides. In some embodiments, in the composition of the base glass, or the composition of the glass-ceramic, or the composition at the center or of the tensile stress layer of the chemically strengthened glass-ceramic, the mole percentage of SiO₂ can be 58%, 59%, 60%, 61%, 62%, 63%, 64%, 65%, 66%, 60.92%, 60.94%, 61.15%, 61.16%, 61.43%, 61.72%, 61.82%, 62.58%, 62.77%, 63.16%, 63.39%, or 63.86%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of SiO₂ can be 55% to 75%, 60% to 71%, 62% to 68%, or 63% to 71%, based on mass percentage of oxides. In some embodiments, in the composition of the base glass, or the composition of the glass-ceramic, or the composition at the center or of the tensile stress layer of the chemically strengthened glass-ceramic, the mass percentage of SiO₂ can be 55%, 56%, 57%, 58%, 59%, 60%, 61%, 62%, 63%, 64%, 65%, 66%, 67%, 68%, 69%, 70%, 71%, 72%, 73%, 74%, 75%, 65.86%, 70.54%, 69.11%, 68.06%, 70.78%, 67.86%, 66.67%, 65.63%, 66.06%, 63.50%, 63.96%, 64.45%, 65.47%, or 63.31%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, Al₂O₃ is an optional component. The addition of an appropriate amount of Al₂O₃ helps to promote ion exchange during the chemical strengthening process to a certain extent. However, excessive Al₂O₃ increases the viscosity of the glass, and at the same time, it easily leads to the precipitation of other crystalline phases, such as petalite, affecting the crystalline phase structure of the glass-ceramic. Therefore, in the present disclosure, to satisfy the desired crystalline phase structure and obtain the desired performance of the glass-ceramic or chemically strengthened glass-ceramic, in the composition of the base glass, or the composition of the glass-ceramic, or the composition at the center or of the tensile stress layer of the chemically strengthened glass-ceramic, the mole percentage content of Al₂O₃ is 0% to 3.5%, or the mass percentage content of Al₂O₃ is 0% to 6%.

In some embodiments, in the composition of the base glass, or the composition of the glass-ceramic, or the composition at the center or of the tensile stress layer of the chemically strengthened glass-ceramic, the mole percentage of Al₂O₃ can be 0%, 0.2%, 0.4%, 0.5%, 0.6%, 0.8%, 1%, 1.2%, 1.4%, 1.5%, 1.6%, 1.8%, 2%, 2.5%, 3%, 3.5%, 1.14%, 1.22%, 1.23%, 1.37%, 1.38%, 1.4%, 1.42%, 1.43%, or 1.44%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of Al₂O₃ can be 0%, 0.5%, 1%, 1.5%, 2%, 2.5%, 3%, 3.5%, 4%, 4.5%, 5%, 5.5%, 6%, 2.7%, 2.64%, 2.63%, 2.33%, 2.58%, 2.53%, 2.52%, 2.51%, 2.42%, 2.43%, 2.45%, 2.08%, or 2.15%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, P₂O₅ is a glass-forming oxide, existing in the network structure as a phosphorus-oxygen tetrahedron [PO₄]. P₂O₅ appears preferentially during the heat treatment process, first causing the glass phase to separate and cluster, forming an amorphous precursor phase Li₃PO₄. Subsequently, Li₃PO₄ acts as heterogeneous nucleation sites, and crystalline phases such as lithium silicate grow attached to the amorphous Li₃PO₄. As the P₂O₅ content increases, the number of heterogeneous nucleation sites increases, and the crystal grains nucleated by Li₃PO₄ are effectively refined, which is beneficial for improving the overall transmittance of the glass-ceramic, the uniformity of the glass, and reducing the b value. However, when the P₂O₅ content is too high, an excessive amount of Li₃PO₄ crystals tends to form, leading to an insufficient Li₂O content for forming lithium silicate. This makes the base glass prone to precipitating quartz crystals, causing a decrease in the transmittance of the glass-ceramic and a decrease in the overall optical uniformity of the glass-ceramic. When the P₂O₅ content is too low, the size of the precipitated crystals tends to be large, making the glass prone to devitrification. Therefore, to achieve the desired crystallization effect of the present disclosure and obtain the desired performance of the glass-ceramic or chemically strengthened glass-ceramic, in the composition of the base glass, or the composition of the glass-ceramic, or the composition at the center or of the tensile stress layer of the chemically strengthened glass-ceramic, the mole percentage content of P₂O₅ is 1% to 3%, or the mass percentage content of P₂O₅ is 2% to 8%.

In some embodiments, in the composition of the base glass, or the composition of the glass-ceramic, or the composition at the center or of the tensile stress layer of the chemically strengthened glass-ceramic, the mole percentage of P₂O₅ can be 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 1.51%, 1.74%, 1.83%, 1.84%, 1.85%, 1.86%, 1.87%, 1.89%, or 1.92%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of P₂O₅ can be 2%, 2.5%, 3%, 3.5%, 4%, 4.5%, 5%, 5.5%, 6%, 6.5%, 7%, 7.5%, 8%, 4.66%, 5.01%, 4.89%, 4.46%, 3.98%, 4.79%, 4.72%, 4.67%, 4.68%, 4.49%, 4.65%, 4.49%, 4.52%, or 4.56%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, ZrO₂ is an intermediate oxide for glass formation. An appropriate amount of ZrO₂ can improve the chemical stability of the glass, increase the hardness of the glass, and enhance the scratch resistance and drop resistance ability of the glass. At the same time, because ZrO₂ cations have high charge and strong field strength, they have a significant accumulation effect on the glass structure and are also commonly used as nucleating agents in glass-ceramics. The higher the ZrO₂ content, the larger the A value that the lithium disilicate glass-ceramic can tolerate without undergoing "surface cracking" during the chemical strengthening process, resulting in a more ideal stress effect. However, when the ZrO₂ content is relatively high, the optical performance of the glass-ceramic is poorer. Therefore, to satisfy the glass formability requirements and achieve the desired strength effect of the present disclosure, in the composition of the base glass, or the composition of the glass-ceramic, or the composition at the center or of the tensile stress layer of the chemically strengthened glass-ceramic, the mole percentage content of ZrO₂ is 1% to 6%, or the mass percentage content of ZrO₂ is 3% to 12%.

In some embodiments, in the composition of the base glass, or the composition of the glass-ceramic, or the composition at the center or of the tensile stress layer of the chemically strengthened glass-ceramic, the mole percentage of ZrO₂ can be 1%, 1.2%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.5%, 4%, 4.5%, 5%, 5.5%, 6%, 1.44%, 1.89%, 2.18%, 2.34%, 2.36%, 3.23%, 4.47%, 4.57%, 4.59%, 4.61%, or 4.66%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of ZrO₂ can be 3%, 3.5%, 4%, 4.5%, 5%, 5.5%, 6%, 6.5%, 7%, 7.5%, 8%, 8.5%, 9%, 9.5%, 10%, 10.5%, 11%, 11.5%, 12%, 7.07%, 3.26%, 4.24%, 4.85%, 5.40%, 5.20%, 7.16%, 10.15%, 10.12%, 9.73%, 10.07%, 9.52%, 9.80%, or 9.88%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, Li₂O, as an essential component, is a network modifying oxide for glass formation. It can not only optimize the viscosity of the glass and promote the melting and fining of the glass melt, but it is also one of the main components for forming lithium disilicate crystals. At the same time, Li₂O provides lithium ions for ion exchange with larger ions in the molten salt bath and is a major factor affecting the achievable stress level of the chemically strengthened glass-ceramic. However, an excessive amount of Li₂O may cause the crystallization process of the glass to become less stable, even precipitating other undesirable crystalline phases, deteriorating the optical performance of the glass-ceramic. Therefore, to obtain a glass-ceramic or chemically strengthened glass-ceramic that satisfies the desired crystalline phase structure, optical performance, and mechanical strength performance, in the composition of the base glass, or the composition of the glass-ceramic, or the composition at the center or of the tensile stress layer of the chemically strengthened glass-ceramic, the mole percentage content of Li₂O is 24% to 32%, or the mass percentage content of Li₂O is 11% to 20%.

In some embodiments, in the composition of the base glass, or the composition of the glass-ceramic, or the composition at the center or of the tensile stress layer of the chemically strengthened glass-ceramic, the mole percentage of Li₂O can be 24%, 24.5%, 25%, 25.5%, 26%, 26.5%, 27%, 27.5%, 28%, 28.5%, 29%, 29.5%, 30%, 30.5%, 31%, 31.5%, 32%, 27.54%, 29.25%, 29.38%, 29.52%, 29.8%, 30.22%, 30.4%, 30.44%, 30.81%, or 31.51%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of Li₂O can be 11%, 11.5%, 12%, 12.5%, 13%, 13.5%, 14%, 14.5%, 15%, 15.5%, 16%, 16.5%, 17%, 17.5%, 18%, 18.5%, 19%, 19.5%, 20%, 16.15%, 16.70%, 16.44%, 14.85%, 17.50%, 16.61%, 16.35%, 15.73%, 15.71%, 15.10%, 15.63%, 15.11%, or 15.21%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, Na₂O, as an optional component, is a network-modifying oxide. An appropriate amount of Na₂O can provide free oxygen, optimize the viscosity of the glass, promote the melting and fining of the glass melt, and also regulate the chemical strengthening rate. However, an excessive amount of Na₂O not only reduces the crystallinity of the glass-ceramic but also affects the chemical strengthening effect. Therefore, to ensure that the glass-ceramic or chemically strengthened glass-ceramic satisfies the desired structure and obtains the desired performance, in the composition of the base glass, or the composition of the glass-ceramic, or the composition at the center or of the tensile stress layer of the chemically strengthened glass-ceramic, the mole percentage content of Na₂O is 0% to 4%, or the mass percentage content of Na₂O is 0% to 4%.

In some embodiments, in the composition of the base glass, or the composition of the glass-ceramic, or the composition at the center or of the tensile stress layer of the chemically strengthened glass-ceramic, the mole percentage of Na₂O can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, or 4%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of Na₂O can be 0%, 0.1%, 0.2%, 0.3%, 0.34%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, or 4%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, K₂O is a glass network modifying oxide and is one of the optional components. An appropriate amount of K₂O can provide free oxygen and increase the oxygen-to-silicon ratio in the glass structure. However, an excessive amount of K₂O affects the network structure of the glass, impacting the optical performance, thermal stability, chemical stability, mechanical strength, and weather resistance of the glass. Therefore, to ensure that the glass-ceramic or chemically strengthened glass-ceramic satisfies the desired structure and obtains the desired performance, in the composition of the base glass, or the composition of the glass-ceramic, or the composition at the center or of the tensile stress layer of the chemically strengthened glass-ceramic, the mole percentage content of K₂O is 0% to 2%, or the mass percentage content of K₂O is 0% to 2%.

In some embodiments, in the composition of the base glass, or the composition of the glass-ceramic, or the composition at the center or of the tensile stress layer of the chemically strengthened glass-ceramic, the mole percentage of K₂O can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, or 2%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of K₂O can be 0%, 0.1%, 0.2%, 0.3%, 0.4%, 0.46%, 0.5%, 0.6%, 0.7%, 0.78%, 0.8%, 0.9%, 1%, 1.1%, 1.2%, 1.3%, 1.4%, 1.5%, 1.6%, 1.7%, 1.8%, 1.9%, or 2%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, CaO is an optional component as a network modifying oxide for glass formation. An appropriate amount of CaO helps to reduce the high-temperature viscosity of the glass and increase the density of the glass. However, an excessive amount of CaO makes the working properties of the glass shorter and increases brittleness. Therefore, to obtain a glass-ceramic or chemically strengthened glass-ceramic that satisfies the desired optical performance and mechanical strength performance, in the composition of the base glass, or the composition of the glass-ceramic, or the composition at the center or of the tensile stress layer of the chemically strengthened glass-ceramic, the mole percentage content of CaO is 0% to 5%, or the mass percentage content of CaO is 0% to 5%.

In some embodiments, in the composition of the base glass, or the composition of the glass-ceramic, or the composition at the center or of the tensile stress layer of the chemically strengthened glass-ceramic, the mole percentage of CaO can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 2%, 2.5%, 3%, 3.5%, 4%, 4.5%, 5%, 0.92%, or 2.67%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of CaO can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 2%, 2.5%, 3%, 3.5%, 4%, 4.5%, 5%, 0.92%, or 2.7%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, BaO is an optional component and is an alkaline earth metal oxide. An appropriate amount of BaO can help to adjust the composition of the glass phase in the glass-ceramic, helping to increase the density of the glass-ceramic and its Young's modulus. However, an excessive amount of BaO deteriorates the optical performance of the glass-ceramic. Therefore, to obtain a glass-ceramic or chemically strengthened glass-ceramic that satisfies the desired optical performance and mechanical strength performance, in the composition of the base glass, or the composition of the glass-ceramic, or the composition at the center or of the tensile stress layer of the chemically strengthened glass-ceramic, the mole percentage content of BaO is 0% to 3%, or the mass percentage content of BaO is 0% to 6%.

In some embodiments, in the composition of the base glass, or the composition of the glass-ceramic, or the composition at the center or of the tensile stress layer of the chemically strengthened glass-ceramic, the mole percentage of BaO can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 2%, 2.5%, 3%, 0.91%, 1.38%, or 1.83%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of BaO can be 0%, 0.5%, 1%, 1.5%, 2%, 2.5%, 3%, 3.5%, 4%, 4.5%, 5%, 5.5%, 6%, 3.76%, 4.85%, or 2.43%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, SrO is an optional component and is an alkaline earth metal oxide. An appropriate amount of SrO can help to adjust the composition of the glass phase in the glass-ceramic, helping to increase the density of the glass-ceramic and its Young's modulus. It also helps to lower the thermal expansion softening point of the glass-ceramic, which is beneficial for hot bending the glass-ceramic into 3D curved glass-ceramic. However, an excessive amount of SrO deteriorates the optical performance of the glass-ceramic. Therefore, to obtain a glass-ceramic or chemically strengthened glass-ceramic that satisfies the desired optical performance and mechanical strength performance, in the composition of the base glass, or the composition of the glass-ceramic, or the composition at the center or of the tensile stress layer of the chemically strengthened glass-ceramic, the mole percentage content of SrO is 0% to 3%, or the mass percentage content of SrO is 0% to 6%.

In some embodiments, in the composition of the base glass, or the composition of the glass-ceramic, or the composition at the center or of the tensile stress layer of the chemically strengthened glass-ceramic, the mole percentage of SrO can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 2%, 2.5%, 3%, 0.91%, 0.92%, 1.38%, 1.42%, or 1.83%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of SrO can be 0%, 0.5%, 1%, 1.5%, 2%, 2.5%, 3%, 3.5%, 4%, 4.5%, 5%, 5.5%, 6%, 2.68%, 2.57%, 1.64%, or 3.33%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, MgO is an optional component. An appropriate amount of MgO can help to adjust the composition of the glass phase in the glass-ceramic. However, an excessive amount of MgO affects crystal growth and the crystalline phase structure of the glass-ceramic. Therefore, to obtain a glass-ceramic or chemically strengthened glass-ceramic that satisfies the desired optical performance and mechanical strength performance, in the composition of the base glass, or the composition of the glass-ceramic, or the composition at the center or of the tensile stress layer of the chemically strengthened glass-ceramic, the mole percentage content of MgO is 0% to 3%, or the mass percentage content of MgO is 0% to 3%.

In some embodiments, in the composition of the base glass, or the composition of the glass-ceramic, or the composition at the center or of the tensile stress layer of the chemically strengthened glass-ceramic, the mole percentage of MgO can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 2%, 2.5%, 3%, or 1.83%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of MgO can be 0%, 0.1%, 0.15%, 0.2%, 0.3%, 0.4%, 0.5%, 0.6%, 0.7%, 0.8%, 0.9%, 1%, 1.1%, 1.2%, 1.3%, 1.4%, 1.5%, 2%, 2.5%, 3%, or 1.32%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, ZnO is a network intermediate and is one of the optional components. An appropriate amount of ZnO can combine with free oxygen, regulate the glass structure, and remain in the glass phase of the glass-ceramic, increasing the glass viscosity. However, an excessive amount of ZnO affects crystal growth and the crystalline phase structure of the glass-ceramic. Therefore, to obtain a glass-ceramic or chemically strengthened glass-ceramic that satisfies the desired optical performance and mechanical strength performance, in the composition of the base glass, or the composition of the glass-ceramic, or the composition at the center or of the tensile stress layer of the chemically strengthened glass-ceramic, the mole percentage content of ZnO is 0% to 3%, or the mass percentage content of ZnO is 0% to 3%.

In some embodiments, in the composition of the base glass, or the composition of the glass-ceramic, or the composition at the center or of the tensile stress layer of the chemically strengthened glass-ceramic, the mole percentage of ZnO can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 2%, 2.5%, 3%, 0.54%, or 1.67%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of ZnO can be 0%, 0.1%, 0.2%, 0.3%, 0.4%, 0.5%, 0.6%, 0.7%, 0.8%, 0.81%, 0.9%, 1%, 1.1%, 1.2%, 1.3%, 1.4%, 1.5%, 2%, 2.5%, 3%, 0.54%, or 2.45%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, B₂O₃ is an optional component. An appropriate amount of B₂O₃ can be used as a fluxing agent and/or a softening agent, helping to improve the forming and hot bending effects of the glass. However, an excessive amount of B₂O₃ makes the crystallization process uncontrollable, leading to poor optical performance of the glass-ceramic. Therefore, to obtain a glass-ceramic or chemically strengthened glass-ceramic that satisfies the desired optical performance and mechanical strength performance, in the composition of the base glass, or the composition of the glass-ceramic, or the composition at the center or of the tensile stress layer of the chemically strengthened glass-ceramic, the mole percentage content of B₂O₃ is 0% to 1%, or the mass percentage content of B₂O₃ is 0% to 1%.

In some embodiments, in the composition of the base glass, or the composition of the glass-ceramic, or the composition at the center or of the tensile stress layer of the chemically strengthened glass-ceramic, the mole percentage of B₂O₃ can be 0%, 0.1%, 0.2%, 0.3%, 0.4%, 0.5%, 0.6%, 0.7%, 0.8%, 0.9%, 1%, or 0.46%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of B₂O₃ can be 0%, 0.1%, 0.2%, 0.3%, 0.4%, 0.5%, 0.6%, 0.7%, 0.8%, 0.9%, 1%, or 0.55%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, the selective addition of appropriate amounts of Y₂O₃, La₂O₃, Ta₂O₅, or Yb₂O₃ helps to increase the density of the glass-ceramic and its Young's modulus. However, it may increase the refractive index of the glass-ceramic, reducing its optical performance. Therefore, to obtain a glass-ceramic or chemically strengthened glass-ceramic that satisfies the desired optical performance and mechanical strength performance, in the composition of the base glass, or the composition of the glass-ceramic, or the composition at the center or of the tensile stress layer of the chemically strengthened glass-ceramic, the mole percentage content of Y₂O₃ is 0% to 1%, and/or the mole percentage content of La₂O₃ is 0% to 1%, and/or the mole percentage content of Ta₂O₅ is 0% to 1%, and/or the mole percentage content of Yb₂O₃ is 0% to 1%, or the mass percentage content of Y₂O₃ is 0% to 2%, and/or the mass percentage content of La₂O₃ is 0% to 2%, and/or the mass percentage content of Ta₂O₅ is 0% to 2%, and/or the mass percentage content of Yb₂O₃ is 0% to 4%.

In some embodiments, in the composition of the base glass, or the composition of the glass-ceramic, or the composition at the center or of the tensile stress layer of the chemically strengthened glass-ceramic, the mole percentage of Y₂O₃ can be 0%, 0.1%, 0.2%, 0.3%, 0.4%, 0.5%, 0.6%, 0.7%, 0.8%, 0.9%, or 1%, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, based on mole percentage of oxides, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of Y₂O₃ can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, or 0.83%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mole percentage of La₂O₃ can be 0%, 0.1%, 0.2%, 0.3%, 0.4%, 0.5%, 0.6%, 0.7%, 0.8%, 0.9%, or 1%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of La₂O₃ can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, or 1.18%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mole percentage of Ta₂O₅ can be 0%, 0.1%, 0.2%, 0.3%, 0.4%, 0.5%, 0.6%, 0.7%, 0.8%, 0.9%, 0.46%, or 1%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of Ta₂O₅ can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, or 1.44%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mole percentage of Yb₂O₃ can be 0%, 0.1%, 0.2%, 0.3%, 0.4%, 0.5%, 0.6%, 0.7%, 0.8%, 0.9%, 0.46%, or 1%, or can be a numerical value within a numerical range formed with any two of the above specific values as endpoints, based on mole percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments, in the composition of the base glass, or the composition of the glass-ceramic, or the composition at the center or of the tensile stress layer of the chemically strengthened glass-ceramic, the mass percentage of Yb₂O₃ can be 0%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.5%, 3%, 3.5%, 4%, or 3.12%, or can be a numerical value within a numerical range formed with any two of the above specific values as endpoints, based on mass percentage of oxides, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the chemically strengthened glass-ceramic satisfies: 2.00 ≤ n(SiO₂)/n(Li₂O) ≤ 2.40, preferably 2.00 ≤ n(SiO₂)/n(Li₂O) ≤ 2.30, more preferably 2.02 ≤ n(SiO₂)/n(Li₂O) ≤ 2.20, wherein n(SiO₂) and n(Li₂O) are mole percentage contents of SiO₂ and Li₂O at the center or in the tensile stress layer of the chemically strengthened glass-ceramic, respectively.

It should be noted that, in the present disclosure, the content relationship formulas for the various oxides are calculated by substituting the content percentages based on mole of oxides, wherein only numerical values are used in the calculation, with mole units being disregarded. By adjusting the contents of the various oxides to satisfy specific content relationships, it is advantageous for obtaining the glass-ceramic or chemically strengthened glass-ceramic that satisfies the desired mechanical strength performance.

In some embodiments, the value of n(SiO₂)/n(Li₂O) can be 2, 2.1, 2.2, 2.3, 2.4, 2.01, 2.03, 2.07, 2.08, 2.09, 2.10, or 2.28, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the chemically strengthened glass-ceramic satisfies: 90% ≤ n(SiO₂) + n(Li₂O) ≤ 96%, preferably 90% ≤ n(SiO₂) + n(Li₂O) ≤ 95%, wherein n(SiO₂) and n(Li₂O) are mole percentage contents of SiO₂ and Li₂O at the center or in the tensile stress layer of the chemically strengthened glass-ceramic, respectively.

In some embodiments, the value of n(SiO₂) + n(Li₂O) can be 90%, 91%, 92%, 93%, 94%, 95%, 96%, 90.17%, 90.19%, 90.31%, 90.4%, 90.41%, 90.81%, 91.24%, 91.62%, 92.16%, 93.38%, 93.39%, 94.26%, or 94.9%, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the chemically strengthened glass-ceramic satisfies: 20% ≤ 2.25 × n(Li₂O) - 8 × n(ZrO₂) - 0.2 × n(CaO) ≤ 60%, preferably 25% ≤ 2.25 × n(Li₂O) - 8 × n(ZrO₂) - 0.2 × n(CaO) ≤ 60%, wherein n(Li₂O), n(ZrO₂), and n(CaO) are mole percentage contents of Li₂O, ZrO₂, and CaO at the center or in the tensile stress layer of the chemically strengthened glass-ceramic, respectively.

In some embodiments, the value of 2.25 × n(Li₂O) - 8 × n(ZrO₂) - 0.2 × n(CaO) can be 20%, 25%, 30%, 35%, 40%, 45%, 50%, 55%, 60%, 29.39%, 29.77%, 30.05%, 42.65%, 43.99%, 50.6%, 52.02%, 52.88%, or 56.88%, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the chemically strengthened glass-ceramic satisfies: 0% ≤ n(Y₂O₃) + n(La₂O₃) + n(Ta₂O₅) + n(Yb₂O₃) ≤ 1%, preferably 0% ≤ n(Y₂O₃) + n(La₂O₃) + n(Ta₂O₅) + n(Yb₂O₃) ≤ 0.7%, wherein n(Y₂O₃), n(La₂O₃), n(Ta₂O₅), and n(Yb₂O₃) are mole percentage contents of Y₂O₃, La₂O₃, Ta₂O₅, and Yb₂O₃ at the center or in the tensile stress layer of the chemically strengthened glass-ceramic, respectively.

In some embodiments, the value of n(Y₂O₃) + n(La₂O₃) + n(Ta₂O₅) + n(Yb₂O₃) can be 0%, 0.1%, 0.2%, 0.3%, 0.4%, 0.5%, 0.6%, 0.7%, 0.8%, 0.9%, 1%, or 0.46%, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the chemically strengthened glass-ceramic satisfies: 0% ≤ n(SrO) + n(BaO) + n(CaO) + n(MgO) ≤ 3%, preferably 0% ≤ n(SrO) + n(BaO) + n(CaO) + n(MgO) ≤ 2.7%, wherein n(SrO), n(BaO), n(CaO), and n(MgO) are mole percentage contents of SrO, BaO, CaO, and MgO at the center or in the tensile stress layer of the chemically strengthened glass-ceramic, respectively.

In some embodiments, the value of n(SrO) + n(BaO) + n(CaO) + n(MgO) can be 0%, 0.5%, 1%, 1.5%, 2%, 2.5%, 3%, 0.2%, 0.92%, 1.38%, 1.42%, 1.83%, or 2.67%, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the chemically strengthened glass-ceramic satisfies: 0 ≤ n(SrO)/[n(SrO) + n(BaO) + n(CaO) + n(MgO)] ≤ 1, wherein n(SrO), n(BaO), n(CaO), and n(MgO) are mole percentage contents of SrO, BaO, CaO, and MgO at the center or in the tensile stress layer of the chemically strengthened glass-ceramic, respectively.

In some embodiments, the value of n(SrO)/[n(SrO) + n(BaO) + n(CaO) + n(MgO)] can be 0, 0.1, 0.2, 0.3, 0.4, 0.5, 0.6, 0.7, 0.8, 0.9, or 1, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, "having the lithium disilicate crystalline phase as the main crystalline phase" or similar expressions means that the mass of the lithium disilicate crystalline phase accounts for greater than 80 mass percentage (mass% or wt%) of all crystalline phases in the glass-ceramic used to prepare the chemically strengthened glass-ceramic or in the chemically strengthened glass-ceramic according to the embodiments of the present disclosure. Optionally, in the glass-ceramic used to prepare the chemically strengthened glass-ceramic or in the chemically strengthened glass-ceramic, the mass of the lithium disilicate crystalline phase accounts for 80 wt% to 100 wt% of all crystalline phases; preferably, in the glass-ceramic used to prepare the chemically strengthened glass-ceramic or in the chemically strengthened glass-ceramic, the mass of the lithium disilicate crystalline phase accounts for 85 wt% to 100 wt% of all crystalline phases. In some embodiments, in all crystalline phases of the glass-ceramic used to prepare the chemically strengthened glass-ceramic or of the chemically strengthened glass-ceramic, the mass of the lithium disilicate crystalline phase can account for 80 wt%, 80.5 wt%, 81 wt%, 81.5 wt%, 82 wt%, 82.5 wt%, 83 wt%, 83.5 wt%, 84 wt%, 84.5 wt%, 85 wt%, 85.5 wt%, 86 wt%, 86.5 wt%, 87 wt%, 87.5 wt%, 88 wt%, 88.5 wt%, 89 wt%, 89.5 wt%, 90 wt%, 95 wt%, or 100 wt%, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In the present disclosure, after the glass-ceramic used to prepare the chemically strengthened glass-ceramic undergoes the chemical strengthening treatment to obtain the chemically strengthened glass-ceramic, its crystallinity does not change significantly, i.e., the crystallinity of the glass-ceramic is similar to or substantially the same as the crystallinity of the chemically strengthened glass-ceramic.

In some embodiments of the present disclosure, the crystallinity of the glass-ceramic used to prepare the chemically strengthened glass-ceramic or of the chemically strengthened glass-ceramic is not less than 65%, preferably, the crystallinity is not less than 70%, preferably, the crystallinity of the glass-ceramic or chemically strengthened glass-ceramic is 70% to 90%, more preferably, the crystallinity of the glass-ceramic or chemically strengthened glass-ceramic is 70% to 87%. The higher the crystallinity of the glass-ceramic used to prepare the chemically strengthened glass-ceramic or of the chemically strengthened glass-ceramic, the more advantageous it is for it to obtain high mechanical strength performance and high damage resistance performance. However, if the crystallinity is too high, it easily affects the chemical strengthening effect of the glass-ceramic, leading to an extension of the chemical strengthening time required to prepare a chemically strengthened glass-ceramic with a high stress level, and also easily affects the optical performance of the glass-ceramic. In the present disclosure, by having the glass-ceramic satisfy the desired crystallinity, it is advantageous for the chemically strengthened glass-ceramic prepared therefrom to also satisfy the desired crystallinity, and more advantageous for preparing a chemically strengthened glass-ceramic that satisfies the desired high mechanical strength performance, high damage resistance performance, and excellent optical performance.

In some embodiments, the crystallinity of the glass-ceramic used to prepare the chemically strengthened glass-ceramic or of the chemically strengthened glass-ceramic can be 65%, 70%, 72%, 74%, 76%, 78%, 80%, 81%, 82%, 83%, 84%, 85%, 86%, 87%, 88%, 89%, 90%, 79.85%, 79.85%, 79.85%, 79.85%, 79.85%, 79.85%, 79.85%, 86.82%, 84.25%, 76.8%, 80.4%, 79.65%, 80.42%, 76.7%, 76.6%, 76.6%, 73.64%, 74.85%, 70.69%, 71.95%, or 70.4%, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the average grain size in the glass-ceramic used to prepare the chemically strengthened glass-ceramic or in the chemically strengthened glass-ceramic is not greater than 100 nm, preferably, the average grain size is not greater than 50 nm, more preferably, the average grain size is 15 nm to 30 nm. An appropriate average grain size allows the glass-ceramic to have both excellent optical performance and high intrinsic strength. If the average grain size is too high, the glass-ceramic is prone to devitrification. In the present disclosure, by having the glass-ceramic or chemically strengthened glass-ceramic satisfy an appropriate average grain size, it is advantageous for ensuring that the glass-ceramic or chemically strengthened glass-ceramic achieves excellent mechanical strength performance and excellent optical performance.

In some embodiments, the average grain size of the glass-ceramic used to prepare the chemically strengthened glass-ceramic or of the chemically strengthened glass-ceramic can be 100 nm, 50 nm, 40 nm, 35 nm, 30 nm, 25 nm, 20 nm, 15 nm, 10 nm, 23.7 nm, 26.8 nm, 23.2 nm, 19.6 nm, 19.5 nm, 24.5 nm, 24.2 nm, 22.8 nm, 23 nm, 24.6 nm, 24.8 nm, 26 nm, 25.5 nm, or 25.6 nm, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, non-limiting examples of other possible crystalline phases in the glass-ceramic used to prepare the chemically strengthened glass-ceramic or in the chemically strengthened glass-ceramic include: a petalite crystalline phase, and/or, a lithium phosphate crystalline phase. In some embodiments, the mass percentage of the petalite crystalline phase contained in the glass-ceramic or chemically strengthened glass-ceramic is less than or equal to 10%, preferably, the petalite crystalline phase accounts for less than or equal to 5% by mass of the glass-ceramic or chemically strengthened glass-ceramic, more preferably, the glass-ceramic or chemically strengthened glass-ceramic is free of a petalite crystalline phase. By controlling the precipitation of other crystalline phases (e.g., the petalite crystalline phase), it is more advantageous for ensuring that the lithium disilicate crystalline phase forms the desired microstructure, thereby ensuring that the glass-ceramic or chemically strengthened glass-ceramic obtains high mechanical strength performance, excellent optical performance, and excellent damage resistance ability.

In some embodiments of the present disclosure, when the thickness is not greater than 0.7 mm, the b value of the glass-ceramic used to prepare the chemically strengthened glass-ceramic or of the chemically strengthened glass-ceramic is < 1.0, preferably, the b value is < 0.80, more preferably, the b value is ≤ 0.60. It should be understood that in the present disclosure, after the glass-ceramic undergoes the chemical strengthening treatment to obtain the chemically strengthened glass-ceramic, its optical performance do not change significantly, i.e., the b value, transmittance, etc. of the glass-ceramic are similar to or substantially the same as those of the chemically strengthened glass-ceramic. In the present disclosure, the b value refers to the optical b value measured under a D65 light source. The present disclosure uses a Konica Minolta CM-3600A to test the b value in transmittance mode, and the result shows b(D65). The smaller the b value, the more it ensures that the glass-ceramic achieves a better display effect. When the b value is too large, the glass-ceramic exhibits an undesirable color, making its display effect unable to meet the application requirements for a display screen cover glass.

In some embodiments, the b value of the glass-ceramic used to prepare the chemically strengthened glass-ceramic or of the chemically strengthened glass-ceramic can be 1.0, 0.8, 0.9, 0.70, 0.65, 0.60, 0.55, 0.50, 0.45, 0.40, 0.35, 0.30, 0.25, 0.20, 0.39, 0.32, 0.49, 0.41, 0.56, 0.41, 0.47, 0.51, or 0.52, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the glass-ceramic used to prepare the chemically strengthened glass-ceramic or the chemically strengthened glass-ceramic is transparent within the visible light wavelength range. Preferably, for light with a wavelength of 550 nm, the transmittance of the glass-ceramic or chemically strengthened glass-ceramic is ≥ 85%, preferably, the transmittance is ≥ 90%, more preferably, the transmittance is ≥ 90.27%. The glass-ceramic or chemically strengthened glass-ceramic satisfying this transmittance can ensure good light transmittance and good transparency effect, making it suitable for use in display screens where display effect is required. Here, the "visible light wavelength range" refers to light with a wavelength of 360 nm to 740 nm.

In some embodiments, for light with a wavelength of 550 nm, the transmittance of the glass-ceramic used to prepare the chemically strengthened glass-ceramic or of the chemically strengthened glass-ceramic can be 85%, 90%, 91%, 92%, 90.76%, 90.76%, 90.76%, 90.76%, 90.76%, 90.76%, 90.76%, 90.31%, 90.59%, 91%, 90.94%, 90.63%, 90.65%, 90.4%, 90.46%, 90.46%, 90.29%, 90.37%, 90.27%, 90.3%, or 90.35%, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the Young's modulus of the glass-ceramic used to prepare the chemically strengthened glass-ceramic or of the chemically strengthened glass-ceramic is greater than 100 GPa, preferably, the Young's modulus is greater than 105 GPa, more preferably, the Young's modulus is 110 GPa to 130 GPa. It should be understood that in the present disclosure, after the glass-ceramic undergoes the chemical strengthening treatment to obtain the chemically strengthened glass-ceramic, its Young's modulus does not decrease, i.e., when the Young's modulus of the glass-ceramic is greater than 100 GPa, the Young's modulus of the resulting chemically strengthened glass-ceramic should also be greater than 100 GPa. A relatively high Young's modulus helps to ensure that the chemically strengthened glass-ceramic has high mechanical strength performance and high damage resistance performance.

In some embodiments, the Young's modulus of the glass-ceramic used to prepare the chemically strengthened glass-ceramic or of the chemically strengthened glass-ceramic can be 100 GPa, 101 GPa, 102 GPa, 103 GPa, 104 GPa, 105 GPa, 106 GPa, 107 GPa, 108 GPa, 109 GPa, 110 GPa, 111 GPa, 112 GPa, 113 GPa, 114 GPa, 115 GPa, 116 GPa, 117 GPa, 118 GPa, 119 GPa, 120 GPa, 125 GPa, 128 GPa, 130 GPa, 118.6 GPa, 116.5 GPa, 116.1 GPa, 115.63 GPa, 116.52 GPa, 117.64 GPa, 118.8 GPa, 117.073 GPa, 114.27 GPa, 114.27 GPa, 113.3 GPa, 114.52 GPa, 120 GPa, 119.3 GPa, or 118.95 GPa, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the density of the glass-ceramic used to prepare the chemically strengthened glass-ceramic or of the chemically strengthened glass-ceramic is 2.51 g/cm³ to 2.65 g/cm³. In some embodiments, the density of the glass-ceramic used to prepare the chemically strengthened glass-ceramic or of the chemically strengthened glass-ceramic can be 2.51 g/cm³, 2.52 g/cm³, 2.53 g/cm³, 2.54 g/cm³, 2.55 g/cm³, 2.56 g/cm³, 2.57 g/cm³, 2.58 g/cm³, 2.59 g/cm³, 2.60 g/cm³, 2.61 g/cm³, 2.62 g/cm³, 2.63 g/cm³, 2.64 g/cm³, or 2.65 g/cm³, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the refractive index of the glass-ceramic used to prepare the chemically strengthened glass-ceramic or of the chemically strengthened glass-ceramic is ≤ 1.60, preferably, the refractive index is 1.54 to 1.60. In some embodiments, the refractive index of the glass-ceramic used to prepare the chemically strengthened glass-ceramic or of the chemically strengthened glass-ceramic can be 1.54, 1.55, 1.56, 1.57, 1.58, 1.59, or 1.60, or can be a numerical value within a numerical range formed with any two of the above specific values as endpoints, as long as the glass-ceramic or chemically strengthened glass-ceramic having the required performance of the present disclosure can be obtained. It should be understood that in specific embodiments, any of the above ranges can be combined with any other ranges, as long as the glass-ceramic or chemically strengthened glass-ceramic having the required performance of the present disclosure can be obtained.

In some embodiments of the present disclosure, the glass-ceramic used to prepare the chemically strengthened glass-ceramic or the chemically strengthened glass-ceramic is 2D, 2.5D, 3D, or irregularly shaped. In some embodiments of the present disclosure, the glass-ceramic used to prepare the chemically strengthened glass-ceramic or the chemically strengthened glass-ceramic has a uniform thickness or a non-uniform thickness. Those skilled in the art can choose according to needs. Here, "non-uniform thickness" means that the glass-ceramic or chemically strengthened glass-ceramic includes at least two portions with different thicknesses.

In some embodiments of the present disclosure, when subjecting the chemically strengthened glass-ceramic to a sandpaper drop resistance test, using an 80-mesh sandpaper, when the thickness is not greater than 0.70 mm, the average sandpaper drop resistance height of the chemically strengthened glass-ceramic is ≥ 1.0 m, preferably, the average sandpaper drop resistance height of the chemically strengthened glass-ceramic is ≥ 1.2 m, more preferably, the average sandpaper drop resistance height of the chemically strengthened glass-ceramic is ≥ 1.6 m. The higher the measured average sandpaper drop resistance height, the better the drop damage resistance performance of the chemically strengthened glass-ceramic.

In some embodiments, when the chemically strengthened glass-ceramic is dropped on 80-mesh sandpaper, the average sandpaper drop resistance height can be 1.0 m, 1.1 m, 1.11 m, 1.12 m, 1.13 m, 1.14 m, 1.15 m, 1.16 m, 1.17 m, 1.18 m, 1.19 m, 1.2 m, 1.25 m, 1.28 m, 1.3 m, 1.35 m, 1.4 m, 1.45 m, 1.5 m, 1.55 m, 1.6 m, 1.65 m, 1.7 m, 1.75 m, 1.8 m, 1.85 m, 1.9 m, 1.95 m, 2.1 m, 2.2 m, 2.3 m, 2.4 m, 2.5 m, or 2 m, or can be a numerical value within a numerical range formed with any two of the above specific values as endpoints, as long as the chemically strengthened glass-ceramic having the required performance of the present disclosure can be obtained. It should be understood that in specific embodiments, any of the above ranges can be combined with any other ranges, as long as the chemically strengthened glass-ceramic having the required performance of the present disclosure can be obtained.

After introducing the composition, crystalline phase structure, stress structure, and the like of the chemically strengthened glass-ceramic above, the preparation method for the chemically strengthened glass-ceramic is described in detail below.

In the present disclosure, the preparation process of the chemically strengthened glass-ceramic mainly comprises: a preparation process of the glass-ceramic and a chemical strengthening treatment process. The preparation process of the glass-ceramic mainly comprises: a preparation process of the base glass and a heat treatment process of the base glass.

In the present disclosure, the base glass can be prepared using a forming method in the prior art, and the present disclosure does not impose any limitation on this. For example, the forming method of the base glass can include, but is not limited to, a float process, an overflow process, a rolling process, or a casting process. Illustratively, the components are mixed uniformly according to the formula, melted and formed, followed by cooling and annealing treatment, to obtain the base glass.

Illustratively, the raw materials (conventional industrial raw materials) are proportioned according to the formula, a clarifying agent is added, and then they are mixed for a period of time to obtain a uniformly mixed raw material mixture. The raw material mixture is placed in a platinum crucible, a platinum-rhodium crucible, or a melting furnace, heated to 1450°C to 1700°C, preferably held at the melting temperature for 5 hours or more, then poured into a forming mold and cooled for forming, preferably cooled to about 900°C, then placed in an annealing furnace for annealing treatment, preferably at an annealing temperature of 450°C to 650°C, preferably for an annealing time of 10 to 48 hours, and then cooled to room temperature with the furnace to obtain the base glass. Those skilled in the art can select the type and amount of clarifying agent according to needs without any creative effort. Further, the clarifying agent can include, but is not limited to, one or more selected from the group consisting of sodium chloride, tin oxide, antimony oxide, and arsenic oxide, and the amount of clarifying agent added can be 0 wt% to 1 wt% of the total amount of the raw materials.

In some embodiments of the present disclosure, the heat treatment process of the base glass can comprise a nucleation treatment and/or a crystallization treatment, preferably a nucleation treatment and a crystallization treatment are used. In some embodiments, the crystallization treatment comprises a one-step crystallization treatment or a two-step crystallization treatment. In some embodiments, to prepare a curved glass-ceramic, the two-step crystallization treatment may be selected. When a two-step crystallization treatment is used, the second step of the crystallization treatment involves heating the crystallized glass raw material obtained from the first step of the crystallization treatment to a hot pressing temperature, while simultaneously performing a 3D hot bending forming treatment and the second step of the crystallization treatment. Here, the "crystallized glass raw material" refers to a glass material that has a certain degree of crystallinity but has not yet reached the crystallinity requirement of the final sample.

In some embodiments of the present disclosure, to obtain the desired physicochemical properties for the glass-ceramic, the heat treatment of the base glass can be a one-step heat treatment or a two-step or multi-step heat treatment. If a one-step heat treatment is used, it means that a nucleation treatment (treatment of nucleation) is not performed separately, and a one-step temperature increase is performed directly, allowing nucleation and crystal growth to occur at the temperature reached during the one-step temperature increase. This can be understood as directly performing a crystallization treatment. If a two-step heat treatment is used, it means that a two-step temperature increase process is performed, including but not limited to the following approach: a first step of nucleation treatment, and a second step of crystallization treatment.

In some embodiments of the present disclosure, to precipitate the desired target crystalline phases in the glass-ceramic and obtain the desired physicochemical properties, the base glass is sequentially subjected to nucleation treatment and crystallization treatment. Further, during the nucleation treatment, the nucleation temperature can be 500 °C to 700°C, and the nucleation time can be 10 min to 1440 min; during the crystallization treatment, the crystallization temperature can be 600 °C to 800°C, and the crystallization time can be 5 min to 1440 min. During the heat treatment process including the nucleation treatment and the crystallization treatment, it is preferred to control the heating rate to be 5°C/min to 20°C/min, more preferably a heating rate of 10°C/min, and the cooling rate can be 0.1°C/min to 3°C/min.

In the present disclosure, after the heat treatment, those skilled in the art may further perform other conventional steps to obtain a glass-ceramic sample that satisfies the desired specifications or requirements, for example, shaping treatment, cutting treatment (e.g., using a multi-wire saw), CNC machining (computer numerical control), thinning treatment, polishing treatment, and the like.

In some embodiments of the present disclosure, by subjecting the aforementioned glass-ceramic to a specific chemical strengthening treatment, a chemically strengthened glass-ceramic that satisfies the desired performance can be prepared.

In some embodiments of the present disclosure, it further comprises a step of polishing and thinning the prepared chemically strengthened glass-ceramic.

In the present disclosure, the chemical strengthening treatment, i.e., the ion exchange method, involves immersing the glass-ceramic in a molten salt bath, so that alkali metal ions with smaller ionic radii in the glass-ceramic exchange with alkali metal ions with larger ionic radii in the molten salt bath, thereby forming a compressive stress layer on the surface of the glass-ceramic and forming the tensile stress layer inside the glass-ceramic, resulting in a chemically strengthened glass-ceramic with improved mechanical properties.

In some embodiments of the present disclosure, the chemical strengthening treatment can use a one-step strengthening method or a multi-step strengthening method. The molten salt bath used for the chemical strengthening treatment is a molten salt bath containing a sodium salt and/or a potassium salt. Preferably, the molten salt bath of the present disclosure is a mixed molten salt bath containing a sodium salt and a potassium salt. Preferably, the temperature of the molten salt bath is 380°C to 600°C, preferably 430°C to 550°C. In some embodiments of the present disclosure, preferably, the concentration of the potassium salt in the salt bath is 0 wt% to 95 wt%, and the concentration of the sodium salt is 5 wt% to 100 wt%. More preferably, a given amount (e.g., 0.01 wt% to 0.3 wt%) of a lithium salt is added to the salt bath. In some embodiments of the present disclosure, preferably, the chemical strengthening treatment time is 0.1 h to 24 h. The sodium salt can be at least one selected from the group consisting of sodium nitrate, sodium sulfate, and sodium carbonate, preferably sodium nitrate; the potassium salt can be at least one selected from the group consisting of potassium nitrate, potassium sulfate, and potassium carbonate, preferably potassium nitrate; the lithium salt can be at least one selected from the group consisting of lithium nitrate, lithium sulfate, and lithium carbonate, preferably lithium nitrate.

In the present disclosure, the stress distribution structure of the chemically strengthened glass-ceramic is closely related to the glass-ceramic composition (including oxide composition, crystalline phase composition), the salt bath composition, the salt bath temperature, and the chemical strengthening treatment time. Only when a glass-ceramic of a specific composition is subjected to a chemical strengthening treatment for an appropriate time in an appropriate salt bath (with an appropriate composition and at an appropriate temperature) can the prepared chemically strengthened glass-ceramic obtain a specific stress distribution structure, thereby achieving the excellent effects desired by the present disclosure.

The chemically strengthened glass-ceramic with excellent performance provided by the present disclosure can be used in electronic devices, including but not limited to mobile phones, tablet computers, handheld game consoles, portable digital devices (e.g., digital cameras), vehicle-mounted central control systems, electronic whiteboard glass, smart homes, smart wearables (e.g., smart bracelets, smart watches, smart glasses), and can further be used in vehicles, aircraft, or watercraft, and can further be used in any glass device requiring a chemically strengthened glass-ceramic. For example, it can be used for display screens, cover glasses, touch screens, inner glass screens, or inner frames of electronic devices; for example, it can be used for windshields of vehicles, aircraft, or watercraft, such as front windshields or side windshields. For example, it can be used for work surfaces, other surfaces, appliance doors, floor tiles, wall panels, or storage containers. Other surfaces can include, but are not limited to, exterior wall surfaces, stair tread surfaces, column facing surfaces, or counter surfaces. Storage containers can include, but are not limited to, cups, plates, medicine bottles, or beverage bottles.

Illustratively, the chemically strengthened glass-ceramic with excellent performance provided by the present disclosure can be used to manufacture glass devices. The glass device referred to here can be regular or irregular, and those skilled in the art can manufacture according to needs.

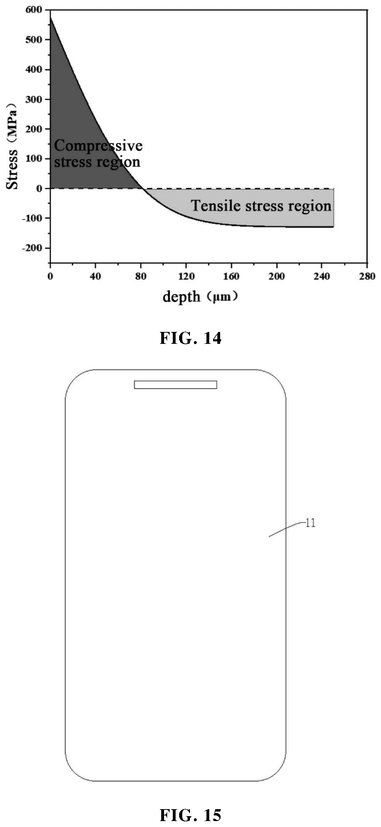

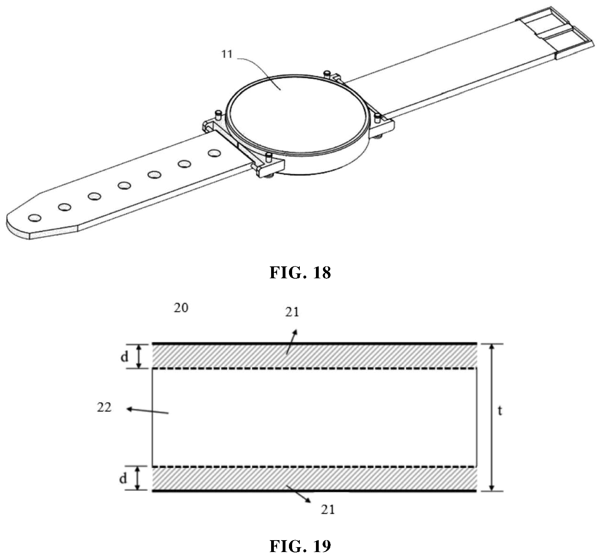

Illustratively, the chemically strengthened glass-ceramic with excellent performance provided by the present disclosure can be used to manufacture a cover glass. The cover glass can be a display screen cover plate, a back cover, or a camera protection cover plate for an electronic device. Illustratively, the chemically strengthened glass-ceramic with excellent performance provided by the present disclosure can be used in an electronic device. Referring to FIG. 15, FIG. 16, FIG. 17, and FIG. 18, an embodiment of the present disclosure provides an electronic device. The electronic device can be a mobile phone, a tablet computer, a smart wearable device, or other electronic products. The electronic device comprises a housing 1 assembled on the outside of the electronic device, and components such as a circuit board and a battery located inside the housing 1. The housing 1 comprises a display screen cover plate 11 assembled on the front side and a back cover 12 assembled on the rear side. The display screen cover plate 11 is disposed over a display module 4. The display screen cover plate 11 and/or the back cover 12 can be made of the aforementioned chemically strengthened glass-ceramic. In the embodiments of the present disclosure, the display screen cover plate 11 and the back cover 12 may entirely use the aforementioned chemically strengthened glass-ceramic, or only locally use the aforementioned chemically strengthened glass-ceramic. In the embodiments of the present disclosure, the display screen can be a touch display screen, and the display screen cover plate 11 can be a protective cover plate disposed on the touch display. In the embodiments of the present disclosure, the back cover 12 may cover only the rear side of the electronic device (i.e., the side away from the display), or may cover both the rear side and the side frame of the electronic device. In some embodiments of the present disclosure, the back cover 12 may cover all side frames around the electronic device, or may cover only part of the side frames.

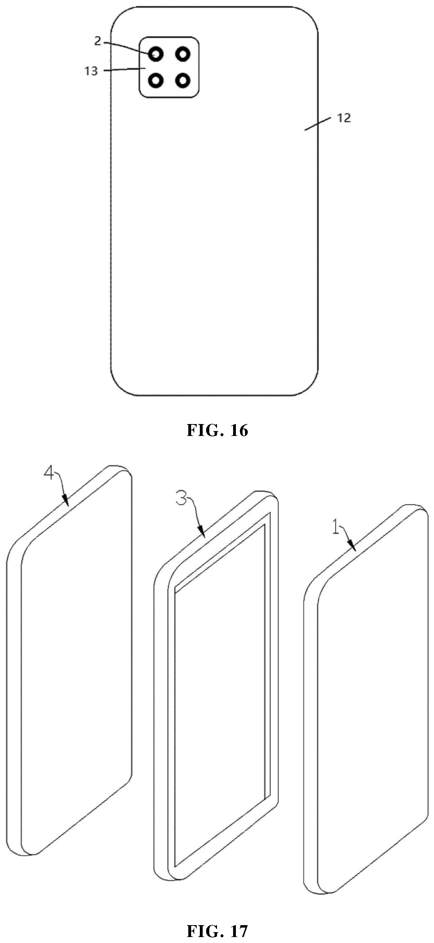

In some embodiments of the present disclosure, as shown in FIG. 16, the electronic device further comprises a camera assembly 2 located inside the housing 1. The housing 1 may comprise a camera protection cover plate 13. The camera protection cover plate 13 is disposed over the camera assembly 2 to protect the camera assembly 2. The camera protection cover plate 13 can use the aforementioned chemically strengthened glass-ceramic. In the embodiments of the present disclosure, the camera protection cover plate 13 may partially use the aforementioned chemically strengthened glass-ceramic, or entirely use the aforementioned chemically strengthened glass-ceramic. In the embodiments of the present disclosure, the position of the camera protection cover plate 13 is determined according to the position of the camera assembly 2. It can be located on the front side of the electronic device or on the rear side of the electronic device. In some embodiments of the present disclosure, the camera protection cover plate 13 may be a separate structure from the display screen cover plate 11 or the back cover 12. In other embodiments of the present disclosure, the camera protection cover plate 13 may also be an integral structure with the display screen cover plate 11 or the back cover 12.

In some embodiments of the present disclosure, as shown in FIG. 17, the electronic device further comprises a middle frame 3 located between the display module 4 and the housing 1. The middle frame 3 may comprise the aforementioned chemically strengthened glass-ceramic.

In the embodiments of the present disclosure, any one of the display screen cover plate, the back cover, the camera protection cover plate, and the middle frame in the electronic device may use the aforementioned chemically strengthened glass-ceramic, or any two of them may use the aforementioned chemically strengthened glass-ceramic, or three of them may use the aforementioned chemically strengthened glass-ceramic, or all four may use the aforementioned chemically strengthened glass-ceramic.

In some embodiments of the present disclosure, the display screen cover plate, the back cover, the camera protection cover plate, or the middle frame in the electronic device can be 2D, 2.5D, 3D, or irregularly shaped. In some embodiments of the present disclosure, the display screen cover plate, the back cover, the camera protection cover plate, or the middle frame in the electronic device can have a uniform thickness or a non-uniform thickness.

The technical solutions of the present disclosure are further described in detail below with reference to the Examples. The Examples of the present disclosure described in detail below are illustrative, only for explaining the present disclosure, and should not be construed as limiting the present disclosure.

### Example 1

### I. Preparation of Base Glass

The raw materials were proportioned according to the ratios of the oxides in Table 1. The total mass of the prepared raw materials was 1000 g. 5 g of clarifying agent sodium chloride (NaCl) was added to the prepared raw materials. Then, the mixture was mixed in a V-type mixer at a speed of 25 r/min for more than 30 minutes to obtain a uniformly mixed raw material mixture.

The uniformly mixed raw material mixture was transferred to a platinum crucible, then melted in a platinum-rhodium crucible at 1600°C for more than 5 hours. Afterwards, it was poured into a forming mold and cooled for forming, cooled to about 900°C, then placed in an annealing furnace at 460°C for annealing for 12 hours, and then cooled to room temperature with the furnace to obtain a base glass brick with dimensions of approximately 180 mm * 65 mm * 24 mm.

### II. Preparation of Glass-Ceramic

The base glass brick was sequentially subjected to the nucleation treatment and the crystallization treatment to prepare a transparent glass-ceramic sample brick. The composition of the prepared glass-ceramic was the same as that of the base glass, as shown in Table 1, based on mole percentage of oxides. The relationships between the components of the glass-ceramic are shown in Table 2.

To obtain the glass-ceramic product of Example 1 of the present disclosure, during the nucleation treatment, the temperature was increased to the nucleation temperature at a heating rate of 10°C/min. The nucleation temperature was 520°C, and the nucleation holding time was 240 minutes. During the crystallization treatment, the temperature was increased from the nucleation temperature to the crystallization temperature at a heating rate of 10°C/min. The crystallization temperature was 690°C, and the crystallization holding time was 90 minutes. Afterwards, the temperature was decreased to room temperature at a cooling rate of 1°C/min to obtain the glass-ceramic sample brick. Here, the nucleation holding time, i.e., the nucleation time, refers to the time for which the crystallization furnace was held at the set nucleation temperature after being heated to the set nucleation temperature at the set heating rate. Here, the crystallization holding time, i.e., the crystallization time, refers to the time for which the crystallization furnace was held at the set crystallization temperature after being heated to the set crystallization temperature at the set heating rate.

The obtained glass-ceramic sample brick was sequentially subjected to cold working processes such as cutting, CNC machining (the CNC instrument equipment model used in the present disclosure was: RCG500S), and polishing to prepare a glass-ceramic sample that satisfied the desired specifications and requirements.

In the specific Examples and Comparative Examples of the present disclosure, the glass-ceramic sample brick was subjected to the aforementioned cold working processes to prepare a polished glass-ceramic sheet sample with dimensions of 50 mm × 50 mm and a thickness of 0.50 mm.

Testing of the glass-ceramic sample obtained in Example 1:
The crystalline phase composition, crystallinity, average grain size (average crystal size), expansion softening point, density, refractive index, Young's modulus, optical b value, and transmittance (under light with a wavelength of 550 nm) of the glass-ceramic sample were tested respectively. The results are shown in Table 3.

### III. Preparation of Chemically Strengthened Glass-Ceramic

The polished glass-ceramic sheet obtained above was subjected to a one-step chemical strengthening treatment in a mixed salt bath at 460°C for a strengthening time of 600 minutes. The composition of the mixed salt bath was: the mass ratio of NaNO₃:KNO₃:LiNO₃ in the molten salt was 29.99%:69.98%:0.03%.

After the chemical strengthening treatment, the glass-ceramic sample was taken out and placed on the furnace body of the strengthening furnace to slowly cool to room temperature. Then, the salt encrusted on the surface of the glass-ceramic was washed off with clean water. After drying the glass-ceramic sample, a chemically strengthened glass-ceramic was obtained. Testing of the chemically strengthened glass-ceramic obtained in Example 1:
I. Judgment of whether the chemically strengthened glass-ceramic had "surface cracking": If, when strong light was shone on the surface of the chemically strengthened glass-ceramic, no cracks were observed on the glass surface, as shown in FIG. 1, or if the chemically strengthened glass-ceramic was placed under an Axiolab 5 polarizing microscope using an LED light source and magnified 100 times or 200 times, and no cracks were observed on the glass surface, as shown in FIG. 3, then the appearance of the chemically strengthened glass-ceramic was considered to have no "surface cracking" problem, recorded as appearance "Qualified". If, when strong light was shone on the surface of the chemically strengthened glass-ceramic, bright cracks were observed, as shown in FIG. 2, or if the chemically strengthened glass-ceramic was placed under an Axiolab 5 polarizing microscope using an LED light source and magnified 100 times or 200 times, and cracks were observed on the glass surface, as shown in FIG. 4, then the chemically strengthened glass-ceramic was considered to have a "surface cracking" problem, recorded as appearance "Unqualified".
   The effect of the chemically strengthened glass-ceramic of Example 1 under strong light illumination is shown in FIG. 1. The morphology of the main surface and the cross-section along the thickness direction of this chemically strengthened glass-ceramic under a microscope (magnified 200 times) is shown in FIG. 3 and FIG. 5. It can be seen that there were no bright cracks, and there were no irregular cracks inside or on the surface of the glass.
II. Stress test: The chemically strengthened glass-ceramic obtained in each Example or Comparative Example was tested on an SLP-2000 stress meter (using a light source wavelength of 518 nm, SOC = 25.5 (nm/cm)/MPa, the refractive index was set according to the refractive index value of the sample to be tested, exposure time: 300 µsec) to measure CS_50, DOL_0, and |CT_AV|. Then, the tensile stress linear density CT_LD value, the stress integral value of the compressive stress layer from the main surface to DOL_0 of the chemically strengthened glass-ceramic, and the absolute value of the slope of the stress curve at depth t = 0.5 × DOL_0, |K_{0.5}×DOL_₀|, were calculated. The results are shown in Table 4.
III. Surface composition test of the chemically strengthened glass-ceramic: XRF was used to test the mass percentage of K₂O and the mass percentage of Na₂O of the surface of the prepared chemically strengthened glass-ceramic. The results are shown in Table 5. Simultaneously, a polishing machine was used to polish and thin two main surfaces of the prepared chemically strengthened glass-ceramic. After thinning each of two main surfaces by 3 µm, a thinned chemically strengthened glass-ceramic was obtained. XRF was used to test the mass percentage of K₂O and the mass percentage of Na₂O of the surface of the thinned chemically strengthened glass-ceramic. The results are shown in Table 5.

The transmittance curve of the chemically strengthened glass-ceramic of Example 1 is shown in FIG. 9. It can be seen from FIG. 9 that, in the present disclosure, the chemically strengthened glass-ceramic is transparent within the visible light range and has high transmittance.

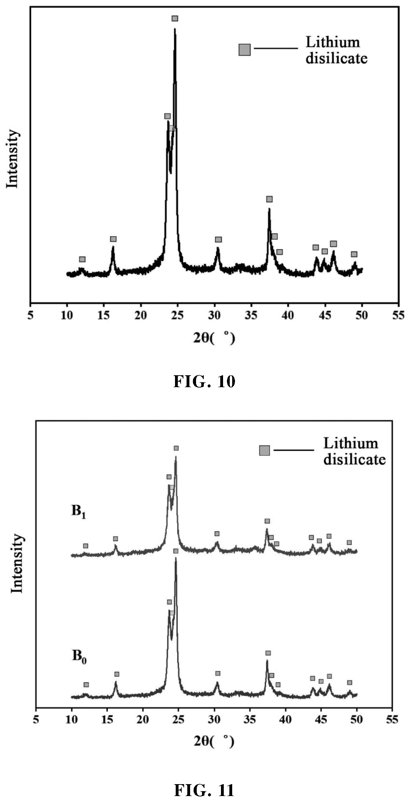

The XRD pattern of the glass-ceramic of Example 1 is shown in FIG. 10. The XRD patterns of the glass-ceramic of Example 1 before and after chemical strengthening are shown in FIG. 11. It can be seen from FIG. 10 and FIG. 11 that, in the present disclosure, the main crystalline phase in both the glass-ceramic and the chemically strengthened glass-ceramic is the lithium disilicate crystalline phase, and the crystalline phase structure of the glass-ceramic did not change significantly before and after the chemical strengthening treatment.

### Examples 2 to 21

These examples were carried out with reference to Example 1, except that the glass compositions, different process parameters, and their corresponding test results for each Example are shown in Tables 1-5, respectively.

### Comparative Examples 1 to 10

These Comparative Examples were carried out with reference to Example 1, except that the glass compositions, different process parameters, and their corresponding test results for each Comparative Example are shown in Tables 1-5, respectively.

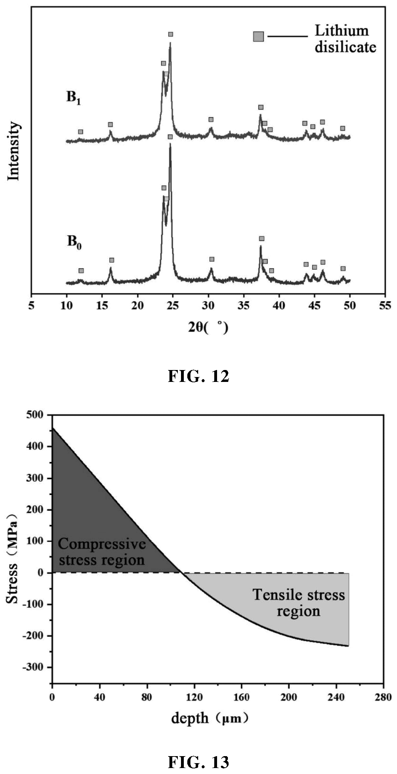

The XRD patterns of the glass-ceramic of Comparative Example 5 before and after chemical strengthening are shown in FIG. 12. It can be seen from FIG. 12 that, in the present disclosure, the main crystalline phase in both the glass-ceramic and the chemically strengthened glass-ceramic is the lithium disilicate crystalline phase, and the crystalline phase structure of the glass-ceramic did not change significantly before and after the chemical strengthening treatment.

Upper temperature limit for crystallization test: To analyze the industrial mass producibility of the glass-ceramic of the present disclosure, the upper temperature limit for crystallization of the base glasses of some Examples was tested. The results are shown in Table 3. The tested upper temperature limits for crystallization of the base glasses of the Examples were all between 1000°C and 1100°C, indicating that the glass-ceramic of the present disclosure is conducive to industrial mass production and manufacturing.

Expansion softening point test: To analyze the 3D hot bending effect of the glass-ceramic of the present disclosure, the thermal expansion coefficient test curves of the glass-ceramics of some Examples were tested to obtain the expansion softening point. The results are shown in Table 3. It can be seen from the test results that the expansion softening points of the glass-ceramics of the present disclosure are all between 750°C and 830°C, indicating that the glass-ceramic of the present disclosure is conducive to 3D hot bending to prepare 3D curved glass-ceramics.

**Table 1**

| Oxides (mol%) | SiO₂ | Al₂O₃ | P₂O₅ | ZrO₂ | MgO | ZnO | Na₂O | K₂O | Li₂O |
|---|---|---|---|---|---|---|---|---|---|
| Example 1 to Example 7 | 61.72% | 1.38% | 1.85% | 3.23% | 0% | 0% | 0% | 0% | 30.44% |
| Example 8 | 63.86% | 1.44% | 1.92% | 1.44% | 0.2% | 0.54% | 0% | 0% | 30.4% |
| Example 9 | 63.16% | 1.42% | 1.89% | 1.89% | 0% | 0% | 0% | 0% | 30.22% |
| Example 10 | 62.77% | 1.43% | 1.74% | 2.18% | 0% | 1.67% | 0% | 0% | 27.54% |
| Example 11 | 63.39% | 1.23% | 1.51% | 2.36% | 0% | 0% | 0% | 0% | 31.51% |
| Example 12 | 62.58% | 1.4% | 1.87% | 2.34% | 0% | 0% | 0.3% | 0% | 30.81% |
| Example 13 | 61.72% | 1.38% | 1.85% | 3.23% | 0% | 0% | 0% | 0% | 30.44% |
| Example 14 | 61.82% | 1.4% | 1.86% | 4.66% | 0% | 0% | 0% | 0% | 29.8% |
| Example 15 to Example 16 | 61.72% | 1.38% | 1.85% | 4.61% | 0% | 0% | 0% | 0% | 29.52% |
| Example 17 | 61.43% | 1.38% | 1.84% | 4.59% | 0% | 0% | 0% | 0% | 29.38% |
| Example 18 | 60.92% | 1.14% | 1.83% | 4.57% | 1.83% | 0% | 0% | 0.46% | 29.25% |
| Example 19 | 60.94% | 1.22% | 1.83% | 4.47% | 0% | 0% | 0% | 0% | 29.25% |
| Example 20 | 61.16% | 1.37% | 1.83% | 4.57% | 0% | 0% | 0% | 0% | 29.25% |
| Example 21 | 61.15% | 1.37% | 1.83% | 4.57% | 0% | 0% | 0% | 0% | 29.25% |
| Comparative Example 1 | 63.86% | 1.44% | 1.92% | 1.44% | 0.2% | 0.54% | 0% | 0% | 30.4% |
| Comparative Example 2 | 63.16% | 1.42% | 1.89% | 1.89% | 0% | 0% | 0% | 0% | 30.22% |
| Comparative Example 3 | 63.39% | 1.23% | 1.51% | 2.36% | 0% | 0% | 0% | 0% | 31.51% |
| Comparative Example 4 | 62.58% | 1.4% | 1.87% | 2.34% | 0% | 0% | 0.3% | 0% | 30.81% |
| Comparative Example 5 to Comparative Example 7 | 61.72% | 1.38% | 1.85% | 3.23% | 0% | 0% | 0% | 0% | 30.44% |
| Comparative Example 8 | 61.72% | 1.38% | 1.85% | 4.61% | 0% | 0% | 0% | 0% | 29.52% |
| Comparative Example 9 | 60.94% | 1.22% | 1.83% | 4.47% | 0% | 0% | 0% | 0% | 29.25% |
| Comparative Example 10 | 61.72% | 1.38% | 1.85% | 3.23% | 0% | 0% | 0% | 0% | 30.44% |

**Table 1 (continued)**

| Oxides (mol%) | CaO | B₂O₃ | Y₂O₃ | La₂O₃ | Ta₂O₅ | SrO | BaO | Yb₂O₃ |
|---|---|---|---|---|---|---|---|---|
| Example 1 to Example 7 | 0% | 0% | 0% | 0% | 0% | 0% | 1.38% | 0% |
| Example 8 | 0% | 0% | 0.2% | 0% | 0% | 0% | 0% | 0% |
| Example 9 | 0% | 0% | 0% | 0% | 0% | 1.42% | 0% | 0% |
| Example 10 | 2.67% | 0% | 0% | 0% | 0% | 0% | 0% | 0% |
| Example 11 | 0% | 0% | 0% | 0% | 0% | 0% | 0% | 0% |
| Example 12 | 0% | 0% | 0% | 0.2% | 0.5% | 0% | 0% | 0% |
| Example 13 | 0% | 0% | 0% | 0% | 0% | 1.38% | 0% | 0% |
| Example 14 | 0% | 0% | 0% | 0% | 0.46% | 0% | 0% | 0% |
| Example 15 to Example 16 | 0.92% | 0% | 0% | 0% | 0% | 0% | 0% | 0% |
| Example 17 | 0% | 0% | 0% | 0% | 0% | 0.92% | 0% | 0.46% |
| Example 18 | 0% | 0% | 0% | 0% | 0% | 0% | 0% | 0% |
| Example 19 | 0% | 0.46% | 0% | 0% | 0% | 0% | 1.83% | 0% |
| Example 20 | 0% | 0% | 0% | 0% | 0% | 0.91% | 0.91% | 0% |
| Example 21 | 0% | 0% | 0% | 0% | 0% | 1.83% | 0% | 0% |
| Comparative Example 1 | 0% | 0% | 0.2% | 0% | 0% | 0% | 0% | 0% |
| Comparative Example 2 | 0% | 0% | 0% | 0% | 0% | 1.42% | 0% | 0% |
| Comparative Example 3 | 0% | 0% | 0% | 0% | 0% | 0% | 0% | 0% |
| Comparative Example 4 | 0% | 0% | 0% | 0.2% | 0.5% | 0% | 0% | 0% |
| Comparative Example 5 to Comparative Example 7 | 0% | 0% | 0% | 0% | 0% | 0% | 1.38% | 0% |
| Comparative Example 8 | 0.92% | 0% | 0% | 0% | 0% | 0% | 0% | 0% |
| Comparative Example 9 | 0% | 0.46% | 0% | 0% | 0% | 0% | 1.83% | 0% |
| Comparative Example 10 | 0% | 0% | 0% | 0% | 0% | 0% | 1.38% | 0% |

| | | | | | | | | |
|---|---|---|---|---|---|---|---|---|
| Note: In Table 1, an oxide content of "0%" indicates that the component was not actively or intentionally added to the glass composition during the initial batching process, but the component may be present as an impurity. The oxide contents in Table 1 can be converted from mole percentage to mass percentage by means of conversion. | | | | | | | | |

**Table 2**

| Oxides (mol%) | n(SiO₂)+n(Li₂O) | n(SiO₂)/n(Li₂O) | 2.25×n(Li₂O)-8×n(ZrO₂)-0.2×n(CaO) |
|---|---|---|---|
| Example 1 to Example7 | 92.16% | 2.03 | 42.65% |
| Example 8 | 94.26% | 2.10 | 56.88% |
| Example 9 | 93.38% | 2.09 | 52.88% |
| Example 10 | 90.31% | 2.28 | 43.99% |
| Example 11 | 94.9% | 2.01 | 52.02% |
| Example 12 | 93.39% | 2.03 | 50.6% |
| Example 13 | 92.16% | 2.03 | 42.65% |
| Example 14 | 91.62% | 2.07 | 29.77% |
| Example 15 to Example 16 | 91.24% | 2.09 | 29.36% |
| Example 17 | 90.81% | 2.09 | 29.39% |
| Example 18 | 90.17% | 2.08 | 29.25% |
| Example 19 | 90.19% | 2.08 | 30.05% |
| Example 20 | 90.41% | 2.09 | 29.25% |
| Example 21 | 90.4% | 2.09 | 29.25% |
| Comparative Example 1 | 94.26% | 2.10 | 56.88% |
| Comparative Example 2 | 93.38% | 2.09 | 52.88% |
| Comparative Example 3 | 94.9% | 2.01 | 52.02% |
| Comparative Example 4 | 93.39% | 2.03 | 50.6% |
| Comparative Example 5 to Comparative Example7 | 92.16% | 2.03 | 42.65% |
| Comparative Example 8 | 91.24% | 2.09 | 29.36% |
| Comparative Example 9 | 90.19% | 2.08 | 30.05% |
| Comparative Example 10 | 92.16% | 2.03 | 42.65% |

**Table 2 (continued)**

| Oxides (mol%) | n(Y₂O₃)+n(La₂O₃)+n(Ta₂O₅) +n(Yb₂O₃) | n(SrO)+n(BaO)+n(CaO) +n(MgO) | n(SrO)/[n(SrO)+n(BaO) +n(CaO)+n(MgO)] |
|---|---|---|---|
| Example 1 to Example 7 | 0% | 1.38% | 0 |
| Example 8 | 0.2% | 0.2% | 0 |
| Example 9 | 0% | 1.42% | 1 |
| Example 10 | 0% | 2.67% | 0 |
| Example 11 | 0% | 0% | / |
| Example 12 | 0.7% | 0% | / |
| Example 13 | 0% | 1.38% | 1 |
| Example 14 | 0.46% | 0% | / |
| Example 15 to Example 16 | 0% | 0.92% | 0 |
| Example 17 | 0.46% | 0.92% | 1 |
| Example 18 | 0% | 1.83% | 0 |
| Example 19 | 0% | 1.83% | 0 |
| Example 20 | 0% | 1.83% | 0.5 |
| Example 21 | 0% | 1.83% | 1 |
| Comparative Example 1 | 0.2% | 0.2% | 0 |
| Comparative Example 2 | 0% | 1.42% | 1 |
| Comparative Example 3 | 0% | 0% | / |
| Comparative Example 4 | 0.7% | 0% | / |
| Comparative Example 5 to Comparative Example 7 | 0% | 1.38% | 0 |
| Comparative Example 8 | 0% | 0.92% | 0 |
| Comparative Example 9 | 0% | 1.83% | 0 |
| Comparative Example 10 | 0% | 1.38% | 0 |

| | | | |
|---|---|---|---|
| Note: In Table 2, "/" indicates that the value does not exist. In Table 2, the content percentages based on mole of oxides are substituted into each formula, and the mole units do not participate in calculation of the formulas. | | | |

**Table 3**

| | Upper temperature limit for crystallization (°C) | Nucleation temperature (°C) | Nucleation holding time (h) | Crystallization temperature (°C) | Crystallization holding time (h) | Crystalline phase | Crystallinity (wt%) |
|---|---|---|---|---|---|---|---|
| Example 1 to Example 7 | 1064.85 | 520 | 4 | 690 | 1.5 | Lithium disilicate | 79.85% |
| Example 8 | / | 500 | 4 | 630 | 1.5 | Lithium disilicate | 86.82% |
| Example 9 | / | 510 | 4 | 650 | 1.5 | Lithium disilicate | 84.25% |
| Example 10 | / | 520 | 4 | 670 | 1.0 | Lithium disilicate | 76.8% |
| Example 11 | 1084.00 | 520 | 4 | 710 | 1.0 | Lithium disilicate | 80.4% |
| Example 12 | / | 525 | 4 | 705 | 1.5 | Lithium disilicate | 79.65% |
| Example 13 | / | 520 | 4 | 690 | 1.5 | Lithium disilicate | 80.42% |
| Example 14 | 1067.21 | 520 | 4 | 710 | 1.0 | Lithium disilicate | 76.7% |
| Example 15 to Example 16 | 1053.45 | 520 | 4 | 690 | 1.5 | Lithium disilicate | 76.6% |
| Example 17 | / | 530 | 4 | 705 | 1.5 | Lithium disilicate | 73.64% |
| Example 18 | / | 525 | 4 | 695 | 1.5 | Lithium disilicate | 74.85% |
| Example 19 | / | 525 | 4 | 695 | 1.5 | Lithium disilicate | 70.69% |
| Example 20 | / | 525 | 4 | 695 | 1.5 | Lithium disilicate | 71.95% |
| Example 21 | 1050.80 | 525 | 4 | 700 | 1.5 | Lithium disilicate | 70.4% |
| Comparative Example 1 | / | 500 | 4 | 630 | 1.5 | Lithium disilicate | 86.82% |
| Comparative Example 2 | / | 510 | 4 | 650 | 1.5 | Lithium disilicate | 84.25% |
| Comparative Example 3 | 1084.00 | 520 | 4 | 710 | 1.0 | Lithium disilicate | 80.4% |
| Comparative Example 4 | / | 525 | 4 | 705 | 1.5 | Lithium disilicate | 79.65% |
| Comparative Example 5 to Comparative Example 7 | 1064.85 | 520 | 4 | 690 | 1.5 | Lithium disilicate | 79.85% |
| Comparative Example 8 | 1053.45 | 520 | 4 | 690 | 1.5 | Lithium disilicate | 76.6% |
| Comparative Example 9 | / | 525 | 4 | 695 | 1.5 | Lithium disilicate | 70.69% |
| Comparative Example 10 | 1064.85 | 520 | 4 | 690 | 1.5 | Lithium disilicate | 79.85% |

**Table 3 (continued)**

| | Average grain size (nm) | Optical b value | Transmittance at 550nm | Expansion softening point (°C) | Density (g/cm³) | Refractive index | Young's modulus (GPa) |
|---|---|---|---|---|---|---|---|
| Example 1 to Example 7 | 23.70 | 0.39 | 90.76% | 809.0 | 2.60 | 1.57 | 118.60 |
| Example 8 | 26.80 | 0.55 | 90.31% | 767.0 | 2.54 | 1.56 | 116.50 |
| Example 9 | 23.20 | 0.49 | 90.59% | 780.0 | 2.54 | 1.56 | 116.10 |
| Example 10 | 19.60 | 0.30 | 91% | 795.0 | 2.54 | 1.56 | 115.63 |
| Example 11 | 19.50 | 0.32 | 90.94% | 826.0 | 2.51 | 1.55 | 116.52 |
| Example 12 | 24.50 | 0.49 | 90.63% | 820.0 | 2.52 | 1.55 | 117.64 |
| Example 13 | 24.20 | 0.41 | 90.65% | 798.0 | 2.59 | 1.57 | 118.80 |
| Example 14 | 22.80 | 0.56 | 90.4% | 797.0 | 2.57 | 1.57 | 117.07 |
| Example 15 to Example 16 | 23.00 | 0.41 | 90.46% | 796.0 | 2.58 | 1.57 | 114.27 |
| Example 17 | 24.60 | 0.47 | 90.29% | 797.9 | 2.62 | 1.57 | 113.30 |
| Example 18 | 24.80 | 0.51 | 90.37% | 778.0 | 2.58 | 1.57 | 114.52 |
| Example 19 | 26.00 | 0.52 | 90.27% | 801.0 | 2.64 | 1.58 | 120.00 |
| Example 20 | 25.50 | 0.60 | 90.3% | 788.0 | 2.64 | 1.58 | 119.30 |
| Example 21 | 25.60 | 0.60 | 90.35% | 783.0 | 2.64 | 1.58 | 118.95 |
| Comparative Example 1 | 26.80 | 0.55 | 90.31% | 767.0 | 2.54 | 1.56 | 116.50 |
| Comparative Example 2 | 23.20 | 0.49 | 90.59% | 780.0 | 2.54 | 1.56 | 116.10 |
| Comparative Example 3 | 19.50 | 0.32 | 90.94% | 826.0 | 2.51 | 1.55 | 116.52 |
| Comparative Example 4 | 24.50 | 0.49 | 90.63% | 820.0 | 2.52 | 1.55 | 117.64 |
| Comparative Example 5 to Comparative Example 7 | 23.70 | 0.39 | 90.76% | 809.0 | 2.60 | 1.57 | 118.60 |
| Comparative Example 8 | 23.00 | 0.41 | 90.46% | 796.0 | 2.58 | 1.57 | 114.27 |
| Comparative Example 9 | 26.00 | 0.62 | 90.27% | 801.0 | 2.64 | 1.58 | 120.00 |
| Comparative Example 10 | 23.70 | 0.39 | 90.76% | 809.0 | 2.60 | 1.57 | 118.60 |

| | | | | | | | |
|---|---|---|---|---|---|---|---|
| Note: In Table 3, "/" indicates that the parameter was not tested or that the value does not exist. | | | | | | | |

**Table 4**

| | Strengthening temperature(°C) | Salt bath composition (mass percentage) | Strengthening time t_{strengthening} | CS_50 (MPa) | DOL_0 (µm) | \|CT_AV\| (MPa) |
|---|---|---|---|---|---|---|
| Example 1 | 460 | 29.99% NaNO₃+69.98% KNO₃ +0.03 % LiNO₃ | 600min | 158.56 | 110.54 | 116.42 |
| Example 2 | 470 | 10%NaNO₃+90%KNO₃ | 480min | 168.85 | 109.75 | 114.85 |
| Example 3 | 470 | 29.99%NaNO₃+69.98%KNO₃ +0.03%LiNO₃ | 420min | 168.41 | 111.42 | 120.50 |
| Example 4 | 470 | 69.98%NaNO₃+29.99%KNO₃ +0.03%LiNO₃ | 360min | 180.27 | 110.75 | 122.54 |
| Example 5 | 470 | 100% NaNO₃ | 325min | 195.42 | 114.20 | 117.56 |
| Example 6 | 480 | 29.99%NaNO₃+69.98%KNO₃ +0.03%LiNO₃ | 300min | 170.20 | 111.90 | 124.85 |
| Example 7 | 490 | 29.99%NaNO₃+69.98%KNO₃ +0.03%LiNO₃ | 240min | 188.74 | 113.24 | 126.47 |
| Example 8 | 450 | 19.99%NaNO₃+79.98%KNO₃ +0.03%LiNO₃ | 480min | 113.52 | 105.74 | 84.25 |
| Example 9 | 470 | 29.99%NaNO₃+69.98%KNO₃ +0.03%LiNO₃ | 240min | 153.44 | 107.56 | 95.34 |
| Example 10 | 470 | 29.99%NaNO₃+69.98%KNO₃ +0.03%LiNO₃ | 300min | 143.55 | 107.96 | 100.24 |
| Example 11 | 470 | 29.99%NaNO₃+69.98%KNO₃ +0.03%LiNO₃ | 240min | 147.58 | 110.78 | 106.45 |
| Example 12 | 470 | 29.99% NaNO₃+69.98% KNO₃ +0.03 % LiNO₃ | 180min | 153.89 | 108.98 | 98.42 |
| Example 13 | 470 | 29.99% NaNO₃+69.98% KNO₃ +0.03 % LiNO₃ | 435min | 184.21 | 109.87 | 124.24 |
| Example 14 | 470 | 29.99% NaNO₃+69.98% KNO₃ +0.03 % LiNO₃ | 180min | 207.10 | 107.04 | 135.85 |
| Example 15 | 470 | 29.99% NaNO₃+69.98% KNO₃ +0.03 % LiNO₃ | 330min | 216.95 | 107.62 | 146.64 |
| Example 16 | 530 | 29.99%NaNO₃+69.98%KNO₃ +0.03%LiNO₃ | 50min | 246.54 | 109.78 | 156.79 |
| Example 17 | 470 | 29.99% NaNO₃+69.98% KNO₃ +0.03 % LiNO₃ | 450min | 223.64 | 110.42 | 150.21 |
| Example 18 | 470 | 29.99% NaNO₃+69.98% KNO₃ +0.03 % LiNO₃ | 300min | 229.67 | 112.85 | 154.65 |
| Example 19 | 470 | 29.99% NaNO₃+69.98% KNO₃ +0.03 % LiNO₃ | 480min | 223.50 | 106.99 | 152.75 |
| Example 20 | 470 | 29.99% NaNO₃+69.98% KNO₃ +0.03 % LiNO₃ | 460min | 239.75 | 107.67 | 157.95 |
| Example 21 | 470 | 29.99% NaNO₃+69.98% KNO₃ +0.03 % LiNO₃ | 450min | 244.85 | 110.42 | 162.35 |
| Comparative Example 1 | 470 | 30.00%NaNO₃+70.00%KNO₃ | 55min | 97.52 | 72.41 | 61.24 |
| Comparative Example 2 | 480 | 100%NaNO₃ | 105min | 110.09 | 78.01 | 59.55 |
| Comparative Example 3 | 500 | 100% NaNO₃ | 25min | 104.51 | 76.85 | 67.85 |
| Comparative Example 4 | 500 | 100% NaNO₃ | 15min | 113.08 | 81.64 | 63.74 |
| Comparative Example 5 | 490 | 99.96%NaNO₃+0.04%LiNO₃ | 45min | 108.74 | 80.61 | 85.96 |
| Comparative Example 6 | 500 | 29.99%NaNO₃+69.98%KNO₃ +0.03%LiNO₃ | 40min | 103.20 | 77.29 | 81.38 |
| Comparative Example 7 | 520 | 29.99%NaNO₃+69.98%KNO₃ +0.03%LiNO₃ | 20min | 115.24 | 75.24 | 83.47 |
| Comparative Example 8 | 540 | 29.99%NaNO₃+69.98%KNO₃ +0.03%LiNO₃ | 25min | 165.07 | 81.72 | 106.74 |
| Comparative Example 9 | 540 | 19.99%NaNO₃+79.98%KNO₃ +0.03%LiNO₃ | 20min | 174.25 | 75.85 | 104.57 |
| Comparative Example 10 | 470 | 5.00%NaNO₃+94.80%KNO₃ +0.20%LiNO₃ | 540min | 88.57 | 104.96 | 72.84 |

**Table 4 (continued)**

| | CT_LD (MPa/mm) | DOL_0/T | ${\int }_{0}^{DOL _ 0} CS \left(t\right) dt$ | \|K_{0.5×DOL_0}\| | Relationshi p A | Relationship C | Relationshi p B |
|---|---|---|---|---|---|---|---|
| Example 1 | 64943.73 | 0.22 | 16624 | 3.088 | 150.39 | 33.97 | 144.41 |
| Example 2 | 64430.85 | 0.22 | 17025 | 3.154 | 155.13 | 40.28 | 149.14 |
| Example 3 | 66795.56 | 0.22 | 17582 | 3.105 | 157.80 | 37.30 | 151.82 |
| Example 4 | 68254.78 | 0.22 | 18157 | 3.241 | 163.95 | 41.41 | 157.96 |
| Example 5 | 63858.59 | 0.23 | 18869 | 3.085 | 165.23 | 47.67 | 159.24 |
| Example 6 | 68967.14 | 0.22 | 18775 | 3.208 | 167.78 | 42.93 | 161.80 |
| Example 7 | 69184.15 | 0.23 | 19475 | 3.309 | 171.98 | 45.51 | 166.00 |
| Example 8 | 48615.62 | 0.21 | 13748 | 2.958 | 130.02 | 45.77 | 148.99 |
| Example 9 | 54320.92 | 0.22 | 15927 | 3.224 | 148.08 | 52.74 | 165.83 |
| Example 10 | 56952.36 | 0.22 | 16574 | 3.647 | 153.52 | 53.28 | 168.65 |
| Example 11 | 59279.88 | 0.22 | 17489 | 3.057 | 157.87 | 51.42 | 170.67 |
| Example 12 | 55516.75 | 0.22 | 16423 | 3.464 | 150.70 | 52.28 | 163.85 |
| Example 13 | 69639.00 | 0.22 | 17745 | 3.354 | 161.51 | 37.27 | 155.53 |
| Example 14 | 77684.46 | 0.21 | 21471 | 3.984 | 200.59 | 64.74 | 136.18 |
| Example 15 | 83514.41 | 0.22 | 23417 | 4.354 | 217.59 | 70.95 | 155.43 |
| Example 16 | 87940.38 | 0.22 | 25715 | 4.587 | 234.24 | 77.45 | 172.09 |
| Example 17 | 83865.25 | 0.22 | 22974 | 4.244 | 208.06 | 57.85 | 147.01 |
| Example 18 | 84840.99 | 0.23 | 23376 | 4.216 | 207.14 | 52.49 | 147.17 |
| Example 19 | 87379.11 | 0.21 | 23545 | 4.485 | 220.07 | 67.32 | 165.17 |
| Example 20 | 89924.09 | 0.22 | 24141 | 4.454 | 224.21 | 66.26 | 164.24 |
| Example 21 | 90643.25 | 0.22 | 25028 | 4.324 | 226.66 | 64.31 | 166.69 |
| Comparative Example 1 | 43502.45 | 0.14 | 11742 | 6.392 | 162.16 | 100.92 | 181.13 |
| Comparative Example 2 | 40968.02 | 0.16 | 13777 | 7.041 | 176.61 | 117.06 | 194.36 |
| Comparative Example 3 | 46992.91 | 0.15 | 14256 | 7.218 | 185.50 | 117.65 | 198.30 |
| Comparative Example 4 | 42925.07 | 0.16 | 13959 | 6.452 | 170.98 | 107.24 | 184.13 |
| Comparative Example 5 | 58243.06 | 0.16 | 15085 | 6.895 | 187.14 | 101.18 | 181.15 |
| Comparative Example 6 | 56220.56 | 0.15 | 15127 | 7.143 | 195.72 | 114.34 | 189.73 |
| Comparative Example 7 | 58348.87 | 0.15 | 16679 | 7.886 | 221.68 | 138.21 | 215.69 |
| Comparative Example 8 | 71848.83 | 0.16 | 20696 | 7.405 | 253.26 | 146.52 | 191.10 |
| Comparative Example 9 | 72843.46 | 0.15 | 20174 | 7.854 | 265.97 | 161.40 | 211.07 |
| Comparative Example 10 | 42258.85 | 0.21 | 9862 | 1.568 | 93.96 | 21.12 | 87.98 |

**Table 5**

| | Strengthening temperature (°C) | Salt bath composition (mass percentage) | Strengthening time t_{strengthening} |
|---|---|---|---|
| Example 1 | 460 | 29.99%NaNO₃+69.98%KNO₃+0.03%LiNO₃ | 600min |
| Example 2 | 470 | 10%NaNO₃+90%KNO₃ | 480min |
| Example 3 | 470 | 29.99%NaNO₃+69.98%KNO₃+0.03%LiNO₃ | 420min |
| Example 4 | 470 | 69.98%NaNO₃+29.99%KNO₃+0.03%LiNO₃ | 360min |
| Example 5 | 470 | 100%NaNO₃ | 325min |
| Example 6 | 480 | 29.99%NaNO₃+69.98%KNO₃+0.03%LiNO₃ | 300min |
| Example 7 | 490 | 29.99%NaNO₃+69.98%KNO₃+0.03%LiNO₃ | 240min |
| Example 8 | 450 | 19.99%NaNO₃+79.98%KNO₃+0.03%LiNO₃ | 480min |
| Example 9 | 470 | 29.99%NaNO₃+69.98%KNO₃+0.03%LiNO₃ | 240min |
| Example 10 | 470 | 29.99%NaNO₃+69.98%KNO₃+0.03%LiNO₃ | 300min |
| Example 11 | 470 | 29.99%NaNO₃+69.98%KNO₃+0.03%LiNO₃ | 240min |
| Example 12 | 470 | 29.99%NaNO₃+69.98%KNO₃+0.03%LiNO₃ | 180min |
| Example 13 | 470 | 29.99%NaNO₃+69.98%KNO₃+0.03%LiNO₃ | 435min |
| Example 14 | 470 | 29.99%NaNO₃+69.98%KNO₃+0.03%LiNO₃ | 180min |
| Example 15 | 470 | 29.99%NaNO₃+69.98%KNO₃+0.03%LiNO₃ | 330min |
| Example 16 | 530 | 29.99%NaNO₃+69.98%KNO₃+0.03%LiNO₃ | 50min |
| Example 17 | 470 | 29.99%NaNO₃+69.98%KNO₃+0.03%LiNO₃ | 450min |
| Example 18 | 470 | 29.99%NaNO₃+69.98%KNO₃+0.03%LiNO₃ | 300min |
| Example 19 | 470 | 29.99%NaNO₃+69.98%KNO₃+0.03%LiNO₃ | 480min |
| Example 20 | 470 | 29.99%NaNO₃+69.98%KNO₃+0.03%LiNO₃ | 460min |
| Example 21 | 470 | 29.99%NaNO₃+69.98%KNO₃+0.03%LiNO₃ | 450min |
| Comparative Example 1 | 470 | 30.00%NaNO₃+70.00%KNO₃ | 55min |
| Comparative Example 2 | 480 | 100% NaNO₃ | 105min |
| Comparative Example 3 | 500 | 100% NaNO₃ | 25min |
| Comparative Example 4 | 500 | 100%NaNO₃ | 15min |
| Comparative Example 5 | 490 | 99.96%NaNO₃+0.04%LiNO₃ | 45min |
| Comparative Example 6 | 500 | 29.99%NaNO₃+69.98%KNO₃+0.03%LiNO₃ | 40min |
| Comparative Example 7 | 520 | 29.99%NaNO₃+69.98%KNO₃+0.03%LiNO₃ | 20min |
| Comparative Example 8 | 540 | 29.99%NaNO₃+69.98%KNO₃+0.03%LiNO₃ | 25min |
| Comparative Example 9 | 540 | 19.99%NaNO₃+79.98%KNO₃+0.03%LiNO₃ | 20min |
| Comparative Example 10 | 470 | 5.00%NaNO₃+94.80%KNO₃+0.20%LiNO₃ | 540min |

**Table 5 (continued)**

| | M(Na₂O) | M(K₂O) | M'(Na₂O) | M'(K₂O) | Appearance | Average drop height on 80-mesh sandpaper (m) |
|---|---|---|---|---|---|---|
| Example 1 | 9.68% | 0.31% | 7.24% | 0.05% | Qualified | 1.30 |
| Example 2 | 6.12% | 1.32% | 5.04% | 0.21% | Qualified | 1.32 |
| Example 3 | 9.75% | 0.32% | 7.35% | 0.06% | Qualified | 1.33 |
| Example 4 | 15.75% | 0.18% | 12.14% | 0.02% | Qualified | 1.55 |
| Example 5 | 24.68% | 0% | 17.52% | 0% | Qualified | 1.64 |
| Example 6 | 10.24% | 0.32% | 8.14% | 0.03% | Qualified | 1.52 |
| Example 7 | 12.75% | 0.33% | 9.84% | 0.02% | Qualified | 1.58 |
| Example 8 | 6.24% | 1.08% | 5.12% | 0.14% | Qualified | 1.02 |
| Example 9 | 9.54% | 0.30% | 7.64% | 0.02% | Qualified | 1.25 |
| Example 10 | 9.68% | 0.31% | 7.68% | 0.02% | Qualified | 1.24 |
| Example 11 | 9.74% | 0.29% | 7.34% | 0.01% | Qualified | 1.25 |
| Example 12 | 9.35% | 0.32% | 6.95% | 0.01% | Qualified | 1.25 |
| Example 13 | 10.14% | 0.30% | 8.17% | 0.03% | Qualified | 1.62 |
| Example 14 | 10.47% | 0.31% | 8.24% | 0.03% | Qualified | 1.74 |
| Example 15 | 9.69% | 0.33% | 7.72% | 0.01% | Qualified | 1.78 |
| Example 16 | 14.96% | 0.54% | 11.74% | 0.08% | Qualified | 2.05 |
| Example 17 | 9.84% | 0.31% | 7.25% | 0.03% | Qualified | 1.80 |
| Example 18 | 10.27% | 0.28% | 8.14% | 0.01% | Qualified | 1.84 |
| Example 19 | 9.95% | 0.30% | 7.65% | 0.02% | Qualified | 1.89 |
| Example 20 | 10.85% | 0.30% | 8.42% | 0.02% | Qualified | 1.95 |
| Example 21 | 11.74% | 0.33% | 9.35% | 0.01% | Qualified | 2.00 |
| Comparative Example 1 | 14.34% | 0.43% | 11.42% | 0.04% | Unqualified | 0.49 |
| Comparative Example 2 | 27.85% | 0% | 20.65% | 0% | Unqualified | 0.54 |
| Comparative Example 3 | 26.48% | 0% | 20.14% | 0% | Unqualified | 0.57 |
| Comparative Example 4 | 26.95% | 0% | 20.30% | 0% | Unqualified | 0.50 |
| Comparative Example 5 | 21.85% | 0% | 15.72% | 0% | Unqualified | 0.55 |
| Comparative Example 6 | 10.35% | 0.42% | 8.14% | 0.03% | Unqualified | 0.55 |
| Comparative Example 7 | 12.96% | 0.44% | 9.85% | 0.03% | Unqualified | 0.59 |
| Comparative Example 8 | 18.47% | 0.52% | 13.75% | 0.05% | Unqualified | 0.70 |
| Comparative Example 9 | 15.84% | 0.75% | 12.65% | 0.11% | Unqualified | 0.73 |
| Comparative Example 10 | 4.52% | 1.27% | 3.42% | 0.25% | Qualified | 0.90 |

| | | | | | | |
|---|---|---|---|---|---|---|
| Note: M(Na₂O) and M(K₂O) are respectively the mass percentage of K₂O and the mass percentage of Na₂O of the surface of the chemically strengthened glass-ceramic measured by XRF. M'(Na₂O) and M'(K₂O) are respectively the mass percentage of K₂O and the mass percentage of Na₂O of the surface of the chemically strengthened glass-ceramic measured by XRF after polishing and thinning a thickness of 3 µm from each of two main surfaces of the chemically strengthened glass-ceramic. An appearance of "Qualified" indicates that the chemically strengthened glass-ceramic has no problem of "surface cracking", and an appearance of "Unqualified" indicates that the chemically strengthened glass-ceramic has the problem of "surface cracking". | | | | | | |

From the above description and the Examples and Comparative Examples in Tables 1-5, it can be seen that, compared with the Comparative Examples, by using the scheme of the Examples of the present disclosure, i.e., subjecting a glass-ceramic having a specific composition, having lithium disilicate as the main crystalline phase, and having a high lithium content to chemical strengthening treatment such that it satisfies specific stress characteristics, including having the mole percentage content of ZrO₂ in the glass-ceramic and the stress characteristic relationship A satisfy a specific requirement (i.e., satisfy the range requirement of relationship B), and/or having the stress characteristic relationship A and the average tensile stress value |CT_AV| satisfy a specific requirement (i.e., satisfy the range requirement of relationship C), and/or having the stress curve slope |K_{0.5×DOL_0}| satisfy a specific range requirement, it is able to not only effectively overcome the problem of "surface cracking" in the resulting chemically strengthened glass-ceramic, but also ensure that the chemically strengthened glass-ceramic has high mechanical strength performance, thereby ensuring that the chemically strengthened glass-ceramic has excellent damage resistance performance.

In the schemes of Comparative Examples 1 to 10, the composition and stress structure of the chemically strengthened glass-ceramic did not satisfy the specific requirements of the present disclosure, for example, they did not satisfy the specific range requirements of relationship B and relationship C required by the scheme of the present disclosure. Consequently, the chemically strengthened glass-ceramics prepared in the schemes of the various Comparative Examples either had the problem of "surface cracking", failing to meet appearance requirements and failing to achieve excellent drop damage resistance performance, or had a low stress level, failing to achieve the desired stress effect, resulting in poor mechanical properties and strength performance, and also failing to achieve excellent drop damage resistance performance.

For example, for the chemically strengthened glass-ceramics prepared in Comparative Examples 1 to 9, after calculation using relationship B and relationship C, it was found that their values were greater than the range requirements of the technical scheme of the present disclosure. The final tests revealed that all of these chemically strengthened glass-ceramics had the problem of "surface cracking", and during the sandpaper drop resistance test, the average sandpaper drop resistance height of these chemically strengthened glass-ceramics was less than 0.8 m. For the chemically strengthened glass-ceramic prepared in Comparative Example 10, after calculation using relationship B and relationship C, it was found that its value was less than the range requirements of the technical scheme of the present disclosure. The final tests revealed that although this chemically strengthened glass-ceramic did not have the problem of "surface cracking", its average sandpaper drop resistance height during the sandpaper drop resistance test was only 0.9 m, which is less than 1 m.

For another example, in Examples 1-7, Comparative Examples 5-7, and Comparative Example 10, glass-ceramics having the same glass composition and crystalline phase structure were used to prepare chemically strengthened glass-ceramics. However, because the values of relationship B and relationship C satisfied by the stress characteristics and composition of the resulting chemically strengthened glass-ceramics were different, it was ultimately found that the chemically strengthened glass-ceramics prepared in Examples 1-7, which satisfied the range requirements of the technical scheme of the present disclosure, not only overcame the problem of "surface cracking", but also had average sandpaper drop resistance heights greater than 1.3 m during the sandpaper drop resistance test. In contrast, the chemically strengthened glass-ceramics prepared in Comparative Examples 5-7, which did not satisfy the range requirements of the technical scheme of the present disclosure, all had the "surface cracking" problem, and their average sandpaper drop resistance heights during the sandpaper drop resistance test were all less than 0.6 m. The chemically strengthened glass-ceramic prepared in Comparative Example 10, which did not satisfy the range requirements of the technical scheme of the present disclosure, although it did not have the problem of "surface cracking", had an average sandpaper drop resistance height of less than 1 m during the sandpaper drop resistance test. This indicates that during the chemical strengthening treatment of the glass-ceramic with a high lithium content and having lithium disilicate as the main crystalline phase to prepare a chemically strengthened glass-ceramic with desired properties, the compatibility between the glass composition and the stress distribution structure is very important. When a glass-ceramic of a specific composition matches an appropriate and preferred stress distribution structure, it not only overcomes the problem of "surface cracking" in the resulting chemically strengthened glass-ceramic, but also ensures that the chemically strengthened glass-ceramic has high mechanical strength performance.

The above are only specific examples of the present disclosure and are not intended to limit the present disclosure. For those skilled in the art, the present disclosure may have various modifications and changes. Any modifications, equivalent substitutions, improvements, etc., made within the spirit and principle of the present disclosure shall be included within the protection scope of the present disclosure.

### INDUSTRIAL APPLICABILITY

In summary, the present disclosure provides a chemically strengthened glass-ceramic, a cover glass comprising the chemically strengthened glass-ceramic, an electronic device, and a glass device. The chemically strengthened glass-ceramic, with a high lithium content and having lithium disilicate as the main crystalline phase, has a specific composition and a specific stress distribution structure, such that the chemically strengthened glass-ceramic not only is free from the problem of "surface cracking" but also has high mechanical strength performance.

## Claims

1. A chemically strengthened glass-ceramic, wherein a main crystalline phase of the chemically strengthened glass-ceramic is a lithium disilicate crystalline phase; a crystallinity of the chemically strengthened glass-ceramic is not less than 65%; a Li₂O content at a center of the chemically strengthened glass-ceramic is not less than 11%, based on mass percentage of oxides;
the chemically strengthened glass-ceramic has a compressive stress layer on a surface thereof and has a tensile stress layer inside; the chemically strengthened glass-ceramic satisfies the following relationships: $A = \frac{{\int }_{0}^{DOL _ 0} CS \left(t\right) dt}{DOL _ 0} ;$ and
B=A-83989×[n(ZrO₂)]²+2526.5×n(ZrO₂), with 130 ≤ B ≤ 180, preferably 135 ≤ B ≤ 180, more preferably 135 ≤ B ≤ 175;
wherein t is a depth from a main surface of the chemically strengthened glass-ceramic, CS(t) is a compressive stress value at depth t, ${\int }_{0}^{DOL _ 0} CS \left(t\right) dt$ is a stress integral of the compressive stress layer from the main surface to DOL_0 of the chemically strengthened glass-ceramic, in MPa·µm; and
DOL_0 is a depth of the compressive stress layer, in µm;
in relationship A, corresponding data are substituted for calculation according to the above unit requirements, and a calculation result of relationship A is obtained, wherein only numerical values are used in the calculation, with units being disregarded;
n(ZrO₂) is a mole percentage content of ZrO₂ at the center of the chemically strengthened glass-ceramic;
in relationship B, a value of relationship A and a numerical value of the mole percentage content of ZrO₂ are substituted for calculation, and a calculation result of relationship B is obtained, wherein only numerical values are used in the calculation, with units being disregarded.

2. The chemically strengthened glass-ceramic according to claim 1, wherein the value of relationship A satisfies: 120 ≤ A ≤ 250, preferably 130 ≤ A ≤ 240, more preferably 130 ≤ A ≤ 235.

3. The chemically strengthened glass-ceramic according to claim 1 or 2, wherein the chemically strengthened glass-ceramic satisfies the following relationship: C=A-|CT_AV|, with 30 ≤ C ≤ 90, preferably 30 ≤ C ≤ 85, more preferably 30 ≤ C ≤ 80, wherein |CT_AV| is an absolute value of an average tensile stress, in MPa.

4. The chemically strengthened glass-ceramic according to any one of claims 1 to 3, wherein the chemically strengthened glass-ceramic satisfies the following relationship: 2.0 ≤ |K_{0.5×DOL_0}| ≤ 6.0, wherein |K_{0.5×DOL_0}| is an absolute value of a slope of a stress curve at a depth t = 0.5 × DOL_0 from the main surface of the chemically strengthened glass-ceramic.

5. The chemically strengthened glass-ceramic according to any one of claims 1 to 4, wherein the chemically strengthened glass-ceramic satisfies:
0.20 ≤ DOL_0/T ≤ 0.25, preferably 0.21 ≤ DOL_0/T ≤ 0.23, wherein DOL_0 is the depth of the compressive stress layer, and T is a thickness of the chemically strengthened glass-ceramic; and/or,
90.00 µm ≤ DOL_0 ≤ 160.00 µm, preferably 100.00 µm ≤ DOL_0 ≤ 160.00 µm, wherein DOL_0 is the depth of the compressive stress layer; and/or,
100.00 MPa ≤ CS_50 ≤ 300.00 MPa, preferably 110.00 MPa ≤ CS_50 ≤ 250.00 MPa, more preferably 110.00 MPa ≤ CS_50 ≤ 240.00 MPa, wherein CS_50 is a compressive stress value at a depth of 50 µm from the main surface of the chemically strengthened glass-ceramic; and/or,
80.00 MPa ≤ |CT_AV| ≤ 200.00 MPa, preferably 80.00 MPa ≤ |CT_AV| ≤ 170.00 MPa, more preferably 80.00 MPa ≤ |CT_AV| ≤ 160.00 MPa, wherein |CT_AV| is the absolute value of the average tensile stress; and/or,
40000.00 MPa/mm ≤ CT_LD ≤ 100000.00 MPa/mm, preferably 47000.00 MPa/mm ≤ CT_LD ≤ 95000.00 MPa/mm, wherein CT_LD is a tensile stress linear density.

6. The chemically strengthened glass-ceramic according to any one of claims 1 to 5, wherein the chemically strengthened glass-ceramic satisfies: 0 ≤ M(K₂O) ≤ 1.5%, and 5% ≤ M(Na₂O) ≤ 25%; M(K₂O) is a mass percentage of K₂O of a surface of the chemically strengthened glass-ceramic, and M(Na₂O) is a mass percentage of Na₂O of the surface of the chemically strengthened glass-ceramic; and/or,
after thinning a thickness of 3 µm from each of two main surfaces of the chemically strengthened glass-ceramic, a resulting thinned chemically strengthened glass-ceramic satisfies: a mass percentage M'(K₂O) of K₂O of a surface of the thinned chemically strengthened glass-ceramic and a mass percentage M'(Na₂O)of Na₂O of the surface of the thinned chemically strengthened glass-ceramic are: 0 ≤ M'(K₂O) ≤ 0.5%, and 4.0% ≤ M'(Na₂O)≤ 20%.

7. The chemically strengthened glass-ceramic according to any one of claims 1 to 6, wherein, a composition at a center or of the tensile stress layer of the chemically strengthened glass-ceramic comprises:
SiO₂: 58% to 66%, Al₂O₃: 0% to 3.5%, P₂O₅: 1% to 3%, ZrO₂: 1% to 6%, and Li₂O: 24% to 32%, based on mole percentage of oxides.

8. The chemically strengthened glass-ceramic according to claim 7, wherein, the composition at the center or of the tensile stress layer of the chemically strengthened glass-ceramic further comprises:
SrO: 0% to 3%, and/or,
Na₂O: 0% to 4%, and/or,
K₂O: 0% to 2%, and/or,
CaO: 0% to 5%, and/or,
B₂O₃: 0% to 1%, and/or,
Ta₂O₅: 0% to 1%, and/or,
BaO: 0% to 3%, and/or,
MgO: 0% to 3%, and/or,
ZnO: 0% to 3%, and/or,
Y₂O₃: 0% to 1%, and/or,
La₂O₃: 0% to 1%, and/or,
Yb₂O₃: 0% to 1%,
based on mole percentage of oxides.

9. The chemically strengthened glass-ceramic according to any one of claims 1 to 8, wherein, the composition at the center or of the tensile stress layer of the chemically strengthened glass-ceramic comprises:
SiO₂ with a mole percentage of 60% to 65%, preferably 60.5% to 64.50%; and/or,
Al₂O₃ with a mole percentage of 0.5% to 3.5%, preferably 1% to 1.5%; and/or,
P₂O₅ with a mole percentage of 1% to 2.8%, preferably 1.20% to 2%; and/or,
ZrO₂ with a mole percentage of 1% to 5%, preferably 1.4% to 5%; and/or,
Li₂O with a mole percentage of 24% to 31.6%, preferably 27.5% to 31%; and/or,
Na₂O with a mole percentage of 0% to 3%, preferably 0% to 1%; and/or,
K₂O with a mole percentage of 0% to 1%, preferably 0% to 0.7%; and/or,
CaO with a mole percentage of 0% to 4%, preferably 0% to 3%; and/or,
BaO with a mole percentage of 0% to 2%, preferably 1% to 2%; and/or,
SrO with a mole percentage of 0% to 2%, preferably 1% to 2%; and/or,
MgO with a mole percentage of 0% to 2%; and/or,
ZnO with a mole percentage of 0% to 2%; and/or,
B₂O₃ with a mole percentage of 0% to 0.7%, preferably 0% to 0.5%; and/or,
Y₂O₃ with a mole percentage of 0% to 0.5%, preferably 0% to 0.2%; and/or,
La₂O₃ with a mole percentage of 0% to 0.5%, preferably 0% to 0.2%; and/or,
Ta₂O₅ with a mole percentage of 0% to 0.7%, preferably 0% to 0.5%; and/or,
Yb₂O₃ with a mole percentage of 0% to 0.7%, preferably 0% to 0.5%,
based on mole percentage of oxides.

10. The chemically strengthened glass-ceramic according to any one of claims 1 to 9, wherein the chemically strengthened glass-ceramic satisfies:
2.00 ≤ n(SiO₂)/n(Li₂O) ≤ 2.40, preferably 2.00 ≤ n(SiO₂)/n(Li₂O) ≤ 2.30, more preferably 2.02 ≤ n(SiO₂)/n(Li₂O) ≤ 2.20, wherein n(SiO₂) and n(Li₂O) are mole percentage contents of SiO₂ and Li₂O at the center or in the tensile stress layer of the chemically strengthened glass-ceramic, respectively; and/or,
90% ≤ n(SiO₂) + n(Li₂O) ≤ 96%, preferably 90% ≤ n(SiO₂) + n(Li₂O) ≤ 95%, wherein n(SiO₂) and n(Li₂O) are mole percentage contents of SiO₂ and Li₂O at the center or in the tensile stress layer of the chemically strengthened glass-ceramic, respectively; and/or,
20% ≤ 2.25 × n(Li₂O) - 8 × n(ZrO₂) - 0.2 × n(CaO) ≤ 60%, preferably 25% ≤ 2.25 × n(Li₂O) - 8 × n(ZrO₂) - 0.2 × n(CaO) ≤ 60%, wherein n(Li₂O), n(ZrO₂), and n(CaO) are mole percentage contents of Li₂O, ZrO₂, and CaO at the center or in the tensile stress layer of the chemically strengthened glass-ceramic, respectively; and/or,
0% ≤ n(Y₂O₃) + n(La₂O₃) + n(Ta₂O₅) + n(Yb₂O₃) ≤ 1%, preferably 0% ≤ n(Y₂O₃) + n(La₂O₃) + n(Ta₂O₅) + n(Yb₂O₃) ≤ 0.7%, wherein n(Y₂O₃), n(La₂O₃), n(Ta₂O₅), and n(Yb₂O₃) are mole percentage contents of Y₂O₃, La₂O₃, Ta₂O₅, and Yb₂O₃ at the center or in the tensile stress layer of the chemically strengthened glass-ceramic, respectively; and/or,
0% ≤ n(SrO) + n(BaO) + n(CaO) + n(MgO) ≤ 3%, preferably 0% ≤ n(SrO) + n(BaO) + n(CaO) + n(MgO) ≤ 2.7%, wherein n(SrO), n(BaO), n(CaO), and n(MgO) are mole percentage contents of SrO, BaO, CaO, and MgO at the center or in the tensile stress layer of the chemically strengthened glass-ceramic, respectively; and/or,
0 ≤ n(SrO)/[n(SrO) + n(BaO) + n(CaO) + n(MgO)] ≤ 1, wherein n(SrO), n(BaO), n(CaO), and n(MgO) are mole percentage contents of SrO, BaO, CaO, and MgO at the center or in the tensile stress layer of the chemically strengthened glass-ceramic, respectively.

11. The chemically strengthened glass-ceramic according to any one of claims 1 to 6, wherein, the composition at the center or of the tensile stress layer of the chemically strengthened glass-ceramic comprises:
SiO₂: 55% to 75%, Al₂O₃: 0% to 6%, P₂O₅: 2% to 8%, ZrO₂: 3% to 12%, and Li₂O: 11% to 20%, based on mass percentage of oxides.

12. The chemically strengthened glass-ceramic according to claim 11, wherein, the composition at the center or of the tensile stress layer of the chemically strengthened glass-ceramic further comprises: SrO: 0% to 6%, and/or, Na₂O: 0% to 4%, and/or, K₂O: 0% to 2%, and/or, CaO: 0% to 5%, and/or, B₂O₃: 0% to 1%, and/or, Ta₂O₅: 0% to 2%, and/or, BaO: 0% to 6%, and/or, MgO: 0% to 3%, and/or, ZnO: 0% to 3%, and/or, Y₂O₃: 0% to 2%, and/or, La₂O₃: 0% to 2%, and/or, Yb₂O₃: 0% to 4%, based on mass percentage of oxides.

13. The chemically strengthened glass-ceramic according to claim 11 or 12, wherein, the composition at the center or of the tensile stress layer of the chemically strengthened glass-ceramic comprises:
SiO₂ with a mass percentage of 60% to 71%, preferably 62% to 68%; and/or,
Al₂O₃ with a mass percentage of 1% to 6%, preferably 1% to 3%, more preferably 2% to 3%; and/or,
P₂O₅ with a mass percentage of 3% to 6%, preferably 3.5% to 5.5%; and/or,
ZrO₂ with a mass percentage of 4% to 11%, preferably 4% to 10%; and/or,
Li₂O with a mass percentage of 11% to 18%, preferably 12% to 17.5%, more preferably 14% to 17%; and/or,
Na₂O with a mass percentage of 0% to 2.8%, preferably 0% to 1%; and/or,
K₂O with a mass percentage of 0% to 1.5%, preferably 0% to 1%; and/or,
CaO with a mass percentage of 0% to 3%, preferably 0% to 1%; and/or,
BaO with a mass percentage of 0% to 5.5%, preferably 0% to 5%; and/or,
SrO with a mass percentage of 0% to 5%, preferably 0% to 3.5%; and/or,
MgO with a mass percentage of 0% to 2%; and/or,
ZnO with a mass percentage of 0% to 2.5%; and/or,
B₂O₃ with a mass percentage of 0% to 0.8%, preferably 0% to 0.5%; and/or,
Y₂O₃ with a mass percentage of 0% to 1%, preferably 0% to 0.8%; and/or,
La₂O₃ with a mass percentage of 0% to 1.5%, preferably 0% to 1%; and/or,
Ta₂O₅ with a mass percentage of 0% to 1.5%, preferably 0% to 0.5%; and/or,
Yb₂O₃ with a mass percentage of 0% to 3.5%, preferably 0% to 3%,
based on mass percentage of oxides.

14. The chemically strengthened glass-ceramic according to any one of claims 1 to 13, wherein the crystallinity of the chemically strengthened glass-ceramic is 70% to 90%, more preferably, the crystallinity of the chemically strengthened glass-ceramic is 70% to 87%; and/or,
in the chemically strengthened glass-ceramic, an average grain size is not greater than 100 nm, preferably, the average grain size is not greater than 50 nm, more preferably, the average grain size is 15 nm to 30 nm; and/or,
in the chemically strengthened glass-ceramic, a mass of the lithium disilicate crystalline phase accounts for 80 wt% to 100 wt% of all crystalline phases; and/or,
a mass percentage of a petalite crystalline phase in the chemically strengthened glass-ceramic is less than or equal to 10%, preferably less than or equal to 5%, more preferably, free of the petalite crystalline phase.

15. The chemically strengthened glass-ceramic according to any one of claims 1 to 14, wherein, when the thickness is not greater than 0.70 mm, a b value of the chemically strengthened glass-ceramic is < 1.0, preferably, the b value is < 0.8, more preferably, the b value is ≤ 0.6; and/or,
the chemically strengthened glass-ceramic is transparent within a visible light wavelength range, preferably, for light with a wavelength of 550 nm, a transmittance of the chemically strengthened glass-ceramic is ≥ 85%, preferably, the transmittance is ≥ 90%, more preferably, the transmittance is ≥ 90.27%.

16. The chemically strengthened glass-ceramic according to any one of claims 1 to 15, wherein a Young's modulus of the chemically strengthened glass-ceramic is greater than 100 GPa, preferably, the Young's modulus is greater than 105 GPa, more preferably, the Young's modulus is 110 GPa to 130 GPa; and/or,
a density of the chemically strengthened glass-ceramic is 2.51 g/cm³ to 2.65 g/cm³; and/or,
a refractive index of the chemically strengthened glass-ceramic is ≤ 1.60, preferably, the refractive index is 1.54 to 1.60; and/or,
the thickness T of the chemically strengthened glass-ceramic is 0.35 mm to 1.0 mm, preferably, the thickness T is 0.4 mm to 0.7 mm, more preferably, the thickness T is 0.45 mm to 0.55 mm; and/or,
the chemically strengthened glass-ceramic is 2D, 2.5D, 3D, or irregularly shaped; and/or,
the chemically strengthened glass-ceramic has a uniform thickness or a non-uniform thickness.

17. The chemically strengthened glass-ceramic according to any one of claims 1 to 16, wherein when subjecting the chemically strengthened glass-ceramic to a sandpaper drop resistance test, using an 80-mesh sandpaper, when the thickness is not greater than 0.70 mm, an average sandpaper drop resistance height of the chemically strengthened glass-ceramic is ≥ 1.0 m, preferably, the average sandpaper drop resistance height of the chemically strengthened glass-ceramic is ≥ 1.2 m, more preferably, the average sandpaper drop resistance height of the chemically strengthened glass-ceramic is ≥ 1.6 m.

18. The chemically strengthened glass-ceramic according to any one of claims 3 to 17, wherein the chemically strengthened glass-ceramic satisfies: the value of relationship A is: 150.39, 155.13, 157.8, 163.95, 165.23, 167.78, 171.98, 130.02, 148.08, 153.52, 157.87, 150.70, 161.51, 200.59, 217.59, 234.24, 208.06, 207.14, 220.07, 224.21, or 226.66; and/or,
the value of relationship B is: 144.41, 149.14, 151.82, 157.96, 159.24, 161.80, 166.00, 148.99, 165.83, 168.65, 170.67, 163.85, 155.53, 136.18, 155.43, 172.09, 147.01, 147.17, 165.17, 164.24, or 166.69; and/or,
a value of relationship C is: 33.97, 40.28, 37.3, 41.41, 47.67, 42.93, 45.51, 45.77, 52.74, 53.28, 51.42, 52.28, 37.27, 64.74, 70.95, 77.45, 57.85, 52.49, 67.32, 66.26, or 64.31.

19. A cover glass, comprising the chemically strengthened glass-ceramic according to any one of claims 1 to 18.

20. An electronic device, comprising the chemically strengthened glass-ceramic according to any one of claims 1 to 18.

21. The electronic device according to claim 20, wherein the electronic device comprises a housing assembled on the outside of the electronic device, and the housing comprises the chemically strengthened glass-ceramic according to any one of claims 1 to 18.

22. The electronic device according to claim 21, wherein the housing comprises a display screen cover plate assembled on the front side of the electronic device, and the display screen cover plate comprises the chemically strengthened glass-ceramic according to any one of claims 1 to 18.

23. The electronic device according to claim 21 or 22, wherein the housing comprises a back cover assembled on the rear side of the electronic device, and the back cover comprises the chemically strengthened glass-ceramic according to any one of claims 1 to 18.

24. The electronic device according to claim 21 or 22, wherein the electronic device further comprises a camera assembly located inside the housing, the housing comprises a camera protection cover plate, the camera protection cover plate is disposed over the camera assembly, and the camera protection cover plate comprises the chemically strengthened glass-ceramic according to any one of claims 1 to 18.

25. The electronic device according to any one of claims 21 to 24, wherein the electronic device further comprises a middle frame, and the middle frame comprises the chemically strengthened glass-ceramic according to any one of claims 1 to 18.

26. A glass device comprising the chemically strengthened glass-ceramic according to any one of claims 1 to 18.
